# FASCICULE DE BREVET EUROPEEN

(11) **EP 1 886 396 B1**
(45) Date de publication et mention de la délivrance du brevet: **15.03.2023**
(21) Numéro de dépôt: 06743820.0
(22) Date de dépôt: 20.04.2006
(51) Int. Cl.: H02K 11/05, H02K 5/22

(54) **Machine électrique tournante avec pièce d'interconnexion de puissance**
Rotierende elektrische Maschine mit ein Leistungsverbindungsstück
Electrical rotating machine with power interconnecting part

(30) Priorité: 31.05.2005 FR 0505501
(43) Date de publication de la demande: 13.02.2008
(73) Titulaire: VALEO EQUIPEMENTS ELECTRIQUES MOTEUR, 94017 Créteil Cedex (FR)
(72) Inventeur: DUBUC, Cyril, F-77260 Sept Sorts (FR); THERY, Laurent, F-94120 Fontenay Sous Bois (FR)
(74) Mandataire: Valeo Powertrain Systems
(86) Numéro de dépôt international: PCT/FR2006/050362
(87) Numéro de publication internationale: WO 2006/129031

(56) Documents cités:
- DE-A1-102004 007 395
- FR-A- 2 749 715
- US-A- 5 194 772
- US-A- 5 451 823
- US-A- 5 587 890
- US-A1- 2002 196 609
- US-A1- 2003 160 537
- US-A1- 2005 001 492

## Description

### Domaine de l'invention

L'invention concerne une pièce d'interconnexion de puissance pour machine électrique tournante.

La présente invention s'applique à tout type de machines électriques tournantes polyphasées, synchrones ou asynchrones, tels que des alternateurs, des alterno-démarreurs, et encore qu'il s'agisse de machines électriques pour des véhicules automobiles et entraînés par exemple par courroie, à refroidissement par air, par liquide ou par tout autre solution envisageable.

### Etat de la technique

Dans un véhicule automobile comportant un moteur thermique et une machine électrique tournante telle qu'un alterno-démarreur, une telle machine électrique comporte par exemple de façon non limitative:
- un rotor comprenant un inducteur dans lequel est amené un courant d'excitation, et
- un stator comprenant un bobinage polyphasé.
L'alterno-démarreur fonctionne en mode moteur ou en mode générateur. C'est une machine dite réversible.
En mode générateur ou alternateur, la machine permet de transformer un mouvement de rotation du rotor entraîné par le moteur thermique du véhicule, en un courant électrique induit dans les phases du stator. Dans ce cas, un pont redresseur relié aux phases du stator permet de redresser le courant induit sinusoïdal en un courant continu pour alimenter des consommateurs du véhicule ainsi qu'une batterie.
Au contraire, en mode moteur, la machine électrique fait office de moteur électrique permettant d'entraîner en rotation, via l'arbre du rotor, le moteur thermique du véhicule. Il permet de transformer l'énergie électrique en énergie mécanique. Dans ce cas, un onduleur permet de transformer un courant continu provenant de la batterie en un courant alternatif pour alimenter les phases du stator pour faire tourner le rotor.

Des signaux de contrôle sont utilisés pour déterminer le mode de fonctionnement de la machine électrique tournante (mode moteur ou mode générateur). Enfin, il est nécessaire d'alimenter en puissance l'ensemble des composants électroniques.

Le document US 2002/0196609 décrit un module de puissance intégrant, dans un boîtier surmoulé, des composants permettant de piloter un moteur triphasé, un circuit électrique permettant de connecter le module de puissance aux phases du moteur, un circuit électrique permettant de connecter ledit module à des dispositifs extérieurs tels que la batterie du véhicule ou des dispositifs de puissance dudit moteur.

Dans le document DE102004007395A1, on utilise des composants électroniques qui sont à l'intérieur d'une ceinture périphérique externe. Ces composants comportent des extrémités de puissance qui sont également à l'intérieur de la ceinture. La ceinture comprend des cloisons internes dans lesquelles des traces métalliques d'interconnexion de puissance sont surmoulées avec des traces de signal. Elles sont superposées les unes sur les autres. Ces traces de puissance permettent de connecter les composants via leurs extrémités de puissance vers la batterie de manière à les alimenter. La ceinture se positionne sur le palier arrière de la machine. Cette solution s'avère problématique du fait, premièrement de la réalisation complexe des traces superposées, et deuxièmement des sections de traces d'interconnexion de puissance qui sont trop petites par rapport au courant nécessaire, de l'ordre de 150A en mode alternateur et 600A au démarrage, pour l'application d'un alternateur ou alterno-démarreur de sorte que lesdites traces atteignent une température trop élevée.

Le document US5587890 décrit un système de distribution de puissance comprenant une pluralité de plaques empilées les unes sur les autres chacune comportant des portions de contact électriquement connectés aux portions de contact d'une autre plaque.

Les documents US 2003/160537, US 2005/001492, US5451823, US5194772 et FR2749715 décrivent d'autres machines électriques tournantes comprenant des modules électroniques, des dissipateurs, et des pièces d'interconnexion empilées axialement.

### Exposé de l'invention

Aussi, un objet de la présente invention est de proposer une pièce d'interconnexion de puissance pour machine électrique tournante que l'on peut facilement intégrer sur une machine électrique tournante et qui puisse avoir des conducteurs suffisamment grands pour supporter les courants qui les traversent.

A cet effet, l'objet de la présente invention est une machine électrique tournante comprenant au moins un module électronique, tel qu'un module de puissance, un module de contrôle ou un module d'excitation, un dissipateur comprenant une plaque de base, et une pièce d'interconnexion de puissance selon la revendication 1.

Ainsi, comme on le verra en détail plus loin, le fait d'avoir une pièce d'interconnexion de puissance comprenant des terminaux électriques destinées à coopérer avec les composants électroniques permet d'avoir une pièce d'interconnexion de puissance indépendante desdits modules et d'empiler ladite pièce dans un plan différent de celui utilisé par lesdits composants électroniques. Ainsi, cela évite les problèmes de surmoulage des traces. Par ailleurs, le fait de déporter les interconnexions sur un plan différent des composants électroniques, permet de libérer plus de surface pour les modules électroniques et donc pour les composants électroniques et également pour les traces d'interconnexion de puissance. Ainsi, on a une plus grande section de traces de puissance de manière à véhiculer plus de puissance. Les traces d'interconnexion sont ainsi définies indépendamment de la place prise par les composants électroniques sur la machine.

Selon des modes de réalisation préférentiels non limitatifs, la pièce d'interconnexion de puissance objet de l'invention présente les caractéristiques supplémentaires énoncées ci-après.
- les terminaux de puissance ne sont pas surmoulés.
- lesdits terminaux de puissance comportent des extrémités libres recourbées.
- une trace de puissance est plate.
- elle comprend au moins une trace d'interconnexion de puissance positive et au moins une trace d'interconnexion négative.
- lesdites traces de puissance sont imbriquées.
- lesdites traces sont concentriques.
- lesdites traces de puissance sont sur un même plan.
- les traces de puissance ne se superposent pas de manière à permettre une connexion électrique avec des traces d'un capot.
- les terminaux de puissance respectifs des traces de puissance positive et négative sont destinés à coopérer respectivement avec des traces positive et négative d'un module électronique.
- il existe au moins un terminal de puissance positif et au moins un terminal de puissance négatif pour un module électronique.
- il existe un unique terminal de puissance positif et un unique terminal de puissance négatif pour un module électronique.
- la plaque de base comprend au moins un évidement pour une connexion électrique d'une trace d'interconnexion de puissance avec un capot.
- elle comprend en outre des dispositifs de fixation pour fixation sur un module électronique, lesdits dispositifs s'étendant radialement sur la périphérie extérieure de ladite pièce.
- des terminaux électriques sont flexibles.
- elle comprend en outre des dispositifs de pré-asssemblage sur une pièce d'interconnexion de signal, ladite pièce de signal permettant de véhiculer des signaux de contrôle entre des modules électroniques.
- elle comprend en outre des inserts pour recevoir des moyens de fixation pour fixation sur la machine.
- elle comprend en outre une butée mécanique disposée sur le diamètre extérieur de ladite pièce.
- elle comporte un évidement central pour l'insertion d'un porte-balais.
- elle est configurée pour être placée sur la face inférieure d'un dissipateur.
- elle comprend en outre au moins un insert pour recevoir un rivet creux et réaliser un pré-assemblage avec un module électronique et une pièce d'interconnexion de signal et un dissipateur.
- elle comprend en outre des moyens de protection de phases de stator de la machine électrique tournante.
- elle comprend en outre des moyens de positionnement sur le palier de la machine électrique tournante, lesdits moyens s'étendant sur une face inférieure de ladite pièce.
- elle comprend en outre au moins une béquille de contrainte pour une déformation axiale de ladite pièce.
- ladite béquille de contrainte est de hauteur plus grande que l'insert.
- elle comprend en outre un insert métallique de sorte à réaliser une connexion électrique avec la trace négative de puissance.
- les terminaux d'interconnexion de puissance sont issus d'une trace de puissance positive.
- les terminaux d'interconnexion électriques sont des languettes axiales dépassant la face supérieure de ladite pièce.
- elle comprend en outre des moyens de protection des terminaux d'interconnexion de puissance positifs.
- elle comprend en outre un connecteur de puissance dans lequel sont insérées des traces de puissance positives et négatives de façon apparentes.
- elle comprend en outre une borne de liaison mécanique à un connecteur client.
- elle comprend en outre un orifice de liaison mécanique pour éviter une transmission des sollicitations mécaniques au surmoulage lorsque l'on fixe le connecteur client de puissance sur la borne de liaison.
- elle comporte en outre une collerette destinée à recouvrir des ouvertures de sorties d'air du palier de la machine électrique tournante de manière à guider l'air en sortie et atténuer un rebouclage d'air.
- elle est placée sur un ensemble modules électroniques plus pièce d'interconnexion de signal plus dissipateur, ladite pièce de signal permettant de véhiculer des signaux de contrôle entre les différents modules électroniques, ledit ensemble étant disposé sur un palier de la machine électrique tournante.
- elle est placée sur une face d'un dissipateur opposée à celle sur laquelle est disposé une pièce d'interconnexion de signal, ladite pièce de signal permettant de véhiculer des signaux de contrôle entre les différents modules électroniques, le tout étant placé sur un palier de la machine électrique tournante.
- elle se fixe sur un dissipateur rapporté.
- elle forme avec l'ensemble modules électroniques plus dissipateur plus pièce d'interconnexion de signal, un sous-ensemble électronique indépendant d'un palier de la machine.

D'autres caractéristiques et avantages de la présente invention ressortiront de la description ci-après. Celle-ci est purement illustrative et doit être lue en regard des dessins annexés, donnés à titre d'exemples non limitatifs.

### Brève description des figures

- La Fig. 1a représente un premier mode de réalisation d'un module électronique selon l'invention,
- La Fig. 1b représente le module de la Fig. 1a en vue de dessous,
- La Fig. 1c est une vue sans surmoulage du module de la Fig. 1a,
- La Fig. 1d est la vue de la Fig. 1c avec des liaisons filaires des composants électroniques du module électronique,
- La Fig. 2a est une première variante du premier mode de réalisation de la Fig. 1a,
- La Fig. 2b est une vue de dessous du module de la Fig. 2a,
- La Fig. 2c est la vue de la Fig. 2a avec des liaisons filaires des composants électroniques du module électronique,
- La Fig. 2d est une deuxième variante du premier mode de réalisation de la Fig. 2a,
- La Fig. 3a représente un deuxième mode de réalisation d'un module électronique selon l'invention,
- La Fig. 3b est une vue de dessous du module de la Fig. 3a,
- La Fig. 3c est une vue sans surmoulage du module de la Fig. 3a,
- La Fig. 3d est une variante du deuxième mode de réalisation de la Fig. 3a,
- La Fig. 3e est la vue de la Fig. 3d avec des liaisons filaires des composants électroniques du module électronique,
- La Fig. 4a est un troisième mode de réalisation du module électronique selon l'invention,
- La Fig. 4b est une vue de dessous du module de la Fig. 4a,
- La Fig. 4c est une vue sans surmoulage du module de la Fig. 4a,
- La Fig. 4d est une vue en coupe sans surmoulage du module de la Fig. 4a intégrant une plaque de support,
- La Fig. 4e est la vue de la Fig. 4c avec des liaisons filaires des composants électroniques du module électronique,
- La Fig. 5a est une variante du troisième mode de réalisation de la Fig. 4a,
- La Fig. 5b est une vue de dessous du module de la Fig. 5a,
- La Fig. 5c est une première vue de dessus sans surmoulage du module de la Fig. 5a,
- La Fig. 5d est une deuxième vue de dessous sans surmoulage du module de la Fig. 5a,
- La Fig. 5e est une troisième vue de dessus sans prémoulage et sans surmoulage du module de la Fig. 5a,
- La Fig. 5f est une quatrième vue de dessous sans prémoulage et sans surmoulage du module de la Fig. 5b,
- La Fig. 6 représente un premier mode de réalisation d'un palier dissipateur destiné à recevoir un module des Fig. 1 et 2,
- La Fig. 7 représente un deuxième mode de réalisation d'un palier dissipateur destiné à recevoir un module des Fig. 3,
- La Fig. 8a représente un premier mode de réalisation d'un dissipateur destiné à recevoir un module des Fig. 4 et 5,
- La Fig. 8b est une vue de dessous du dissipateur de la Fig. 8a,
- La Fig. 8c est une vue en coupe de la Fig. 8b,
- La Fig. 8d montre un flux d'air axial et un flux d'air radial dans le dissipateur de la Fig. 8b,
- La Fig. 9a représente un premier mode de réalisation d'une pièce d'interconnexion de signal destinée à se placer sur un module des Fig. 1 et 2,
- La Fig. 9b est une vue de dessous de la pièce de la Fig. 9a,
- La Fig. 9c est une vue sans surmoulage de la pièce de la Fig. 9a,
- La Figure 10a représente un deuxième mode de réalisation d'une pièce d'interconnexion de signal destinée à se placer sur un module des Fig. 3,
- La Fig. 10b est une vue de dessous de la pièce d'interconnexion de signal de la Fig. 10a,
- La Fig. 10c est une vue sans surmoulage de la pièce d'interconnexion de signal de la Fig. 10a,
- La Figure 11a représente un troisième mode de réalisation d'une pièce d'interconnexion de signal destinée à se placer sur un module des Fig. 4 et 5,
- La Fig. 11b est une vue de dessous de la pièce d'interconnexion de signal de la Fig. 11a,
- La Fig. 11c est une autre vue de dessus de la pièce d'interconnexion de signal de la Fig. 11a,
- La Fig. 11d est une vue sans surmoulage de la pièce d'interconnexion de signal de la Fig. 11a,
- La Fig. 12a représente un premier mode de réalisation d'une pièce d'interconnexion de puissance destinée à être en contact avec un module des Fig. 1 et 2, et à être située au dessus de la pièce d'interconnexion de signal des Fig. 9,
- La Fig. 12b est une vue de dessous de la pièce de la Fig. 12a,
- La Fig. 12c est une vue sans surmoulage de la pièce de la Fig. 12a,
- La Fig. 13a représente un deuxième mode de réalisation d'une pièce d'interconnexion de puissance destinée à être en contact avec un module des Fig. 3 et à être située au dessus de la pièce d'interconnexion de signal des Fig. 10,
- La Fig. 13b est une vue de dessous de la pièce de la Fig. 13a,
- La Fig. 13c est une vue sans surmoulage de la pièce de la Fig. 13a,
- La Fig. 14a représente un troisième mode de réalisation d'une pièce d'interconnexion de puissance destinée à recevoir un dissipateur des Fig. 8,
- La Fig. 14b est une vue de dessous de la pièce de la Fig. 14a,
- La Fig. 14c est une vue sans surmoulage de la pièce de la Fig. 14a,
- La Fig. 14d est une vue de la pièce de la Fig. 14a intégrant une collerette,
- La Fig. 14e est une vue de la pièce de la Fig. 14d sur un palier dissipateur,
- La Fig. 15a est un premier mode de réalisation d'un capot destiné à être situé au dessus de la pièce de puissance des Fig. 12,
- La Fig. 15b est une vue de dessus du capot de la Fig. 15a,
- La Fig. 15c est une vue de côté du capot de la Fig. 15a,
- La Fig. 16 est un deuxième mode de réalisation d'un capot destiné à être situé au dessus de la pièce de puissance des Fig. 13,
- La Fig. 17a est un troisième mode de réalisation d'un capot destiné à être situé au dessus de la pièce d'interconnexion de signal des Fig. 11,
- La Fig. 17b est une vue de dessus du capot de la Fig. 17a,
- La Fig. 18 représente un montage d'un module électronique des Fig. 1 et 2 sur un palier dissipateur,
- La Fig. 19 représente un montage d'une pièce interconnexion de signal des Fig. 9 sur l'ensemble palier dissipateur-modules de la Fig. 18,
- La Figure 20 représente un montage de la partie interconnexion de puissance des Fig. 12 sur l'ensemble palier dissipateur-module-pièce d'interconnexion de signal de la Fig. 19,
- La Fig. 21 représente l'agencement de la Fig. 20 avec un capot en coupe partielle,
- La Fig. 22 est une vue complète de l'agencement selon la Fig. 21 avec le capot en place, montrant un positionnement du capot par rapport à un module,
- La Fig. 23 représente un montage d'un module électronique des Fig. 3 sur un palier dissipateur,
- La Fig. 24 représente un montage de la partie interconnexion de signal de la Fig. 10 sur l'ensemble palier dissipateur-modules de la Fig. 23,
- La Fig. 25 représente un montage de la partie interconnexion de puissance des Fig.12 sur l'ensemble palier dissipateur-module-pièce d'interconnexion de signal de la Fig. 24.
- La Fig. 26 représente l'agencement de la Fig. 25 avec un capot en coupe partielle,
- La Fig. 27a représente un montage des modules des Fig. 4 sur un dissipateur,
- La Fig. 27b représente un montage de la pièce d'interconnexion de puissance des Fig. 14 sur un dissipateur,
- La Fig. 28 représente un montage de la pièce d'interconnexion de puissance des Fig. 14 sur l'ensemble dissipateur-modules de la Fig. 27a,
- La Fig. 29 représente un montage de la pièce interconnexion de signal sur l'ensemble de la Fig. 28,
- La Fig. 30a est un assemblage de l'ensemble de la Fig. 29 sur un palier,
- La Fig. 30b est une coupe selon un plan X-Y de la Fig. 30a de la pièce d'interconnexion de puissance assemblée de la Fig. 14a, et
- La Fig. 30c représente un palier sur lequel est assemblé l'ensemble de la Fig. 29.

### Description détaillée d'un mode de réalisation de l'invention

On notera que dans la suite de la description, on définit comme diamètre extérieur de la machine le diamètre d'un palier de la machine hors patte de fixation.

### Module électronique

On notera qu'un module électronique, dans le cadre de l'invention, est un ensemble de composants électroniques qui sont disposés dans un boîtier et comporte des éléments de connexion accessibles de l'extérieur pour son fonctionnement, ces éléments permettant de transmettre des signaux de contrôle et/ou de puissance.

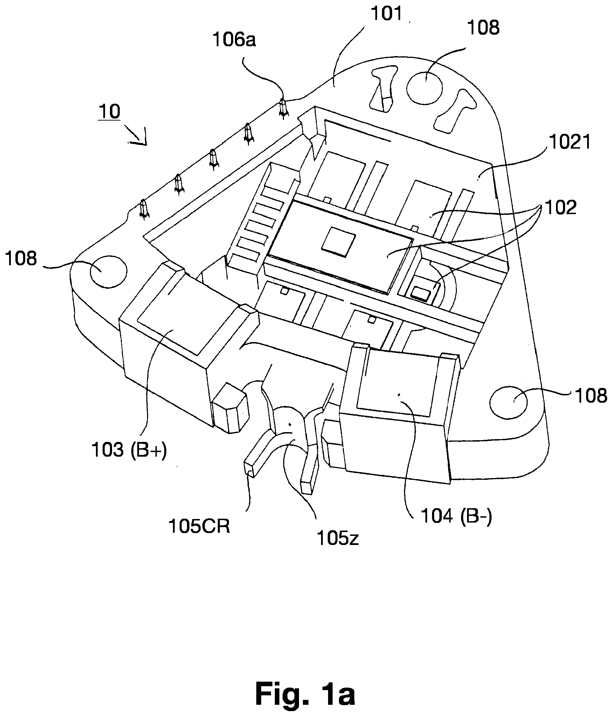

La Fig. 1a représente **un premier mode de réalisation non limitatif** d'un module électronique 10 selon l'invention.

Ledit module 10 comprend :
- Un boîtier 101,
- des composants électroniques 102 localisés dans une zone centrale 1021 recouverte d'un gel protecteur tel qu'un gel type silicone ou résine époxy,et d'un capot en plastique protecteur,
- des conducteurs électriques 103 (B+), 104(B-)
- des éléments de connexion de signal 106, et
- des points de fixation 108.

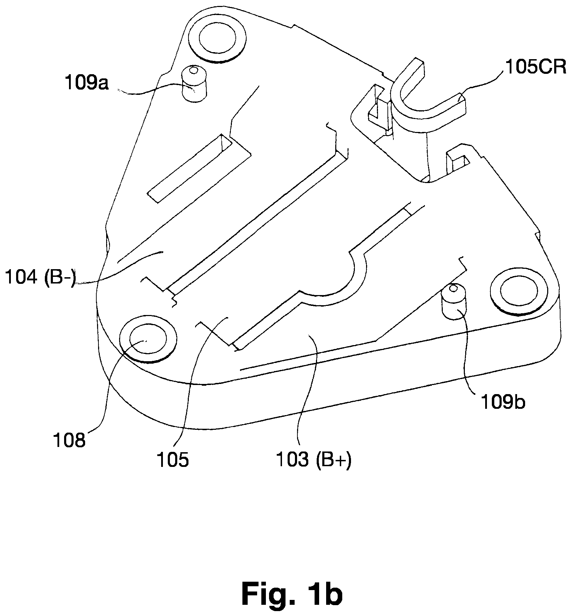

En outre, ledit module 10 comporte, comme indiqué sur la vue de dessous de la Fig. 1b :
- des moyens de positionnement 109 du module 10 sur un palier dissipateur.

Les différents éléments dudit module 10 sont décrits ci-après.
- Le boîtier 101 est en un matériau électriquement isolant. De préférence, le boîtier a une forme de base sensiblement triangulaire, il a donc au moins trois faces latérales et une face supérieure et une face inférieure. Cette forme va permettre d'utiliser un maximum de surface sur l'arrière cylindrique de la machine, et ce de façon optimale.

Par ailleurs, préférentiellement, une des faces du module 10 est un arc de cercle. Cela permet d'être en adéquation avec la forme générale de la machine.

Bien entendu, on pourrait utiliser d'autres formes, telle qu'une forme sensiblement rectangulaire.
- Les conducteurs d'alimentation de puissance électriques 103 (B+), 104(B-) permettent de véhiculer un courant provenant de la batterie au travers des éléments électroniques.

Dans un mode de réalisation préférentiel, les conducteurs sont deux traces de connectique de puissance 103, 104 dont les extrémités sont disposées sur la périphérie extérieure du module. Préférentiellement, lesdites traces sont en cuivre.

Ainsi, contrairement à une architecture dans laquelle la puissance nécessaire pour chaque module transite par tous les modules ou dans laquelle une carte électronique de puissance se trouve dans un boîtier séparé de la machine, cette configuration présente les avantages suivants :
- cela permet au brouillard salin de s'écouler vers l'extérieur de la machine au lieu de s'entasser au centre de ladite machine, ce qui évite une corrosion des traces par ledit brouillard salin,
- il y a moins d'échauffement dans les modules car la puissance nécessaire pour un module ne transite que par ledit module,
- on effectue les soudures des extrémités de traces sur un seul rayon ce qui permet de mieux automatiser la soudure,
- cela permet également l'équilibrage du courant dans les modules, en effet, chaque module est alimenté indépendamment, i.e. qu'ils sont alimentés en parallèle.

Dans une première variante de ce mode, les traces de puissance 103, 104 s'étendent suivant un plan parallèle à celui selon lequel s'étend le bloc d'éléments électroniques. Cela permet une soudure laser axiale par rapport à l'axe de la machine.

Dans une deuxième variante, les traces s'étendent suivant deux plans parallèles entre eux et parallèles au plan du bloc d'éléments électroniques.

On notera qu'on entend par trace une tôle découpée formée en un métal tel que le cuivre.
- Les éléments de connexion signal 106 appelés connexions de signal, permettent de véhiculer des signaux de commande pour commander les éléments électroniques 102. Ils permettent ainsi l'envoi et la réception d'informations nécessaires à la commande du bras d'onduleur (mode moteur) et/ou, du bras du pont de redressement (mode générateur). Ils permettent une connexion avec une plaque de signal (décrite plus loin).

Dans un premier mode de réalisation préférentiel, ces connexions de signal 106 comportent une première série de languettes 106a et sont alignées sur une des faces latérales du boîtier triangulaire du module. Ainsi, les axes de ces éléments de connexions de signal 106a sont dans un même plan P1 perpendiculaire à la face inférieure du module, ledit plan passant essentiellement par l'axe de rotation AX rotor.

Cet alignement permet d'effectuer des soudures de languettes linéaires ce qui limite le temps du procédé de fabrication appelé « process », et l'encombrement. Cette configuration a pour avantage d'avoir, pour la pièce d'interconnexion de signal, une trace de signal découpée en une seule fois contrairement à une autre configuration dans laquelle les traces de signal se chevaucheraient. On remarquera que si on décale les languettes vers l'intérieur du module, i.e. si le plan ne passe pas par l'axe de rotation, on réduit la place pour les composants électroniques 102, et inversement, on réduit la place pour les autres modules.
- Des moyens de fixation 108 représentés ici par des orifices sont destinés à faciliter le maintien du module sur la machine électrique moyennant des goujons 113 ou vis etc. ou tout moyen de fixation approprié.
- Les moyens de positionnement 109 du module 10 sur un palier dissipateur ou dissipateur sont ici au nombre de deux 109a, 109b comme illustrés sur la Fig. 1b qui sont sur la face inférieure du module, à proximité de deux bords opposés. Dans l'exemple, ce sont des pions situés de part et d'autre des éléments électroniques 102. Ils sont ainsi espacés au maximum ce qui permet de limiter les erreurs de positionnement.

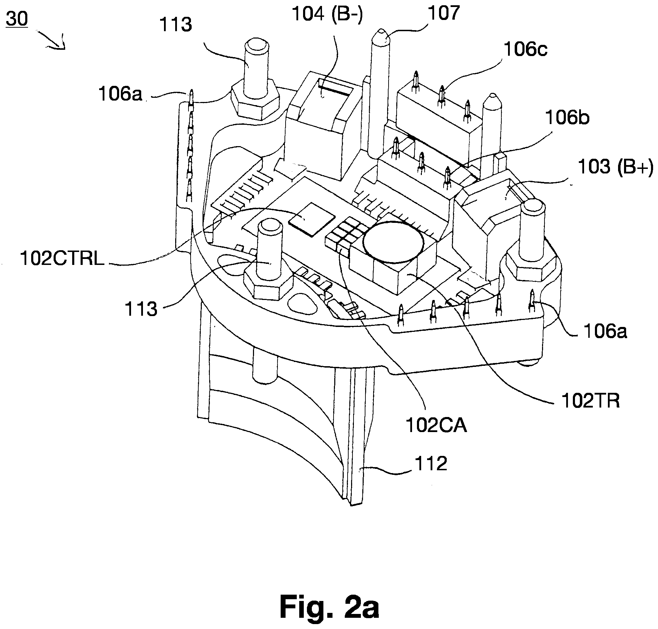

De plus, préférentiellement, le module 10 comporte en outre, tel qu'illustré à la Fig. 2a :
- Des moyens de protection 107 des connexions de signal 106 permettant de faciliter le positionnement d'un capot (décrit plus loin).

De plus, préférentiellement, ledit module électronique 10 comporte en outre, tel qu'illustré à la Fig. 1a :
- Une trace de phase 105 permettant de connecter ledit module à une phase du stator.

Dans un mode de réalisation préférentiel, la trace de phase 105 comporte une extrémité 105z qui comprend un crochet 105cr et permet d'y connecter, par soudage, brasage ou tout autre procédé adapté, un fil de phase ou une languette de phase provenant du stator de la machine électrique. Sur l'exemple représenté à la Fig. 1a, ladite extrémité 105z est perpendiculaire à ladite trace, i.e. i.e. à la face inférieure, et est situé au dessous dudit plan ; elle s'étend vers le bas. Ainsi, cela permet une réduction de la longueur du fil de phase du stator et implique une soudure radiale. De plus, l'extrémité 105z de la trace de phase 105 se trouve sur la circonférence extérieure du module ce qui facilite la connexion avec une phase du stator. De plus, préférentiellement, l'extrémité 105z de la trace de phase 105 est placée entre deux conducteurs électriques de puissance 103, 104.

Cela optimise les liaisons filaires électriques « wire bounding » entre les composants électroniques transistors et les traces, notamment leur longueur, et cela permet d'éviter des chevauchements de traces. De plus, préférentiellement, l'extrémité de la trace de phase 105 se trouve au droit d'une sortie de phase du stator ce qui facilite la soudure avec ladite phase.

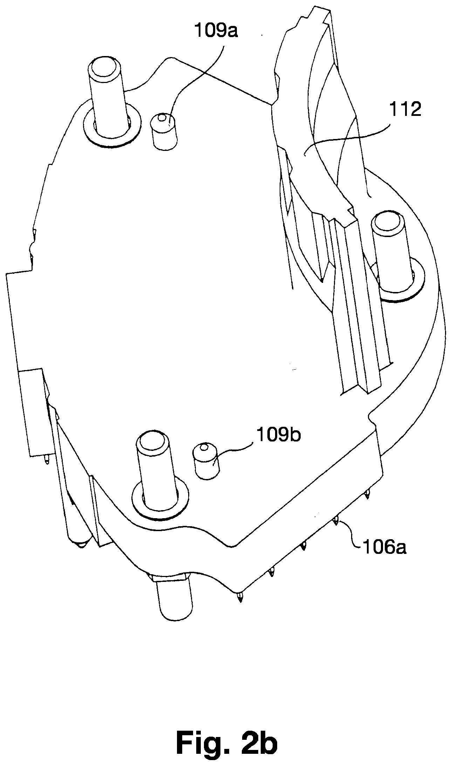

De plus, préférentiellement, selon une première variante de ce mode de réalisation, ledit module électronique 10 est un module de contrôle 30 qui comporte en outre, tel qu'illustré aux Fig. 2a et 2b :
- Une troisième série de languettes de signal
   106c qui sont alignés sur la périphérie extérieure du boîtier triangulaire du module, ladite périphérie coïncidant avec le diamètre extérieur de la machine. Cette série de languettes permet de se connecter à un connecteur de signal intégré dans un capot.
- Une deuxième série de languettes 106b qui sont alignés parallèles à la troisième série 106c et décalées vers l'intérieur du module. Cette deuxième série de languettes permet de véhiculer des signaux complémentaires qui n'ont pas pu être intégrés dans les premières séries de languettes 106a, par exemple des signaux SC pour un élément de pilotage d'un interrupteur. Cela permet une découpe des deux séries de languettes 106b et 106c en une seule fois. On notera que la troisième série de languettes 106c est préférentiellement positionnée plus haute que la deuxième série 106b pour permettre de faciliter la soudure d'un capot au module de contrôle après avoir effectué la soudure d'une pièce d'interconnexion signal.

Autrement dit, les deuxième et troisième séries de connexions de signal 106b, 106c sont alignées sur la même face sur laquelle sont disposées les extrémités des liaisons de puissance.
- un logement 112 pour capteurs de position du stator.

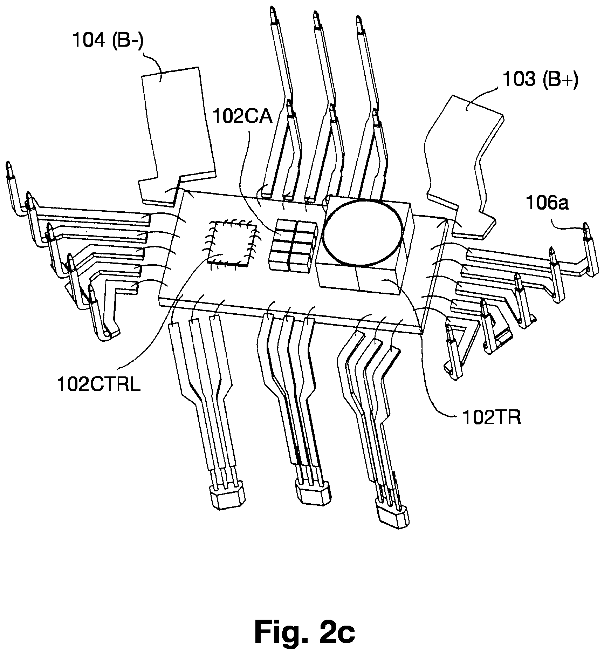

On notera que les interconnexions entre les transistors et les traces associées sont réalisées par des liaisons filaires « wire bounding » telles qu'illustrées sur la Fig. 2c. Dans le cadre d'un module avec un seul transistor par potentiel, on a un transistor disposé sur la trace positive 103 qui est relié à la trace de phase 105 et à la céramique 1110 du driver 111, tandis qu'un deuxième transistor est disposé sur la trace de phase 105 et est relié à la trace négative 104 et également à la céramique 1110. On notera qu'on pourrait également avoir un transistor sur la trace négative 104.

On notera que dans cet exemple, il y a quatre transistors, deux transistors pour le côté « low side », indiqué LS et « high side », indiqué HS d'un bras, soit deux transistors par potentiel pour augmenter la puissance de la machine.

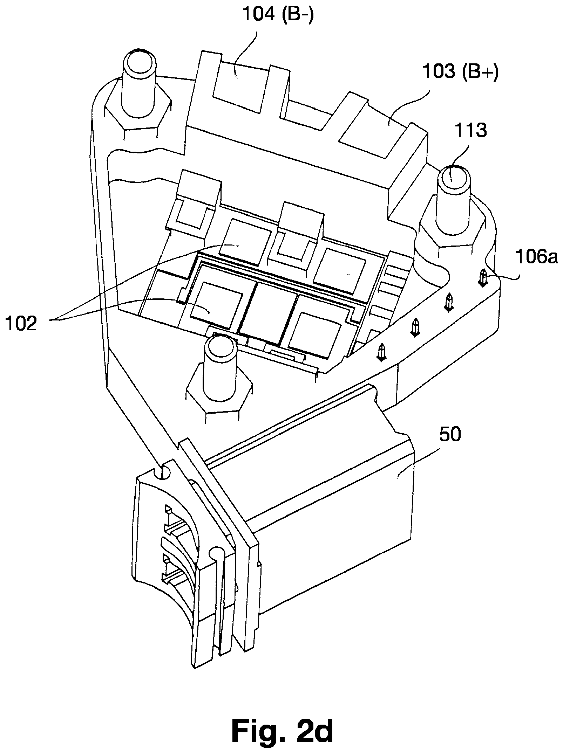

De plus, préférentiellement, selon une deuxième variante de ce mode de réalisation, ledit module électronique 10 est un module d'excitation 40, tel qu'illustré à la Fig. 2d. Il comporte des composants électroniques 102, en particulier des transistors MOS et des diodes, qui matérialisent l'étage d'excitation du rotor de la machine.

Ainsi, les modules électronique 10 ont, en ce qui concerne l'agencement des traces 103, 104 et de leurs extrémités formant des conducteurs électriques à l'intérieur de chaque module et en ce qui concerne l'agencement des connexions de signal 106, une architecture standardisée permet d'utiliser lesdits modules sur différents types de machines électriques. Cette standardisation de l'architecture permet de remplacer tout module 10 par un module de même architecture. De plus, cela permet d'intégrer lesdits modules directement sur le palier arrière de la machine. On intègre ainsi l'électronique de puissance et de contrôle sur la machine directement. L'électronique n'est plus dans une carte électronique de puissance dans un boîtier séparé.

Ainsi, selon l'architecture d'un module électronique 10 décrite précédemment, on peut avoir des modules de puissance 20 (Fig. 1a à 1c), un module de contrôle 30 (Fig. 2a à 2c) et un module d'excitation 40 (Fig. 2d).

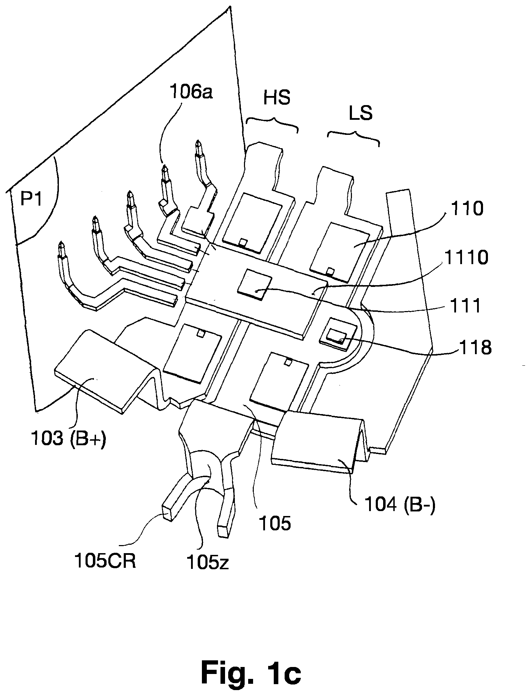

Dans le cas des modules de puissance 20, les composants électroniques 102, illustrés à la Fig. 1c, comprennent par exemple :
- un ensemble d'interrupteurs électroniques 110 destinés à réaliser un bras de pont redresseur/onduleur pour une phase de la machine,
- des éléments de pilotage 111 appelés drivers associés aux interrupteurs, et
- un capteur de température 118 (positionné sur une céramique) de la trace de phase 105

Les interrupteurs peuvent être, par exemple, des transistors de technologie MOSFET 110 qui se présentent soit sous forme de composants packagés, c'est-à-dire présentés avec un boîtier, soit, pour augmenter la compacité de l'agencement des modules et pour réduire les coûts, sous forme de puces nues, c'est-à-dire sans boîtier. Les MOSFET 110 sont contrôlés par les éléments de pilotage 111 appelés couramment des drivers sur une céramique 1110 avec des composants additionnels. Préférentiellement, les drivers sont des ASIC. Les éléments électroniques peuvent également être des diodes d'un bras d'un pont redresseur, en sachant que les MOS ont un meilleur rendement que les diodes. Le nombre de composants électroniques dépend essentiellement des contraintes de l'application particulière (machine triphasée ou héxaphasée par exemple), du niveau de puissance exigée par la machine....

Pour une machine triphasée, on aura de préférence trois modules de puissance servant à réaliser un onduleur (un module par phase). Plus généralement, la machine est une machine polyphasée (x phases), ayant de préférence un module par phase.

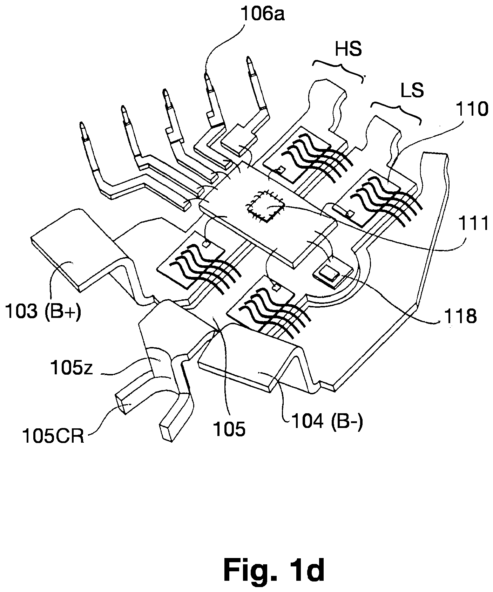

La Fig. 1d illustre les liaisons filaires couramment appelées « wire bounding » entre les transistors et la connectique de puissance 104 et la connectique de phase 105. On notera que dans cet exemple, il existe quatre transistors MOS, de manière à augmenter la puissance de la machine. Bien entendu, il peu y en avoir que deux. On notera que la céramique 1110 sert ainsi de support pour des composants électroniques mais également d'interconnexion entre les transistors et le driver 111.

Le module de contrôle 30 permet de contrôler la machine et notamment le réglage du courant d'excitation de la machine en contrôlant les drivers des transistors MOS. Il comporte notamment, comme illustré à la Fig. 2a, un composant électronique de contrôle 102CTRL, des capacités 102CA, et un transformateur 102TR pour alimenter les drivers 111 des modules de puissance. Des signaux de contrôle vont ainsi être envoyés du composant de contrôle 102CTRL vers les drivers 111 des modules de puissance.

Le module d'excitation 40 permet d'alimenter la bobine du rotor de ladite machine, ledit module comprenant de manière classique, des transistors MOS et des diodes permettant de déterminer le courant dans le rotor.

Ainsi, Le module de contrôle 30 et le module d'excitation 40 reprennent l'architecture des modules de puissance 10 et notamment la disposition des extrémités des traces de puissance 103, 104 et des connexions de signal 106.

Selon une variante de réalisation, le module de contrôle 30 et le module d'excitation 40 peuvent être remplacés par un module commun d'excitation et de contrôle.

L'ensemble des modules 20, 30 et 40 est monté sur un palier arrière de la machine électrique tournante.

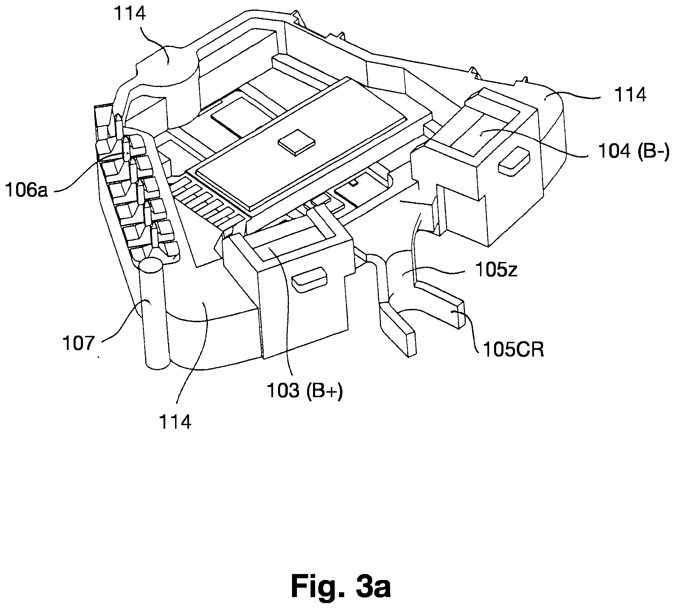

**Dans un deuxième mode de réalisation non limitatif,** illustré à la Fig. 3a, le module électronique 10 diffère du premier mode en ce que :
- à la place des moyens de fixation 108, il comporte des zones d'appuis 114 pour recevoir des béquilles appartenant à une pièce d'interconnexion de signal comme il sera décrit par la suite, ce qui permet de supprimer les goujons de fixation 113 de sorte que le coût des pièces et d'assemblage sont réduits, et cela permet d'obtenir un assemblage plus simple.

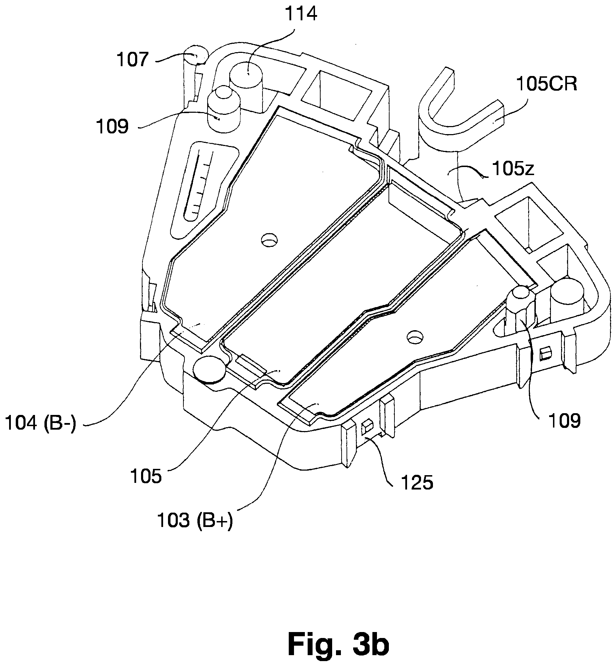

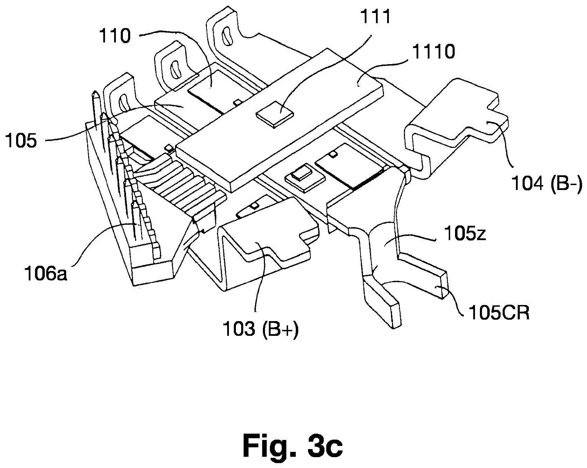

On peut voir le nouveau module 10 en vue de dessous à la Fig. 3b et en vue sans surmoulage à la Fig. 3c pour un module de puissance. On notera simplement à la Fig. 3b que le module comporte préférentiellement un clip de fixation 125 d'un capot plastique pour module afin de protéger le gel de protection des composants. Ce clip de fixation peut être remplacé par un collage du capot ou une soudure ultrasonique par exemple.

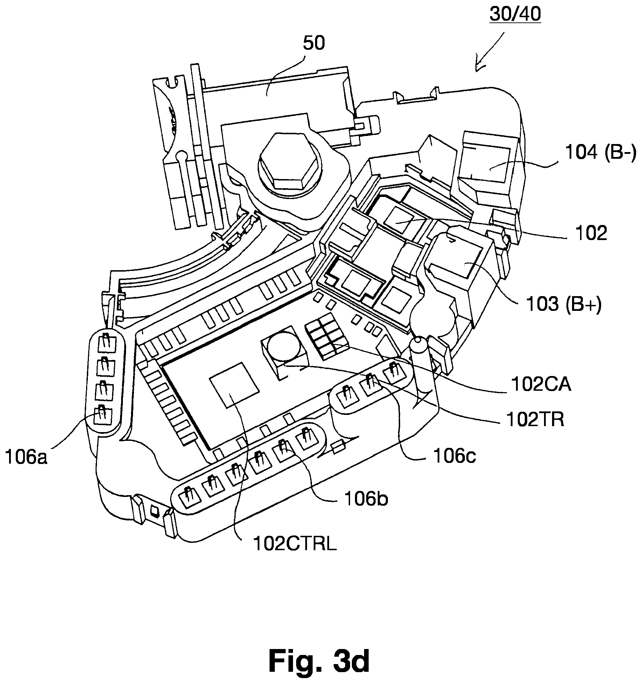

La Fig. 3d présente une variante de réalisation pour un module de contrôle/excitation 30/40. On notera que le fait d'avoir un seul module pour la fonction contrôle et excitation permet de gagner en terme d'encombrement.

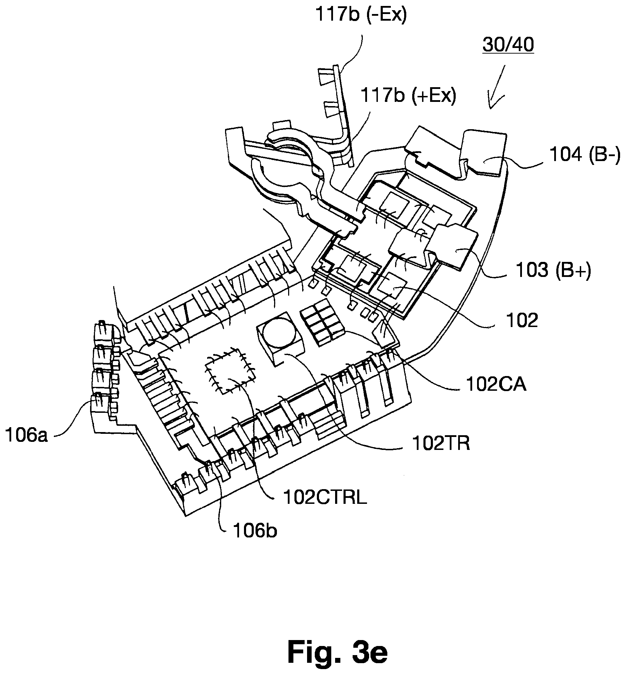

La Fig. 3e présente les liaisons filaires « wire bounding » de cette variante. On notera qu'il existe une interconnexion entre la céramique de contrôle et la céramique (substrat) d'excitation réalisée par une liaison filaire « wire bounding » afin de permettre une transmission de signaux entre la partie excitation et la partie contrôle.

Dans les deux premiers modes de réalisation décrits, préférentiellement, les extrémités desdites traces de puissance 103, 104 sont plates et affleurantes sur la face inférieure dudit module. Ainsi, cette configuration a pour avantage de pouvoir souder des traces d'une plaque de puissance (décrite en détail plus loin) sur les extrémités de traces d'un module par transparence (plat sur plat).

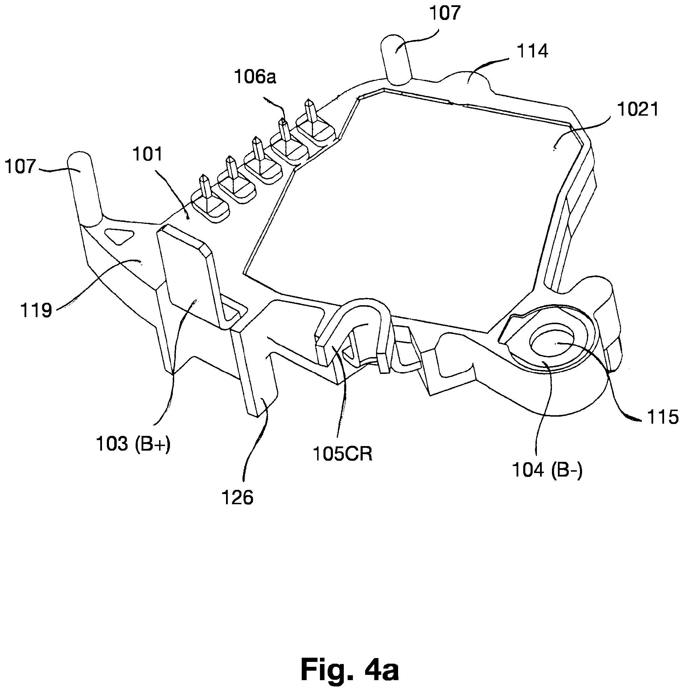

**Dans un troisième mode de réalisation non limitatif,** illustré à la Fig. 4a, le module électronique 10 est configuré pour être fixé sur un dissipateur, lui-même fixé sur le palier arrière de la machine.

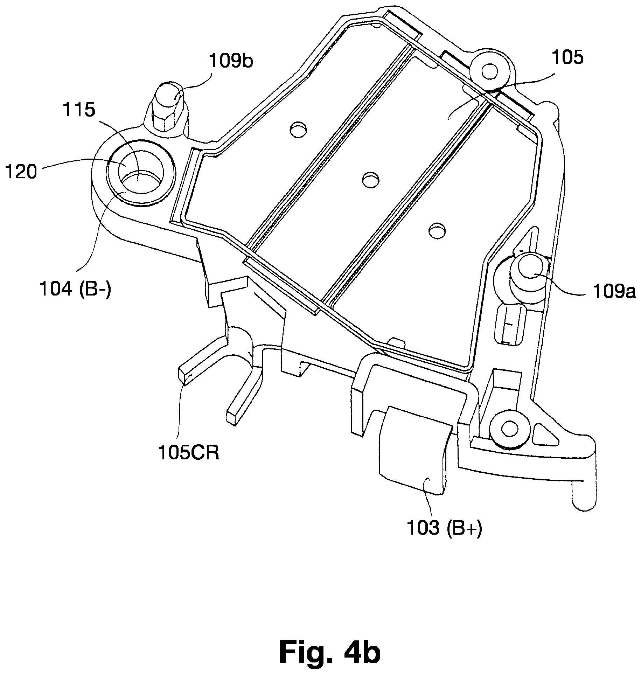

Il diffère du deuxième mode de réalisation en ce que :
- l'extrémité 105z de la trace de phase 105 est perpendiculaire à la face inférieure du module, et dépasse le boîtier 101 du module et son capot plastique, il s'étend vers le haut. Ainsi, cela permet une soudure axiale et évite ainsi d'être gêné par les pattes de fixation de l'alterno-démarreur sur le moteur, et ce quelque soit le moteur d'un constructeur ; et cela permet de faciliter l'accès à l'outillage de soudure,
- l'extrémité de la trace positive 103 (B+) est une languette pliée permettant une soudure laser radiale avec une plaque de puissance ou une soudure électrique axiale par des électrodes ; elle s'étend axialement vers le haut par rapport au boîtier 101 du module et dépasse ledit boîtier pour engager lesdites électrodes, i.e. qu'elle est perpendiculaire à la face inférieure du module ; la languette dépasse du dissipateur. Cela permet de connecter une pièce d'interconnexion de puissance 21 avec le module par le dessous,
- l'extrémité de la trace négative 104 (B-) n'est plus une languette, mais un insert métallique cylindrique creux permettant une connexion électrique à un dissipateur 80 via la trace B- et une vis 1150 correspondant à l'orifice 115, ladite vis permettant de comprimer ladite trace sur l'insert et ainsi de comprimer la trace+insert sur le dissipateur de manière à réaliser la mise à la masse du module, ledit dissipateur étant à la masse comme il sera décrit en détail plus loin,
- Les pions de positionnement 109 situés sur la face inférieure, sont positionnés différemment. Un premier pion 109a est positionné au plus proche des languettes de signal 106, et préférentiellement centré sur celle du milieu, pour réduire la tolérance de positionnement desdites languettes par rapport au jeu qui peut exister entre le deuxième pion 109b et l'orifice 609b (décrit plus en détail plus loin) correspondant du palier dissipateur. On réduit ainsi les erreurs de positionnement des languettes par rapport au dissipateur. Comme illustré à la Fig. 4b, ce premier pion 109a se trouve au milieu des deux languettes extrêmes 106a de signal. On notera que le premier pion 109a sert à positionner le module selon l'axe XY, et le deuxième 109b sert à orienter le module en rotation et est le plus éloigné des languettes 106a,
- Un des pions de protection 107 est déplacé plus à l'extérieur du module de sorte qu'il existe un espace d'appui 119 pour permettre de recevoir une béquille d'une plaque de signal. Les pions 107 empêchent que les languettes de signal 106 ne se plient entre le moment de la fabrication du module et son assemblage sur la machine, et servent de pré-guidage pour une pièce d'interconnexion de signal (décrite plus loin).

Par ailleurs, le module 10 selon ce troisième mode comporte en outre :
- Un insert 120 comportant un orifice de fixation 115, ledit insert permettant une mise à la masse du module, et ledit orifice étant destiné à fixer ledit module sur un dissipateur au moyen de vis 1150 par exemple,
- Des moyens de protection électrique 126 de la l'extrémité de la trace 103 (B+) qui évitent un court-circuit entre les potentiels B+ (trace de puissance de la pièce d'interconnexion de puissance) et B-(masse dissipateur).

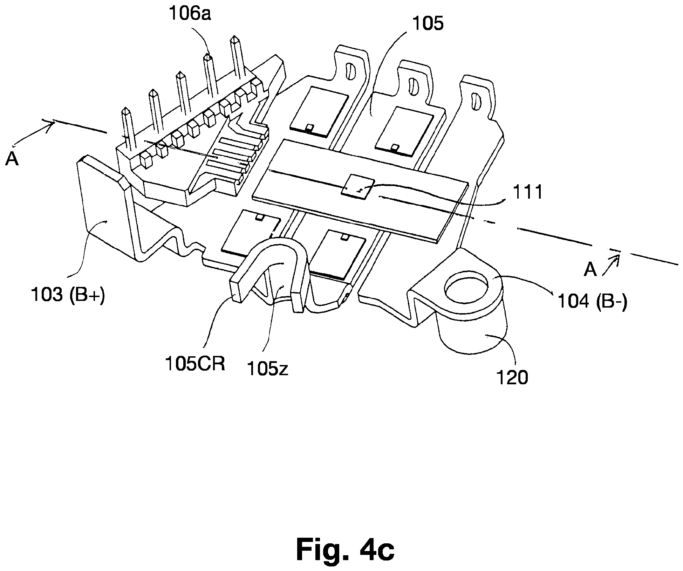

Une vue sans surmoulage d'un module de puissance 20 selon ce troisième mode de réalisation est représentée à la Fig. 4c.

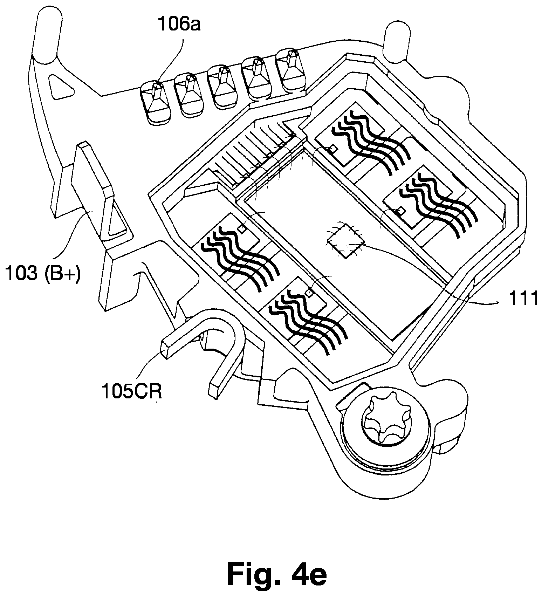

Une vue avec les liaisons filaires « wire bounding » est représentée à la Fig. 4e.

Préférentiellement, chaque module de puissance 20 comporte une plaque 1022 peu résistive et thermiquement conducteur, préférentiellement en aluminium (même résistance que le dissipateur) ou encore en cuivre.

Ainsi, on a :
- les composants électroniques 102 soudés sur les traces métalliques,
- les traces métalliques, qui sont apparentes sur la face inférieure du boîtier du module, sont collées sur la plaque 1022 par une colle électriquement isolante et thermiquement conductrice, par exemple une colle à bille de verre, ladite colle permettant d'isoler électriquement les traces entre elles et les traces par rapport à l'extérieur, et
- la plaque 1022 qui se place sur le dissipateur.

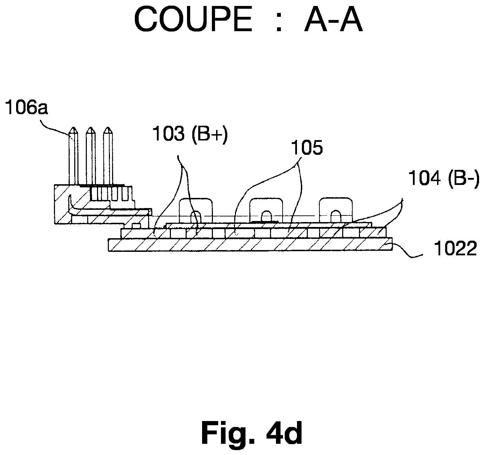

La plaque 1022 est illustrée sur la Fig. 4d (représentation en coupe selon un axe A-A de la Fig. 4c). On notera que cette plaque peut être utilisée de la même manière sur les autres modules contrôle ou excitation dans le cadre de traces apparentes.

La plaque permet ainsi de tester l'isolation électrique de chaque module indépendamment avant assemblage sur le dissipateur ou palier dissipateur. Ainsi, s'il existe un problème de court-circuit du à une mauvaise application de la colle isolante, cette plaque 1022 évite le rebus de l'ensemble des modules montés sur le dissipateur. Seul le module posant problème sera jeté avant son assemblage sur le dissipateur.

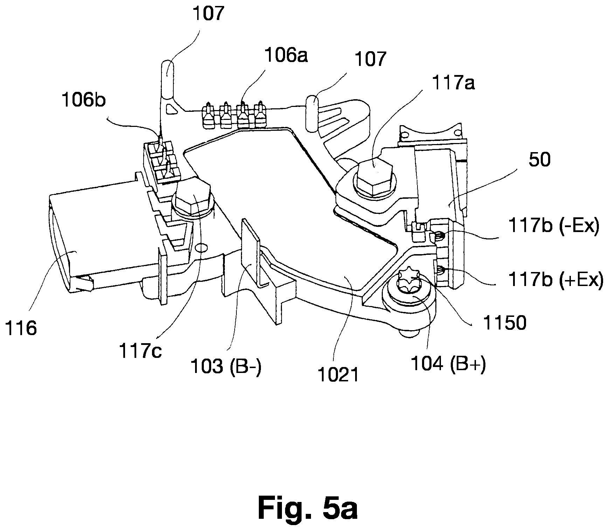

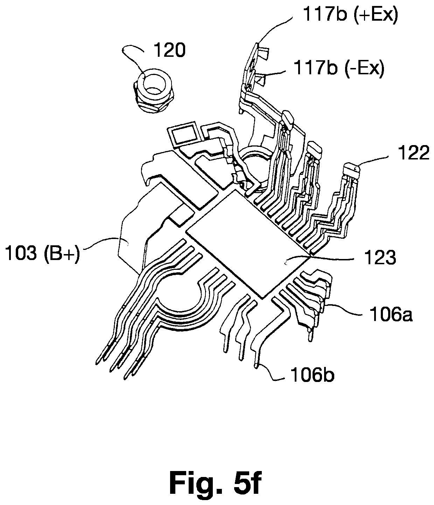

Selon une variante de ce troisième mode de réalisation, le module 10 comporte, tel qu'illustré à la Fig. 5a :
- un connecteur de signal 116,
- une vis 117a permettant un contact électrique entre deux traces 117b (+EX, -EX) d'un porte balais 50 et ledit module 10, et
- une vis 117c de maintien mécanique sur le dissipateur et permettant de supporter les efforts mécaniques du connecteur 116.

Plus particulièrement c'est le module de contrôle 30 ou le module de contrôle/excitation qui comporte ledit connecteur 116 et ladite vis 117a. On notera que le porte balais est ici monobloc avec ledit module 30. En effet, il surmoulé avec ledit module.

La présence dudit connecteur de signal 116 présente l'avantage de :
- Supprimer des soudures permettant d'effectuer des liaisons électriques entre le capot et les modules, par rapport au premier mode de réalisation,
- éviter des problèmes de soudure et d'étanchéité,
- gagner en temps de procédé de fabrication.

Il n'existe donc plus de languettes externes 106c comme dans les premier ou deuxième modes de réalisation, ce qui permet de réduite la matière des traces (celles dans le capot) comme on le verra par la suite.

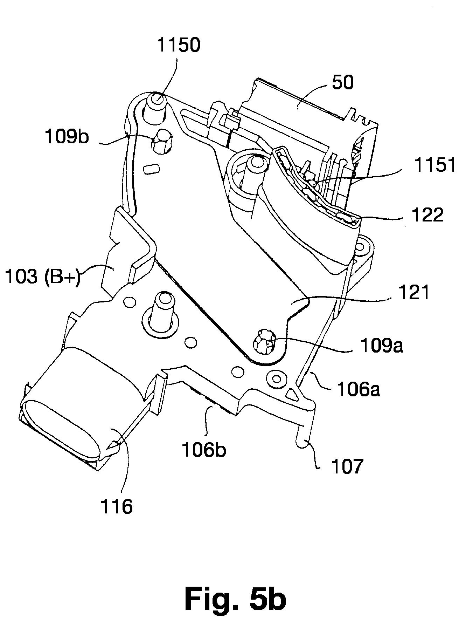

La Fig. 5b est une vue de dessous du module de contrôle 30 selon ce troisième mode de réalisation.

Comme on peut le voir, le premier pion de positionnement 109a est au plus près des deux séries de languettes de signal 106a et 106b pour limiter les erreurs de positionnement des languettes par rapport au dissipateur.

Par ailleurs on peut voir également :
- une plaque métallique 121 fixée par la vis 1150, ladite plaque étant préférentiellement en aluminium et étant ainsi mise à la masse dissipateur via ladite vis 1150, ladite plaque comprenant des substrats 123 de type céramique sur laquelle sont intégrés des composants électroniques,
- des capteurs de position 122 permettant de donner la position du stator de la machine électrique.

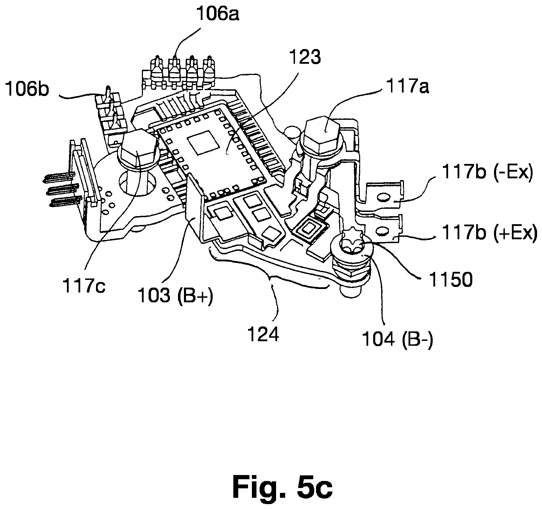

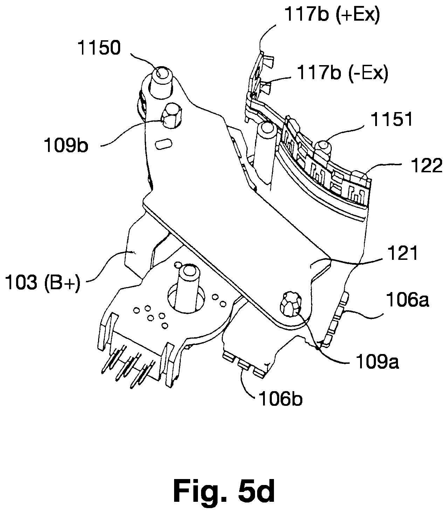

La Fig. 5c est une vue de dessus du module de contrôle/excitation sans surmoulage, sans le connecteur 116 et sans le porte balais 50. La Fig. 5d représente la vue de dessous.

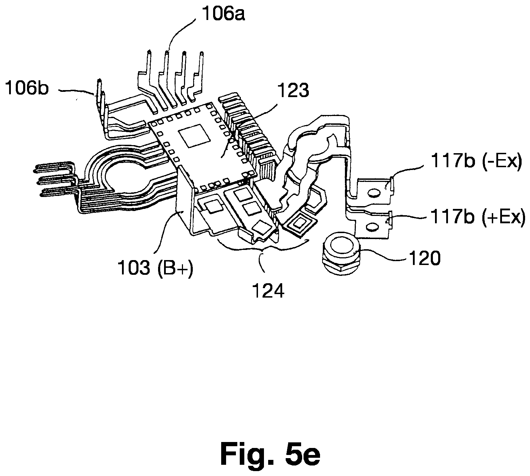

La Fig. 5e est une première vue sans prémoulage et sans surmoulage des traces du module de contrôle/excitation dans laquelle on peut voir notamment :
- une céramique 123 de contrôle comportant les composants électroniques pour le contrôle de la machine, et
- une partie excitation 124 comportant les composants électroniques pour l'excitation de la machine via le porte balais 50.

On peut voir les traces dudit module également à la Fig. suivante 5f sans prémoulage et sans le surmoulage plastique en vue de dessous.

On notera que le prémoulage est une opération qui s'effectue avant le surmoulage et qui permet de maintenir certains éléments en position, telles que les languettes de signal 106 par exemple.

On remarquera que dans tous les modes de réalisation, les composants électroniques 102, en particulier les transistors MOS sont montés sur les liaisons de puissance, à savoir ici la trace positive 103 et la trace de phase 105.

Préférentiellement, dans tous les modes de réalisation présentés ci-dessus, les traces de puissance des modules sont apparentes sur la face inférieure des modules. On peut ainsi les isoler électriquement du dissipateur ou palier dissipateur par de la colle à la place du plastique du boîtier 101. L'utilisation de la colle à la place du plastique du boîtier 101 permet d'avoir une épaisseur moindre sous les modules (environ 0.2mm dans un exemple non limitatif), et d'avoir une plus faible résistance thermique que le plastique de manière à avoir une meilleure dissipation dans le palier dissipateur ou dissipateur.

On notera que dans tous les modes de réalisation présentés ci-dessus, on peut bien entendu inclure ou non le connecteur de signal 116 dans le module de contrôle ou module de contrôle/excitation si on le désire. S'il n'est pas inclus, il sera dans le capot.

On notera que le module électronique selon tous les modes de réalisation présentés ci-dessus présente les avantages supplémentaires suivants :
- il utilise des puces nues pour les composants électroniques au lieu de composants standards dits packagés, de manière à réduire l'encombrement,
- il inclut les éléments permettant de piloter les transistors MOS appelés drivers,
- un module est configuré pour s'intégrer parfaitement sur le dissipateur ou palier dissipateur de sorte que :
   - il n'obture pas l'axe du palier dans lequel vient s'introduire l'arbre du rotor,
   - il existe un refroidissement axial avec le dissipateur rapporté (non intégré),
   - toutes les extrémités des traces de puissance et de signal sont à l'extérieur de la circonférence du dissipateur ou palier dissipateur, ce qui facilite les connexions à établir contrairement au cas où elles sont à l'intérieur de ladite circonférence, de manière à être accessibles et de sorte qu'il existe plus de place disponible sur le diamètre extérieur qu'intérieur pour lesdites extrémités
- un module est configuré préférentiellement pour une unique phase de sorte que :
   - le crochet du module soit en vis-à-vis de la sortie naturelle d'une phase de stator,
   - on a un module par phase. Ainsi, on s'adapte plus facilement à la place disponible sur le dissipateur ou palier dissipateur par rapport à un module unique comportant trois traces de phase, et ce de manière optimale
- la définition du module permet d'avoir un module de puissance, de contrôle et d'excitation de même architecture,
- il permet en cas de défaillance de soudure d'un des transistors d'éviter trop de rebus par rapport à un unique module pour les trois phases du stator.

On notera qu'on peut également prévoir un unique surmoulage pour l'ensemble des modules de puissance 20, du module de contrôle 30 et du module d'excitation 40 ou module contrôle/excitation 30/40.

A ce moment on aurait un unique module qui comporterait et la puissance, et le contrôle et l'excitation, ledit module comportant alors trois traces de phase.

### Autres éléments

Un module électronique 10, coopère avec les éléments suivants :
- un palier dissipateur 60 (dissipateur intégré au palier, i.e. monobloc avec ledit palier), ou un dissipateur 80 (dissipateur non intégré au palier, i.e. rapporté sur le palier)
- une pièce d'interconnexion de signal 22
- une pièce d'interconnexion de puissance 21, et
- un capot 70

Ces éléments sont décrits ci-après.

### Palier dissipateur

Un palier dissipateur a pour fonction d'évacuer la chaleur des modules électroniques.

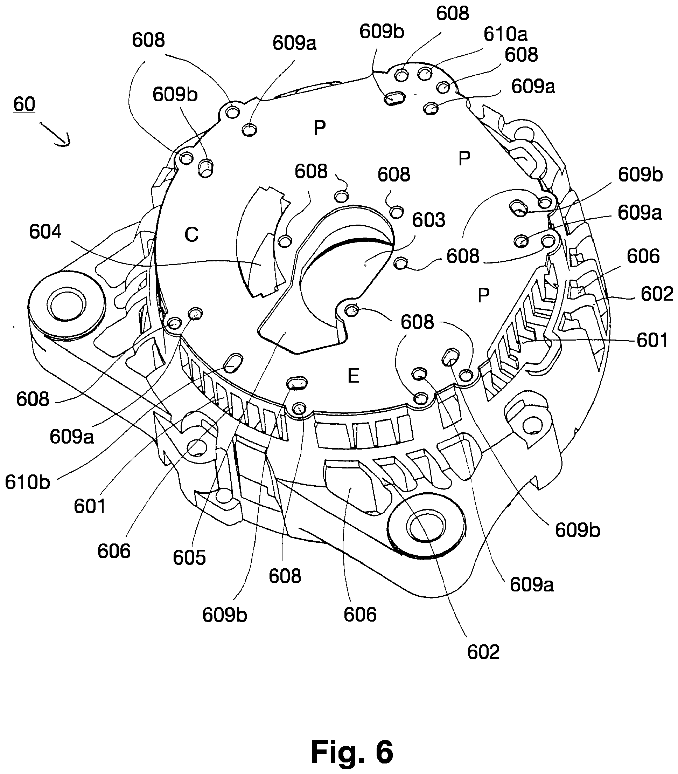

Le palier arrière dissipateur 60, représenté à la Fig. 6 comporte selon **un premier mode de réalisation non limitatif** :
- une pluralité d'orifices de positionnement 609, préférentiellement deux 609a, 609b par modules, pour positionner lesdits modules sur ledit palier, lesdits orifices se trouvant sur un même diamètre, soit dans l'exemple illustré, dix orifices,
- une pluralité d'orifices de fixation 608 pour recevoir les trois goujons de fixation de chaque module sur lesquels viendra se positionner la plaque de puissance, soit dans l'exemple illustré, quinze orifices
- des entrées d'air 601 comportant des ailettes 606,
- des sorties d'air 602 comportant des ailettes 606,
- différents dégagements référencés 603 pour l'arbre rotor de la machine électrique tournante, 604 pour des capteurs à effet hall permettant de connaître la position rotor, et 605 pour un porte balais 50, et
- des orifices de positionnement 610 pour positionner une plaque de signal, ici deux orifices 610a et 610b qui se répartissent de part et d'autre du diamètre du palier dissipateur. Préférentiellement un des orifices est le contrôle de référence du palier dissipateur, on utilise ainsi un orifice déjà existant.

On notera que la Fig. 6 montre les emplacements des différents modules. Ainsi, les emplacements marqués P, c, et E reçoivent respectivement les trois modules de puissance 20, le module de contrôle 30 et enfin le module d'excitation 40.

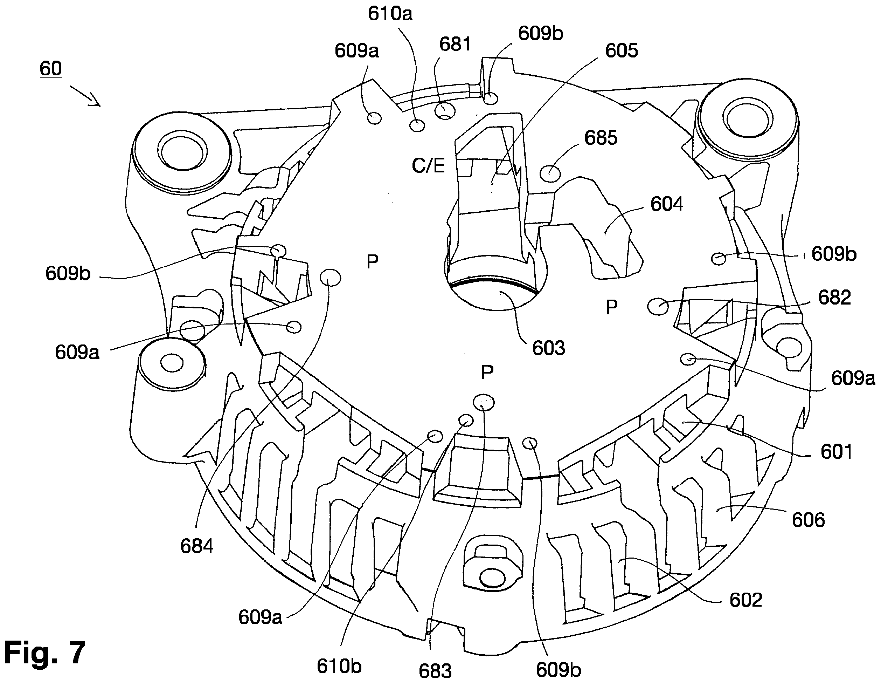

Selon **un deuxième mode de réalisation préférentiel non limitatif,** illustré à la Fig. 7, le palier dissipateur 60 comporte :
- une pluralité d'orifices de fixation, ici quatre, 681, 682, 683 et 684 pour recevoir quatre goujons de maintien de la plaque de signal,
- un orifice de fixation 685 pour recevoir une vis de fixation d'un porte balais 50, il n'y a pas de goujon ce qui évite la réduction de section de la trace B+ d'une plaque de puissance,
- les mêmes éléments suivants que le premier mode de réalisation :
   ▪ entrées d'air 601 comportant des ailettes 66,
   ▪ sorties d'air 602 comportant des ailettes 606,
   ▪ différents dégagements 603, 604 et 605, et
   ▪ les orifices de positionnement 610a et 610b de la plaque de signal.

On remarquera que les fonctions contrôle et excitation ont été réunis dans un seul module de contrôle/excitation. Par ailleurs, on notera l'emplacement C/E et P respectivement du module de contrôle/excitation et des modules de puissance 20 sur la Fig. 7.

On notera par ailleurs que les ailettes 606 peuvent de manière connue de l'homme du métier être remplacée par un circuit de refroidissement par liquide pour les deux modes de réalisation du palier dissipateur décrits ci-dessus.

### Dissipateur

Le dissipateur a pour fonction d'évacuer la chaleur des modules électroniques.

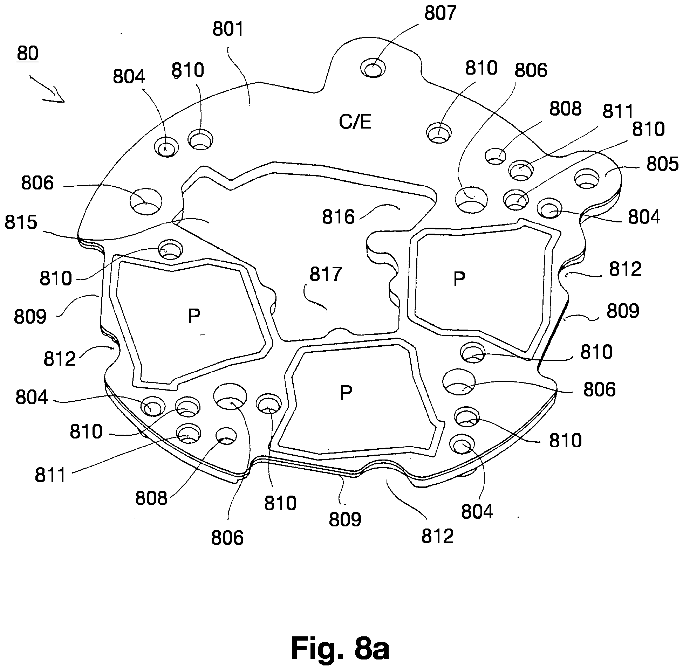

Le dissipateur 80 tel qu'illustré en vue de dessus de la Fig. 8a est indépendant du palier arrière de la machine tournante.

Il comporte selon un mode de réalisation préférentiel non limitatif :
- une plaque de base 801 préférentiellement en aluminium de fonderie, et
- des orifices de fixation 806 sur le palier arrière de la machine, ici quatre, pour recevoir des goujons de fixation d'une plaque de signal,
- un orifice de connexion électrique 805 pour relier le dissipateur à la masse via la plaque d'interconnexion de puissance au moyen d'un écrou,
- des orifices de fixation 804 pour fixer les modules, ici quatre, et les relier à la masse dissipateur via un insert,
- un orifice de fixation 807 pour fixer un connecteur de signal du module de contrôle/excitation via un insert,
- des orifices de positionnement mécaniques 808 pour positionner une plaque de puissance 21, ici deux répartis de part et d'autre du diamètre du dissipateur,
- des évidements 809 sur la circonférence pour recevoir des moyens de protection électrique, ici trois, pour la trace positive (B+) de la pièce d'interconnexion de puissance,
- des orifices de positionnement 810 des modules, ici deux par module, soit 8 orifices,
- des orifices de positionnement mécaniques 811 pour positionner une plaque de signal 22, ici deux répartis de part et d'autre du diamètre du dissipateur, et
- des évidements 812 pour insérer des logement de phase d'une plaque de puissance comme on le verra en détail plus loin. Il en existe donc trois ici,
- des dégagements 815, 816, 817 pour recevoir respectivement un porte balais, des capteurs de position, et l'arbre rotor.

On remarquera les emplacements C/E et P respectivement du module de contrôle/excitation et des modules de puissance 20.

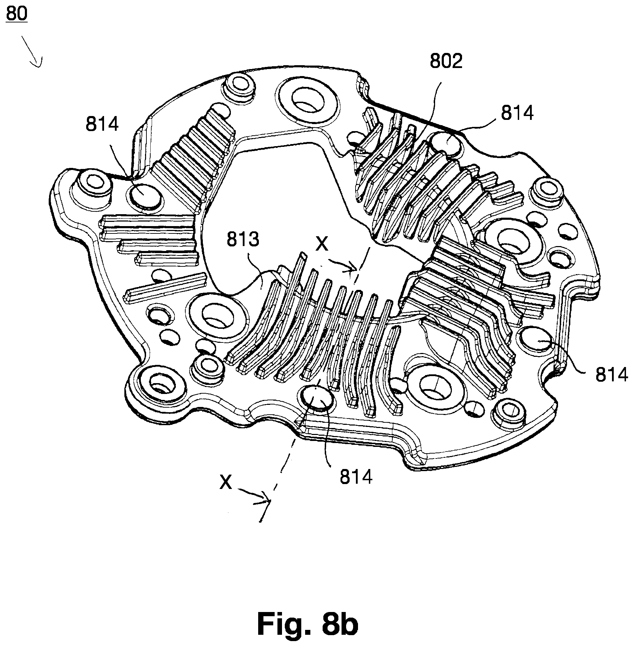

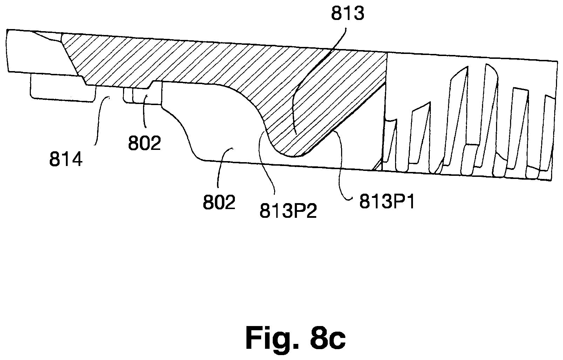

La Fig. 8b montre une vue de dessus du dissipateur. On peut voir que le dissipateur comporte en outre :
- des blocs d'ailettes de refroidissement 802 destinés à augmenter sensiblement la dissipation calorifique des modules de puissance 20, lesdits blocs se situant sur la face inférieure en position d'utilisation de la plaque de base 801,
- Des zones d'appui 814 pour recevoir des béquilles de contrainte de la pièce d'interconnexion de puissance qui permettent de supporter les vibrations moteurs,
- Un bossage 813 qui permet de guider l'air de l'entrée radiale de la machine vers l'intérieur de ladite machine et évite ainsi que l'air ne stagne au niveau du dissipateur. C'est également le cas pour l'air axial. Il est guidé vers l'intérieur de la machine. On remarquera que les ailettes à ce niveau traverse ledit bossage 813. On peut voir une coupe X-X du bossage sur la Fig. 8c.

Par ailleurs, on notera que la plaque de base 801 est configurée d'une part pour pouvoir être assemblée en sandwich entre, une plaque d'interconnexion de puissance et les modules, et une plaque d'interconnexion de signal, et d'autre part pour laisser au centre un passage suffisamment grand pour l'air de refroidissement de la machine électrique.

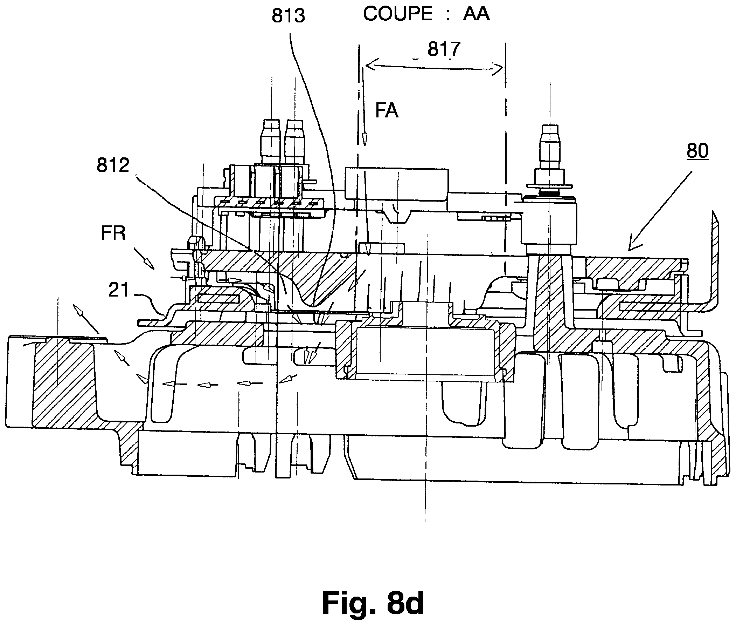

Comme indiqué sur la Fig. 8d, un premier flux de l'air entrera dans la machine ainsi de façon axiale FA. Cela a pour avantage d'augmenter la vitesse de l'air et ainsi de réduire les pertes de charge par rapport à un flux radial (cas des premier et deuxième modes de réalisation du palier dissipateur décrits précédemment).

De cette manière, on évite un rebouclage d'air réchauffé par la machine entre une sortie et une entrée du palier dissipateur (pour l'air entrant de façon axiale) et on évite ainsi de réinjecter de l'air chaud dans la machine.

Plus particulièrement, c'est l'espacement 817 qui est configuré de manière à laisser passer de l'air autour de l'arbre rotor et est donc plus large que le diamètre de l'arbre rotor ou pour être plus précis du protecteur de collecteur de l'arbre.

Ainsi, on se rapproche du refroidissement standard appliqué à un alternateur classique.

Par ailleurs, le flux d'air axial est guidé par la première pente 813P1 du bossage 813 du dissipateur de sorte qu'il n'y ait pas d'air stagnant sur la face inférieure du dissipateur au niveau des ailettes.

De plus, grâce au positionnement du dissipateur décrit, on a également un deuxième flux d'air qui est radial entre le dissipateur 80 et la pièce d'interconnexion de puissance 21. On peut le voir également sur la Fig. 8d. Cet air radial FR entre par le dissipateur et ressort par les ouvertures 606 du palier. Ce flux d'air radial augmente le débit d'air et améliore donc le refroidissement de la machine, ce dernier étant ainsi plus efficace que s'il n'y avait qu'un flux d'air axial.

De plus, grâce au bossage 813 situé au niveau des ailettes, ce flux d'air radial ne stagne pas car il est guidé par la deuxième pente 813P2 dudit bossage 813 vers l'intérieur de la machine.

On notera que ces flux d'air radial FR et axial FA sont accélérés par le ventilateur de la machine ce qui entraîne un meilleur refroidissement de la machine plus l'électronique du fait notamment de la disposition du dissipateur telle que décrite ci-dessus.

### Plaque d'interconnexion de signal

La plaque d'interconnexion de signal 22 est destinée à faire véhiculer différents signaux nécessaires au fonctionnement des modules et, par cela, au bon fonctionnement de la machine électrique tournante. De tels signaux sont par exemple :
- un signal de mode de fonctionnement de la machine électrique, par exemple moteur ou générateur,
- un signal indiquant la température des modules,
- un signal remontant un défaut détecté sur les modules,
- un signal de commande des interrupteurs des MOS etc.

Ces signaux sont véhiculés entre les modules de puissance 20 et le module de contrôle 30.

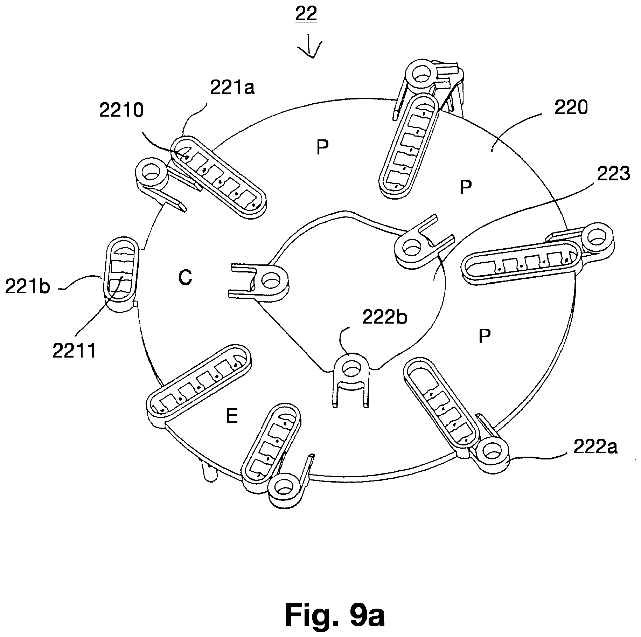

Les Fig. 9a à 9c représentent **un premier mode de réalisation non limitatif** de la pièce d'interconnexion de signal 22.

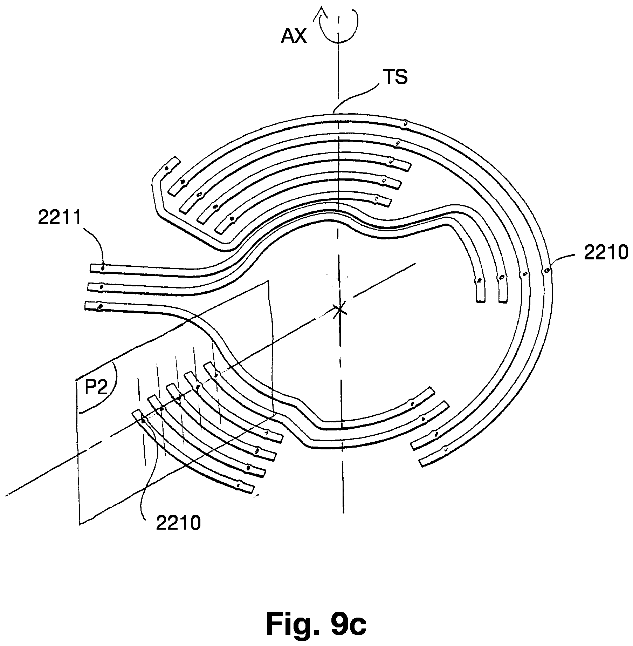

Elle comprend :
- une plaque de base 220 en matière isolante, préférentiellement en plastique, et préférentiellement sensiblement cylindrique, qui surmoule des traces métalliques de signal TS,
- un évidement central 223 pour alléger ladite plaque en matière,
- des évidements 221a pour laisser des traces métalliques apparentes TS, lesdites traces comportant des orifices d'interconnexion 2210, ici cinq orifices, dont les axes sont disposés dans un plan P2 (représenté à la Fig. 9c) perpendiculaire à la surface de la plaque et passant sensiblement par l'axe de rotation rotor AX, lesdits orifices étant destinés à recevoir les languettes de signal 106 d'un module électronique en vue d'être reliés électriquement,
- un évidement de connexion 221b pour laisser des traces métalliques apparentes TS, lesdites traces comportant des orifices d'interconnexion 2211, disposé suivant la périphérie extérieure de ladite plaque 22, lesdits orifices étant destinés à recevoir les languettes de signal 106 d'un module de contrôle, ici trois orifices, et
- des pattes de fixation 222 destinées à s'insérer dans un des trois goujons de maintien 113 d'un module électronique, et destiné à recevoir un écrou de fixation, lesdites pattes de fixation permettant de maintenir la plaque d'interconnexion de signal 22 sur les modules, via les goujons, des premières pattes 222a étant disposées sur le diamètre externe de ladite plaque et dépassant de ladite plaque, et des deuxième pattes 222b étant disposées sur le diamètre interne de ladite plaque et atténuant en outre des vibrations de la plaque.

On notera que les évidements 221a et 221b peuvent être protégés par la suite contre l'environnement extérieur par une résine par exemple.

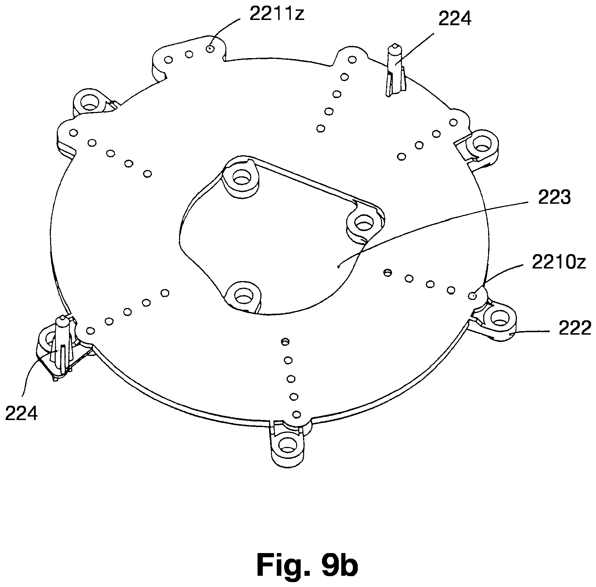

On notera par ailleurs que le surmoulage 220 comporte des orifices 2210z, 2211z en regard des orifices des traces métalliques TS tels qu'illustrés à la Fig. 9b.

La plaque de signal 22 comporte en outre :
- des pions de positionnement 224 pour assemblage sur un palier dissipateur 60, ici deux comme illustré sur la vue de dessous de la Fig. 9b, et
- des traces métalliques de signal TS configurées pour s'adapter à la forme de la plaque et à la position des languettes 106 des modules, et comportant des orifices d'interconnexion 2210, 2211 tels qu'illustrés sur la Fig. 9c. lesdites traces sont préférentiellement dans un même plan. Par ailleurs, elles sont préférentiellement configurées en forme d'arcs de cercle essentiellement concentriques par rapport à l'axe de rotation rotor.

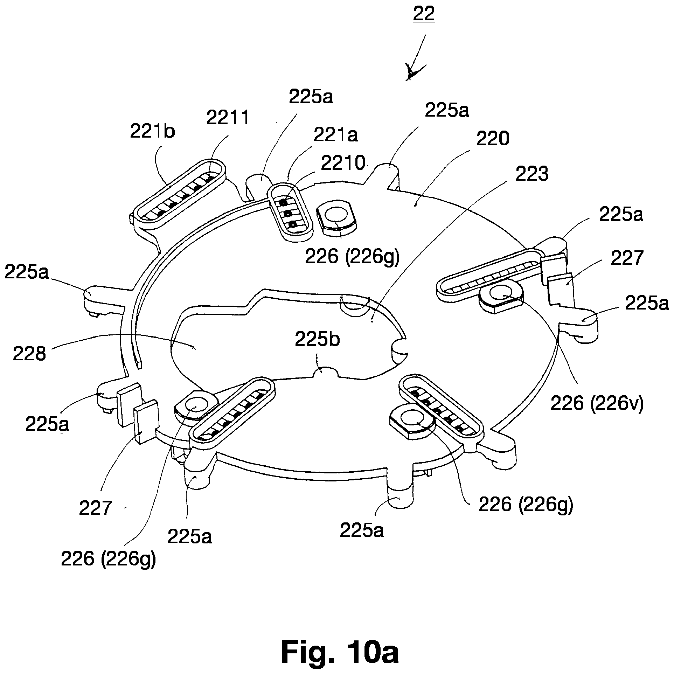

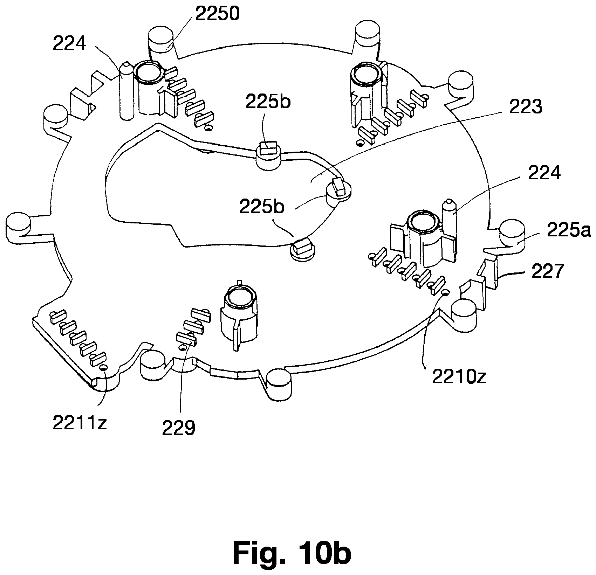

Les Fig. 10a à 10c représentent **un deuxième mode de réalisation préférentiel** de la pièce d'interconnexion de signal 22.

Cette plaque d'interconnexion de signal 22 comporte :
- à la place des pattes de fixation du premier mode, des béquilles 225 permettant de presser les modules contre un palier dissipateur, des premières béquilles 225a et des deuxièmes béquilles 225b étant positionnées respectivement sur la périphérie externe ou interne de ladite plaque, ici neuf au total ; on a ainsi trois points d'appui sur chaque module,
- à la place des trois évidements par module, uniquement trois inserts 226 d'appui destinés à recevoir trois goujons 226g, pour fixation sur le palier dissipateur 60, et
- un insert métallique 226 pour recevoir une vis 226v permettant de fixer la plaque sur le palier dissipateur. Cette vis évite de réduire la section des traces de puissance positives (B+) de la pièce d'interconnexion de puissance 21 (décrite plus loin).
   Ces quatre inserts permettent également d'éviter le fluage du plastique du surmoulage. On pourra donc également les utiliser pour le premier mode de réalisation.

La plaque 22 comporte en outre :
- au moins un logement de fixation 227 pour fixer la pièce d'interconnexion de puissance 21 et recevoir un clip de fixation (218), ici deux logements, et
- un évidement central 228 supplémentaire pour recevoir un porte balais.

Dans une première variante de réalisation de ce mode, la plaque comporte en outre des séparateurs 229 de languettes de signal 106 de manière à éviter des courts-circuits entre lesdites languettes, courts-circuits dus notamment au brouillard salin. Ainsi, on augmente la longueur de cheminement électrique entre les languettes.

Dans une autre variante, ladite plaque ne comporte pas de séparateurs. A ce moment, pour isoler lesdites languettes entre elles, on prévoit des joints qui entourent lesdites languettes 106 sur les modules eux-mêmes. Par la suite, la plaque de signal 22 comprimera ces joints.

On notera que ces deux variantes s'appliquent aux deux modes de réalisation du module électronique décrits ci-dessus ainsi qu'au troisième mode qui va être décrit plus loin.

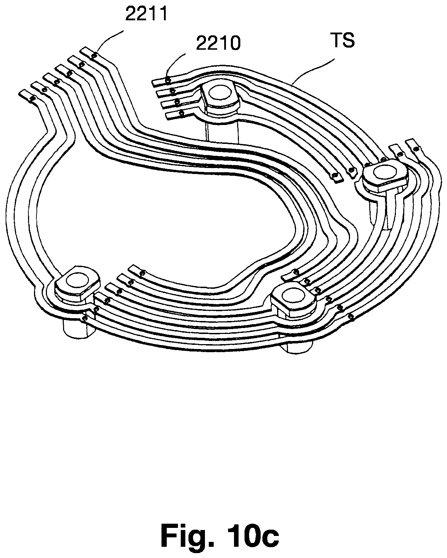

Sur la Fig. 10c, on peut voir les traces métalliques concentriques de la plaque de signal 22. Lesdites traces métalliques sont configurées pour s'adapter à la position des languettes 106 des modules, et préférentiellement à la forme de ladite plaque, et de plus pour contourner les quatre inserts 226. Elles sont préférentiellement configurées en forme d'arcs de cercle essentiellement concentriques par rapport à l'axe de rotation rotor.

On notera que, les béquilles 225 sont, d'une manière non limitative, de forme cylindrique. Cette forme présente une arrête vive 2250.

Par ailleurs, on notera que la plaque d'interconnexion 22 selon ce deuxième mode présente les mêmes éléments suivants que la plaque selon le premier mode :
- la plaque de base 220,
- les évidements 221a et 221b,
- l'évidement central 223 destiné à recevoir ici un arbre rotor,
- les pions de positionnement 224, et
- les traces métalliques TS avec les orifices 2210 et 2211.

On notera que, pour les premier et deuxième modes de réalisation décrits ci-dessus, les traces de signal sont préférentiellement configurées l'intérieur du diamètre sur lequel sont réalisés les terminaux de puissance (décrites détail plus loin). Cela permet à la plaque de puissance 21 (décrite plus loin) de coiffer la plaque de signal 22. Ainsi, le montage est facilité et lesdites traces de signal ne gênent pas les traces de puissance.

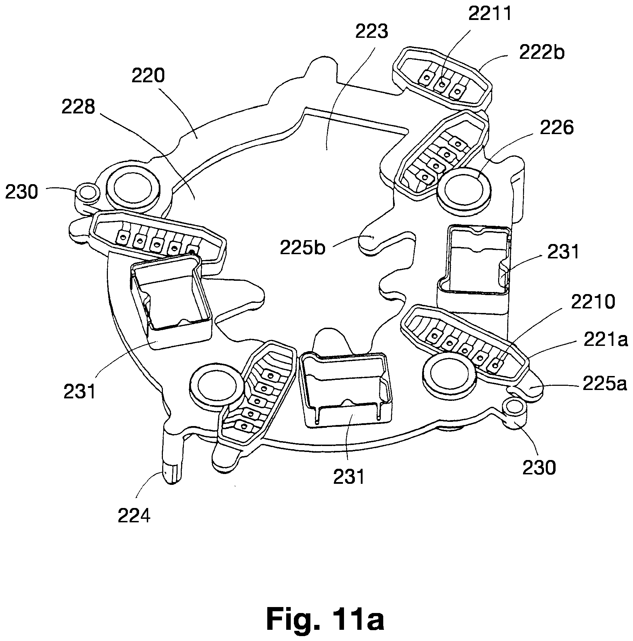

Les Fig. 11a à 11d représentent **un troisième mode de réalisation non limitatif** de la pièce d'interconnexion de signal 22.

Elle diffère du deuxième mode de réalisation en ce que :
- elle ne comporte plus de logements de fixation 227 pour positionner la pièce d'interconnexion de puissance 21 car dans ce mode, la plaque de puissance 21 se situe en dessous de la plaque de signal 22 comme on le verra en détail plus loin.
- les béquilles 225a et 225b ont une forme différente. Elles ont une forme qui ne comportent plus d'arrête vive ce qui évite que les contraintes subit par le plastique ne se concentrent sur les arrêtes vives. On diminue ainsi le risque de casser lesdites béquilles.

Ladite plaque de signal 22 comporte en outre :
- des protubérances évidées 230 pour prépositionner ladite plaque sur lesdits modules. Ici, il existe deux protubérances. Elles servent notamment pour un pré-guidage lors de l'assemblage process. Cela permet ainsi de fixer par la suite les pions de positionnement 224 de ladite plaque 22 dans le dissipateur 80. On va pouvoir ainsi positionner la plaque de signal 22 avant l'assemblage des languettes de signal 106, et

- des logements 231 pour y loger des capacités de filtrage. Ces capacités seront connectées aux modules électroniques. Les logements permettent une bonne tenue mécanique desdites capacités. De la résine sera déposée dans lesdits logements.

Par ailleurs, on notera que la plaque d'interconnexion 22 selon ce troisième mode présente les mêmes éléments suivants que la plaque selon le deuxième mode :
- la plaque de base 220,
- les évidements 221a et 221b,
- l'évidement central 223,
- l'évidement 228 pour le porte balais,
- les quatre inserts 226,
- les pions de positionnement 224, et
- les traces métalliques TS avec les orifices 2210 et 2211.

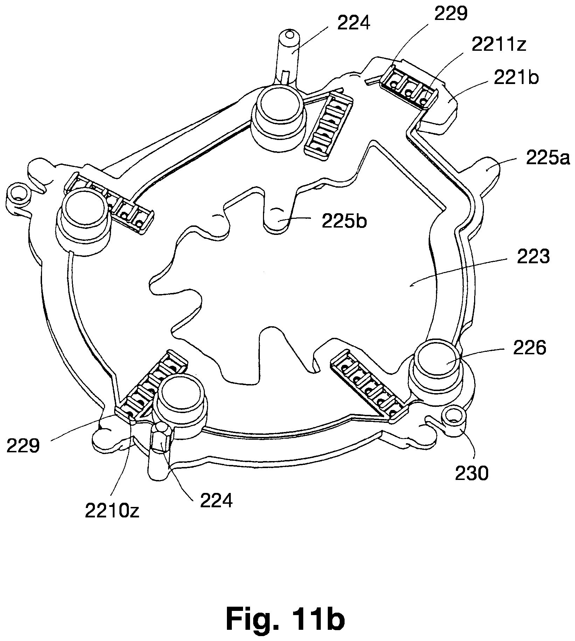

Selon une première variante de ce mode, les orifices 2210 et 2211 sont configurés de manière à effectuer une soudure à l'étain entre lesdits orifices et les languettes de signal 106 correspondantes. Ce sont donc des trous avec chanfrein tels qu'illustrés à la Fig. 11a et à la Fig. 11b en vue de dessous.

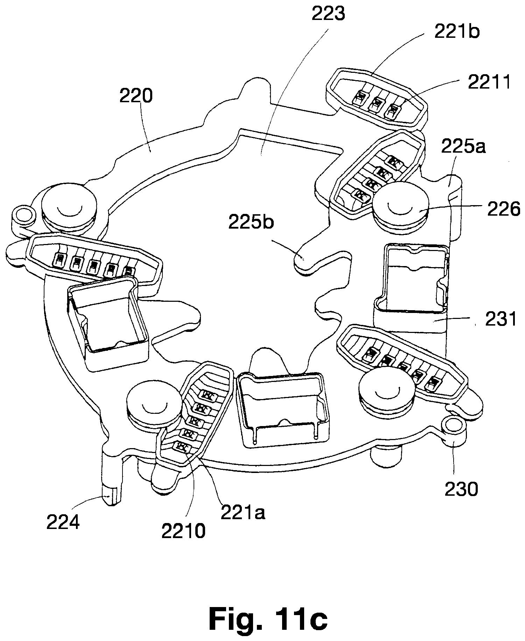

Selon une deuxième variante de ce mode, les orifices 2210 et 2211 sont configurés de manière à effectuer une soudure laser entre lesdits orifices et les languettes de signal 106 correspondantes. Ce sont donc des micro-languettes pliées comme illustrées sur la Fig. 11c.

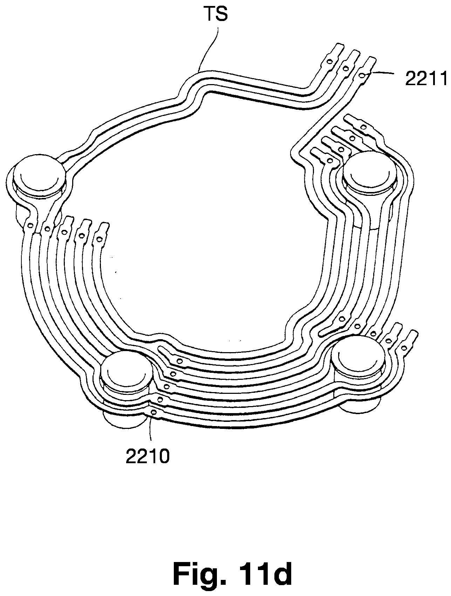

Sur la Fig. 11d, on peut voir les traces métalliques de la plaque de signal 22. Lesdites traces métalliques sont configurées pour s'adapter à la position des languettes 106 des modules, et préférentiellement à la forme de ladite plaque, et de plus pour contourner les quatre inserts 226. Elles sont préférentiellement configurées en forme d'arcs de cercle essentiellement concentriques par rapport à l'axe de rotation rotor.

Ainsi, contrairement à une carte électronique réalisant la fonction signal, une telle plaque de signal présente les avantages de :
- supporter de hautes températures, par exemple de 260°C, contrairement à une carte électronique classique en PCB, une telle carte PCB étant composée de traces cuivre avec un isolant polymère, lesdites traces en cuivre ne tenant pas les hautes températures.
- pouvoir être centrée au dessus des modules électroniques 10,
- comprendre des traces métalliques pas nécessairement en cuivre. En effet, en raison de la puissance relativement faible véhiculée par ces traces, on n'a pas forcément besoin d'un matériau à faible résistance électrique. Ainsi, lesdites traces peuvent par exemple être, de façon non limitative en acier,
- être au plus proche des modules ce qui évite d'avoir des languettes de signal pour les modules trop longues et évite ainsi des problèmes d'enfichage,
- grâce aux traces métalliques qui ne se chevauchent pas, on obtient une découpe de trace en une seule fois, on obtient une épaisseur fine de la plaque d'où un gain en encombrement axial de l'ensemble de la machine, et une fabrication de la plaque d'interconnexion de signal facilitée.

On notera que bien entendu, dans tous les modes de réalisation présentés ci-dessus, on peut également prévoir au lieu des orifices d'interconnexions 2210, 2211 d'autres moyens d'interconnexion tels que des languettes pliées par exemple.

### Plaque d'interconnexion de puissance

La pièce d'interconnexion de puissance 21 permet de distribuer la puissance entre les modules électroniques 20, 30, 40 depuis l'extérieur (notamment la batterie du véhicule).

Cette pièce est indépendante des modules électroniques ce qui permet d'alimenter chaque module indépendamment en courant et évite ainsi les échauffements des modules liés au passage du courant destiné à un module dans tous les modules. Ainsi, selon la configuration de cette pièce et des modules associés, il n'y pas de circulation de courant entre les trois modules de puissance.

La pièce d'interconnexion 21 se présente, dans le cas le plus simple, sous la forme d'une plaque réalisée en un matériau électriquement isolant, préférentiellement du plastique.

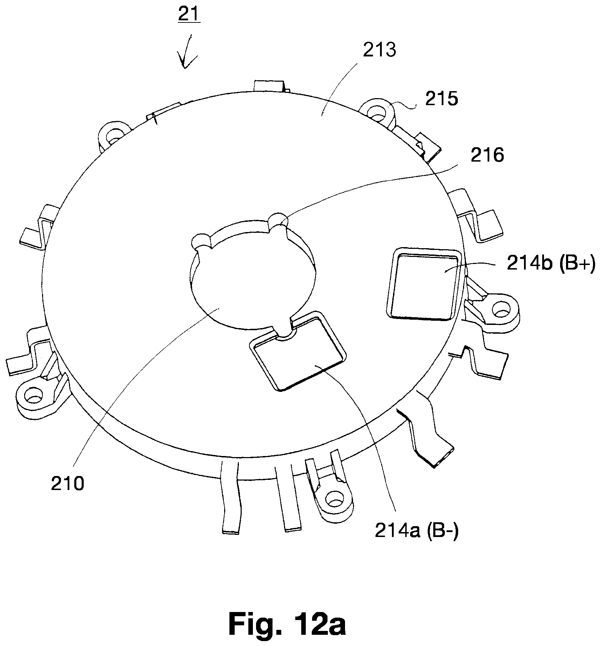

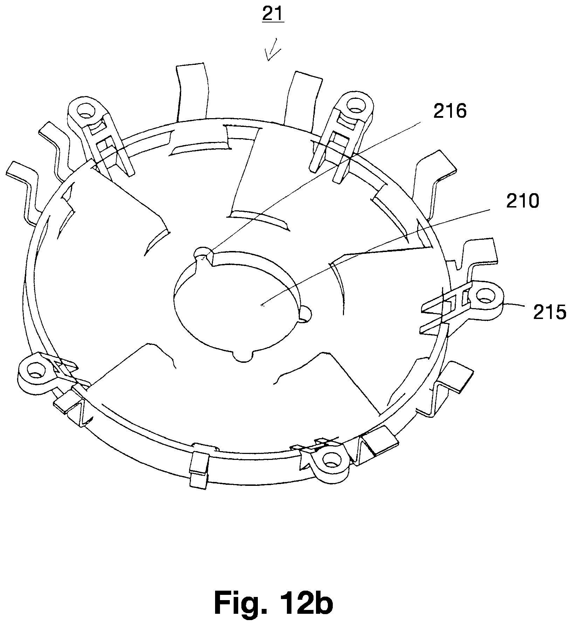

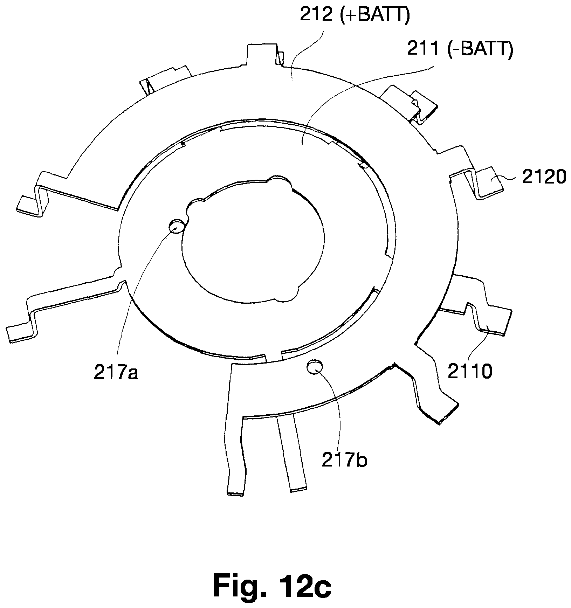

**Dans un premier mode de réalisation non limitatif,** illustré aux Fig. 12a à 12c, elle comporte :
- un évidement central 210 pour alléger ladite plaque en matière,
- des traces d'interconnexion de puissance 211(-BATT), 212 (+BATT),
- des terminaux de puissance négatifs 2110 et positifs 2120 issues des traces de puissance respectives 211, 212,
- un surmoulage plastique 213 sur lesdites traces d'interconnexion 211 et 212,
- un premier évidement 214a,
- un deuxième évidement 214b, et
- des pattes de fixation 215.

Les éléments de la plaque d'interconnexion de puissance sont décrits en détail ci-après.
- Les traces d'interconnexion de puissance 211, 212 sont disposées au moins sur une face de la plaque. Ce sont des traces en un métal peu résistif, préférentiellement en cuivre, qui sont surmoulées dans de la matière plastique de la plaque de puissance 21. Elles peuvent être réalisées sous la forme de bandes plates clipsées, rivetées, collées ou fixées de toute autre manière appropriée sur la plaque en matière plastique.

Selon un mode de réalisation préférentiel, les traces 211, 212 sont imbriquées (la trace 211 est entourée par la trace 212) et concentriques et sur un même plan. Dans ce cas, les terminaux de puissance négatifs 2110 sont pliés de façon à ne pas être en interférence avec la trace d'interconnexion positive 212 (+BATT). De cette manière, on peut optimiser l'emplacement des évidements 214a, 214b pour orienter un capot suivant le besoin d'un connecteur client qui effectue la liaison de la machine avec l'extérieur. Lesdites traces 211 et 212 ne se superposent pas de manière à permettre une connexion électrique avec les traces d'un tel capot, ladite zone comprenant les évidements 214a et 214b.

Selon un deuxième mode de réalisation, les traces 211, 212 peuvent être superposées l'une sur l'autre. Cela favorise un encombrement radial.

Enfin, on notera que chacune des traces d'interconnexion de puissance 211, 212, comprend un trou 217a, 217b permettant de positionner en x, y ladite trace dans un moule, ce dernier permettant de faire le surmoulage plastique 213.
- Les traces d'interconnexion de puissance 211, 212 présentent respectivement des terminaux de puissance négatifs 2110 (-BATT) en forme de L, et positifs 2120 (+BATT). Lesdits terminaux s'étendent radialement vers la périphérie externe de ladite pièce 21. Ces terminaux présentent des extrémités libres recourbées. Les dimensions et la position précises des terminaux 2110, 2120 sont déterminées de façon à leur permettre de se positionner au-dessus des extrémités de traces 104, 103 de chacun des modules afin de pouvoir être reliées auxdites traces au moyen d'une soudure, d'un brasage ou d'un soudo-brasage par exemple. Cette configuration des terminaux de puissance (en forme de L et présentant des extrémités recourbées par pliage) sur le diamètre extérieur facilite ainsi l'assemblage avec les modules. Ces terminaux permettent ainsi d'obtenir une liaison électrique avec les traces correspondantes 103, 104 des modules électroniques 10 de sorte que la puissance électrique est distribuée dans chacun desdits modules. On remarquera que la trace de puissance positive 212 chevauche les terminaux d'interconnexion négatifs 2110.
- Le surmoulage 213 comporte un premier évidement 214a pour une connexion électrique de la trace d'interconnexion 211, par soudure laser de préférence, avec un capot vers la batterie,et un deuxième évidement 214b dans ledit surmoulage pour une connexion électrique de la trace d'interconnexion 212, par soudure laser de préférence, avec un capot vers la batterie.

Par ailleurs, le surmoulage 213 comprend des évidements d'assemblage 216 permettant à un outillage d'assemblage de traverser ladite plaque et d'assembler le palier dissipateur arrière avec un palier avant.

On notera que les extrémités des terminaux de puissance 2110 et 2120 ne sont pas surmoulées de sorte que lesdites extrémités peuvent s'appuyer sur les extrémités des traces 104, 103 des modules. Préférentiellement, l'ensemble de la pièce terminal de puissance n'est pas surmoulé de sorte que l'assemblage sur les extrémités des traces est facilité. En effet, cela apporte plus de flexion dans un tel assemblage.
- Les pattes 215 s'étendent sensiblement radialement sur la périphérie extérieure de la plaque d'interconnexion. Chacune des pattes 215 est pourvue d'un orifice permettant d'y passer, lors de l'assemblage des différents modules et autres éléments de l'agencement, des moyens de fixation telles des tiges filetées ou des boulons ou des gougeons ou tout autre élément de fixation approprié.

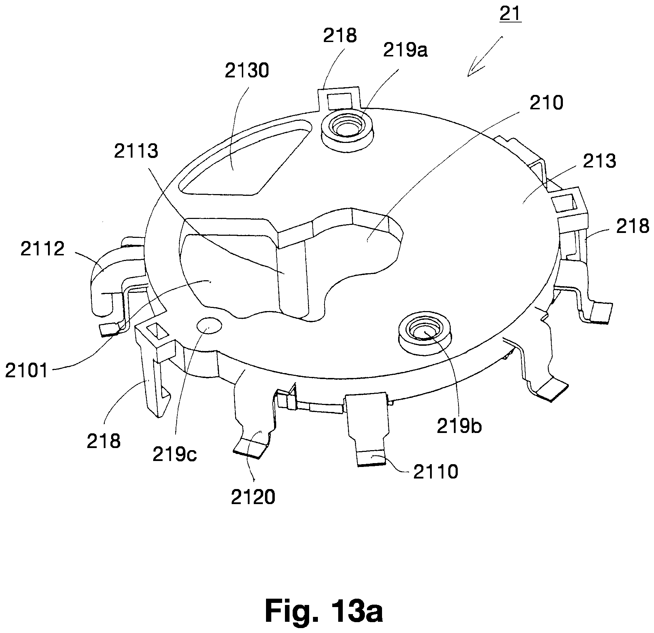

**Dans un deuxième mode de réalisation non limitatif,** illustré aux Fig. 13a à 13c, la plaque d'interconnexion de puissance 21 comporte:
- un évidement central supplémentaire 2101,
- au moins un clip de fixation 218,
- des inserts 219a, 219b pour recevoir des goujons de maintien,
- une butée mécanique 2112,
- au moins un pion d'appui 2113, et
- un orifice 219c.

Les éléments de la plaque d'interconnexion de puissance sont décrits en détail ci-après.
- l'évidement central supplémentaire 2101 permet l'insertion du porte balais avec son protecteur. Dans ce cas, le protecteur cage balais est une pièce indépendante assemblée sur le porte balais, et le porte balais peut être amovible par rapport au module de contrôle/excitation, ce qui facilite la maintenance de la machine notamment dans une optique de seconde monte, c'est-à-dire lorsque l'on change les balais (et donc le porte balais) quand ils sont usés. Ainsi, au lieu de changer toute l'électronique (les modules et les deux plaques), on ne changera que le porte balais (si l'électronique n'est pas défaillante).
- les clips de fixation 218 permettent une tenue mécanique de la plaque 21 sur la plaque de signal 22, ici trois,
- Les inserts 219a et 219b pour recevoir des goujons de maintien, ici deux au total, et pour relier les traces de puissance 211, 212 à un capot 70. Les deux inserts 219a, 219b permettent d'accéder auxdites traces de puissance de sorte qu'un surmoulage 213 peut être effectué sur lesdites traces comme illustré sur la Fig. 13a. Ces deux inserts permettent ainsi une tenue mécanique de la plaque 21 et une connexion électrique.
- Le dernier orifice 219c permet uniquement une tenue mécanique de ladite plaque 21 via un goujon.
- La butée mécanique 2112 permet d'arrêter la plaque de puissance 21 en translation lorsqu'elle est assemblée. Elle prend appui, par exemple, sur le module de contrôle/excitation. Par ailleurs cette butée à une longueur plus petite que les terminaux de puissance 2110 et 2120 des traces de puissance de sorte que lesdits terminaux prennent appui sur les traces des modules correspondantes avant que la butée n'appuie sur le module de contrôle. La butée est disposée sur le diamètre extérieur de la plaque et dépasse de cette plaque.
- les pions d'appui 2113, ici deux, permettent à ladite plaque 21 d'appuyer sur le palier dissipateur lors de l'assemblage.

La plaque 21 comporte, tels que décrits dans le premier mode :
- l'évidement central 210,
- les traces de puissance 211, 212,
- les terminaux de puissance négatifs 2110 et positifs 2120, et
- le surmoulage 213.

On notera que le surmoulage 213 comporte ici un dégagement 2130 permettant d'alléger la matière plastique, ledit dégagement étant possible car il n'existe pas de traces de puissance en regard. De la même façon que dans le premier mode de réalisation, les terminaux de puissance 2110 et 2120 ne sont pas surmoulés.

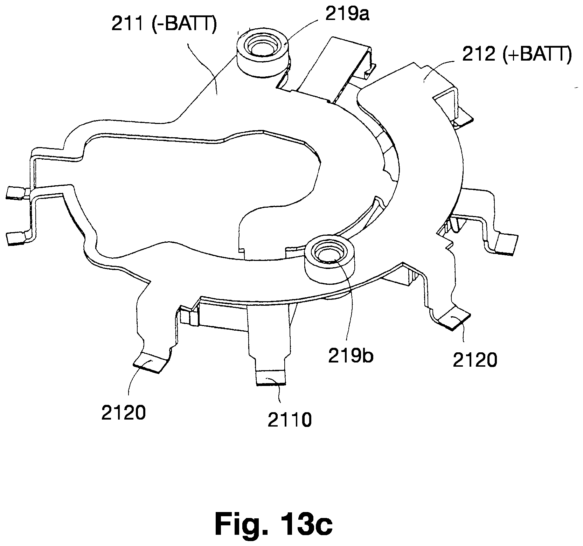

Les traces de puissance 211 et 212 sont représentées à la Fig. 13c.

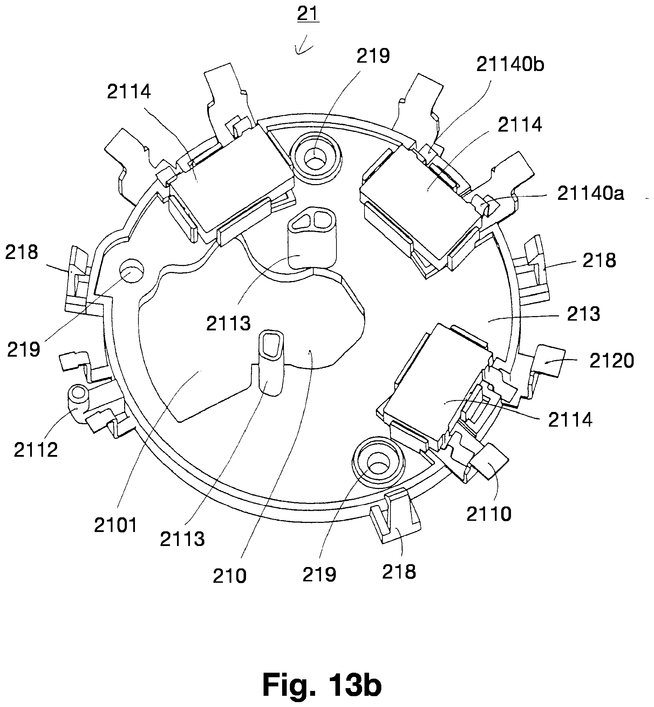

Par ailleurs, selon les premier et deuxième modes de réalisation :
- la plaque 21 peut en outre intégrer des composants passifs de filtrage 2114 représentés à la Fig. 13b, par exemple des capacités connectées entre les traces de puissance 211 (-BATT), 212 (+BATT) via des micro-languettes 21140a et 21140b. Ceci permet par exemple de filtrer la tension du réseau de bord du véhicule automobile, et de filtrer notamment des oscillations dues aux composants de conversion électriques MOS, diodes....
- préférentiellement, les extrémités des traces de puissance sont plates et affleurantes en surface du module. Ainsi, cette configuration a pour avantage de pouvoir souder des traces d'une plaque de puissance (décrite en détail plus loin) sur les extrémités des traces d'un module par transparence plat sur plat,
- la plaque d'interconnexion de puissance 21 peut en outre intégrer un protecteur cage balais (non représenté) qui permet de rendre étanche le porte balais. Ceci permet d'avoir une pièce de moins à assembler. Le porte balais permet l'alimentation du courant d'excitation issu du module d'excitation vers le rotor via des balais. Ledit protecteur comporte alors des guides de positionnement qui vont permettre de positionner ledit protecteur en regard du porte balais,
- préférentiellement, les terminaux positifs 2120 sont des pattes rigides définissant un plan d'appui de référence pour ladite pièce de puissance sur les traces correspondantes des modules,
- préférentiellement, les terminaux de puissance négatifs 2110 sont des pattes flexibles pour prendre en compte les tolérances d'assemblage. Ainsi, lors de l'assemblage des modules et de ladite plaque, cela va permettre de déformer les traces de ladite plaque de puissance avant soudage par transparence. Cela facilite ainsi la mise en contact des traces de l'interconnexion de puissance avec les traces correspondantes des modules. On pourra utiliser cette flexibilité également pour le premier mode de réalisation, également pour le troisième mode décrit ci-après (bien que cela ne soit pas nécessaire).

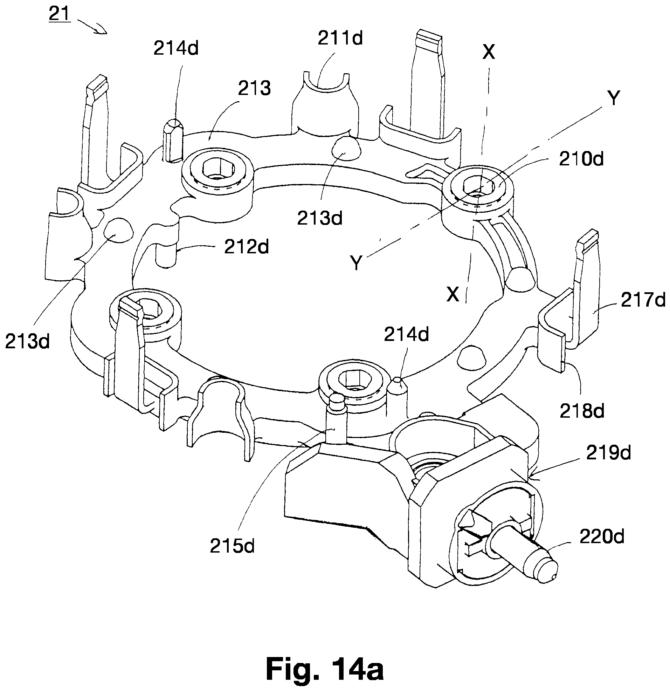

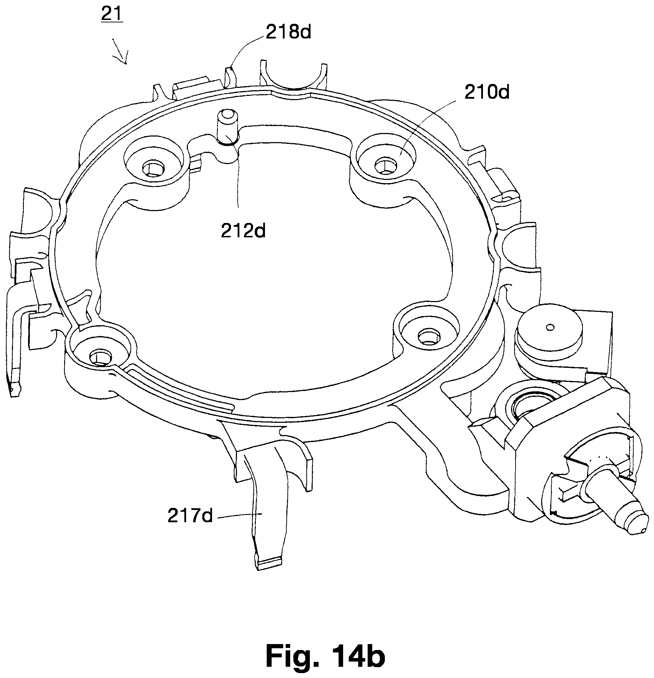

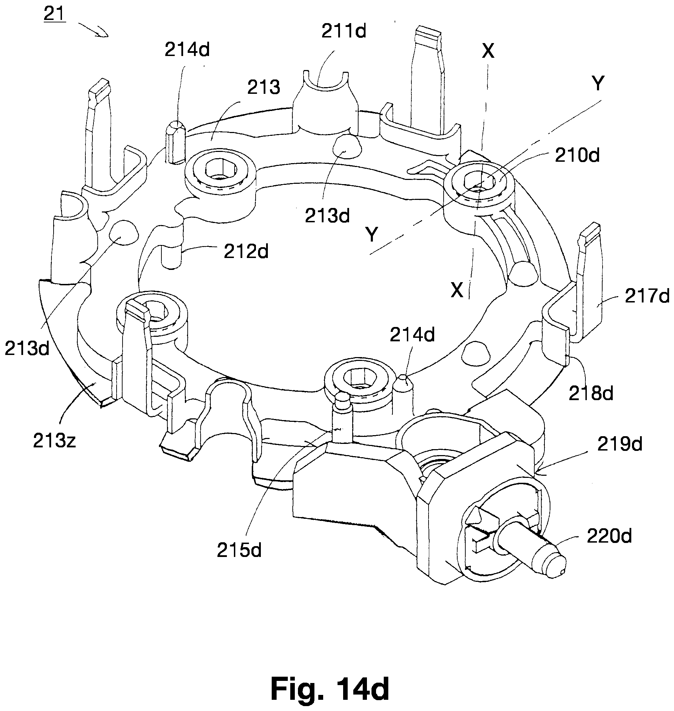

Les Fig. 14a à 14e représentent **un troisième mode de réalisation non limitatif** de la pièce d'interconnexion de puissance 21.

La plaque d'interconnexion de puissance 21 comporte :
- des inserts 210d pour établir une liaison mécanique avec le palier arrière de la machine,
- des moyens de protection 211d de phase de stator,
- des moyens de positionnement 212d sur le palier arrière de la machine,
- des béquilles de contrainte 213d
- des moyens de positionnement 214d de ladite plaque dans le dissipateur 80,
- une borne de fixation 215d permettant de fixer ladite plaque sur le dissipateur 80,
- un insert électrique 216d,
- un connecteur de puissance 219d
- des traces positive 221d (B+) et négatives 222d (B-) surmoulées dans du plastique,
- des terminaux de puissance positifs 217d issues de la trace positive B+,
- des moyens de protection 218d des terminaux de puissance positifs 217d,
- une borne 220d de liaison mécanique à un connecteur client de puissance (non représenté) relié à la batterie, et
- un orifice de liaison mécanique 220e relié à la borne de liaison 220d.

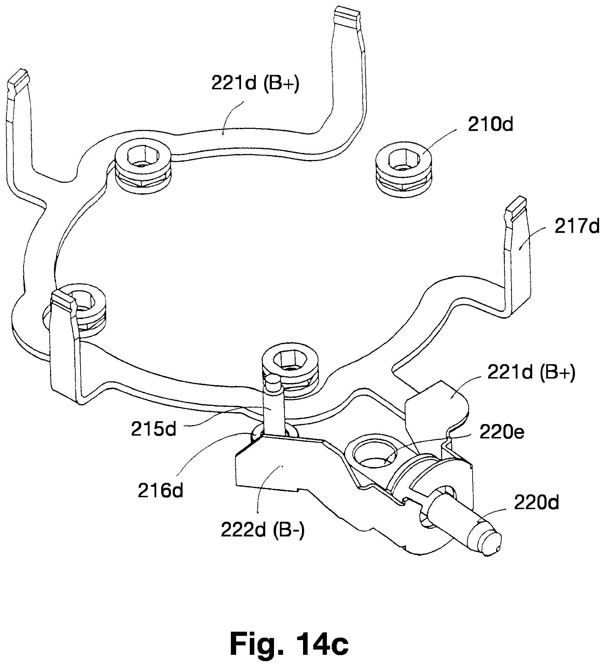

Les éléments de la plaque d'interconnexion de puissance sont décrits en détail ci-après.
- Les inserts 210d pour établir une liaison mécanique avec le palier arrière de la machine, au moyen de vis par exemple, ici au total quatre,
- les moyens de protection 211d de phase de stator se situent sur le diamètre extérieur de ladite plaque et dépassant le plan de ladite plaque, lesdits moyens évitant un contact entre une phase de stator et la masse dissipateur ou masse palier notamment,
- les moyens de positionnement 212d sur le palier arrière de la machine, lesdits moyens étant ici un pion de positionnement, s'étendent sur la face inférieure de la plaque, ledit pion se positionnant avantageusement dans un trou oblong qui est l'orifice de référence d'usinage du palier,
- les béquilles de contrainte 213d permettent une déformation axiale vers le bas de ladite plaque de puissance pour éviter des problèmes de vibration, lesdites béquilles étant préférentiellement de hauteur plus grandes que les inserts 210d pour être sûr de déformer la plaque, lesdites béquilles s'étendant sur la face supérieure de la plaque,
- les moyens de positionnement 214d de ladite plaque dans le dissipateur 80, ici deux, s'étendent sur la face supérieure de ladite plaque,
- la borne de fixation 215d permet de fixer ladite plaque sur le dissipateur 80 au moyen d'un écrou, et est connectée à la trace négative de puissance B-, ce qui réalise une mise à la masse du dissipateur,
- l'insert électrique 216d est destiné à s'assembler avec la borne 215d sur la trace 222d, ladite trace étant ainsi prise en sandwich par ledit insert et ladite borne, ce qui évite ainsi une soudure difficile à réaliser entre le dissipateur, qui est préférentiellement en aluminium de fonderie et la trace de puissance en cuivre,
- le connecteur de puissance 219d comporte une trace négative B- et une trace positive B+,
- les terminaux électriques de puissance 217d issus d'une trace positive B+, sont ici en forme de L et présentent une languette axiale, i.e. perpendiculaire au plan de ladite plaque 21 et dépassant ledit plan vers le haut ; lesdits terminaux ne sont pas surmoulés pour permettre une connexion avec l'extrémité de la trace positive 103 (B+) d'un module électronique, les terminaux s'étendent vers la périphérie externe de ladite pièce 22,
- les moyens de protection 218d des terminaux électriques 217d protègent contre les courts-circuits et le brouillard salin notamment,
- les traces positive 221d (B+) et négative 222d (B-) sont surmoulées dans du plastique 213 par exemple, traces que l'on peut voir à la Fig. 14c. Les traces se trouvent apparentes sur le connecteur de puissance 219d ce qui permet la mise en place du connecteur client de puissance pour réaliser les liaisons électriques entre ledit connecteur et lesdites traces,
- la borne 220d de liaison au connecteur de client relié à la batterie, ladite borne permettant de réaliser une pression entre les traces 221d et 222d et les traces du connecteur client de puissance de sorte que le courant puisse s'établir correctement entre la batterie et la machine, et
- un orifice 220e de liaison mécanique pour une vis, évitant ainsi la transmission des sollicitations mécaniques au surmoulage lorsque l'on fixe le connecteur client de puissance sur la borne de liaison 220d.

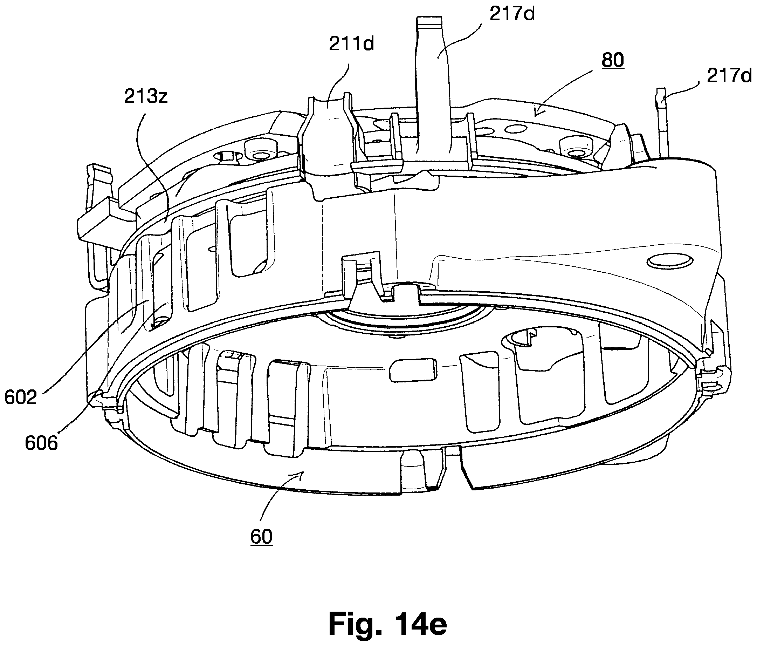

Préférentiellement, dans une variante de réalisation, comme représenté à la Fig. 14e, le surmoulage 213 de la plaque de puissance 21 recouvre les ouvertures des sorties d'air du palier (jusqu'au diamètre extérieur du palier) de manière à guider l'air en sortie pour diminuer un rebouclage radial de l'air vers l'intérieur de la machine. Ainsi, ledit surmoulage comporte une collerette de recouvrement 213z représenté à la Fig. 14e.

Ainsi, la plaque de puissance présente les avantages de :
- avoir une unique trace sans chevauchement, ladite trace permettant de réaliser un moulage et un positionnement plus faciles,
- se fixer sous le dissipateur 80 et donc d'être séparé par une masse de la plaque d'interconnexion de signal 22, de sorte que le signal de puissance B+ ne perturbe pas les signaux de ladite plaque d'interconnexion de signal 22.
- Un gain en encombrement axial puisque la plaque de puissance 21 se place dans l'encombrement nécessaire aux ailettes du dissipateur,
- Permettre au dissipateur d'être en masse isolée (par rapport à celle du palier) ou non, donc une masse différente de celle du palier, évitant ainsi les perturbations du réseau de bord lors d'un démarrage notamment.

On notera que grâce à la présence de la plaque de puissance 21, on a une grande section de cuivre pour véhiculer la puissance nécessaire au fonctionnement de la machine (150A en mode alternateur, 600A au démarrage) contrairement à une solution dans laquelle les traces de puissance sont intégrées dans une ceinture comprenant également les modules électroniques de puissance.

### Capot

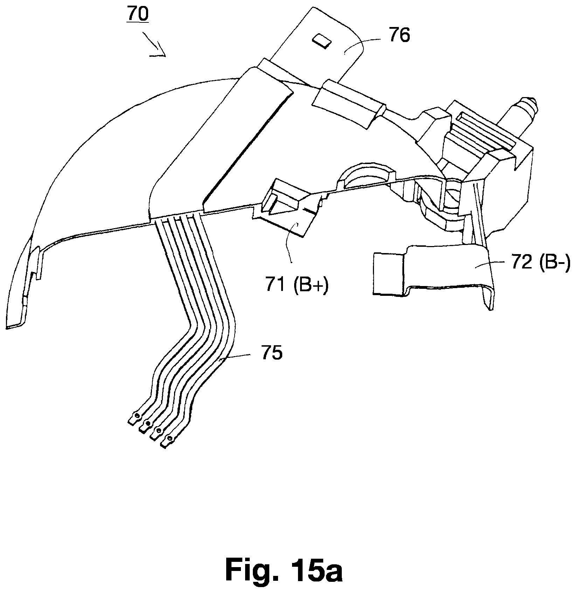

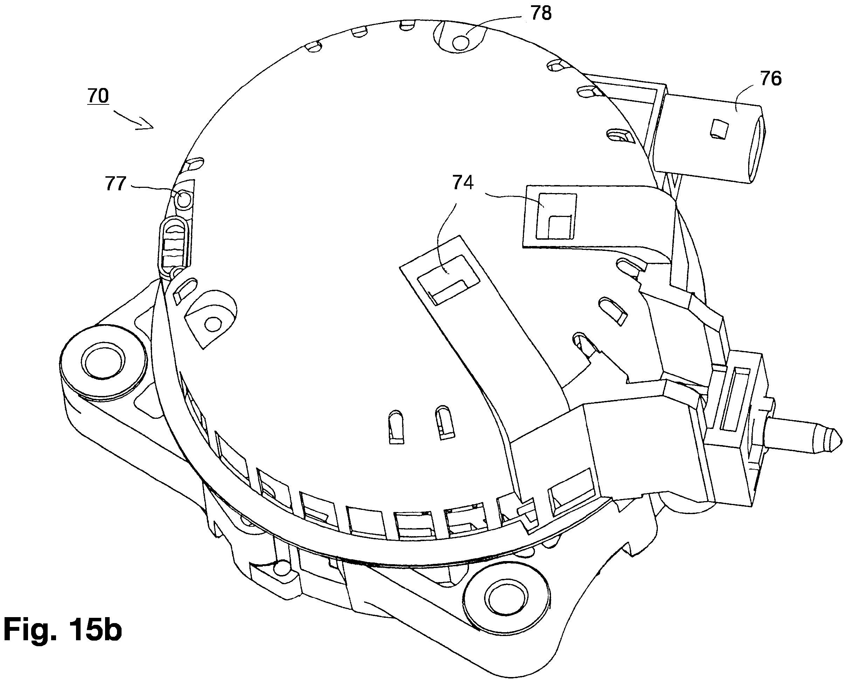

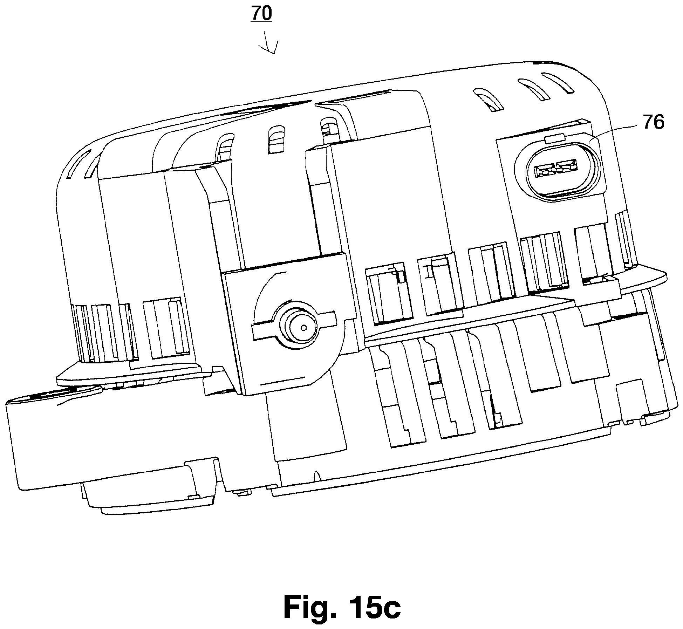

**Selon un premier mode de réalisation non limitatif**, le capot 70 tel qu'illustré aux Fig. 15a à 15c comporte :
- des traces de puissance 71 positive (B+), et négative 72 (B-),
- deux ouvertures 74 pour effectuer des soudures des traces 71, 72 avec les traces correspondantes de la plaque de puissance 21,
- des traces de signal 75 permettant un liaison entre les modules et une connectique de signal 76,
- une connectique de signal 76,
- des rainures ou orifices pour détromper 77, et
- des orifices de fixation 78 pour fixer des vis ou écrous par exemple.

Les éléments du capot sont décrits en détail ci-après.
- Les traces de puissance 71, 72, sont destinées à relier électriquement les traces de puissance 212, 211 de la pièce d'interconnexion de puissance 21 assurant la connexion avec le connecteur de puissance client du véhicule automobile. Les traces de puissance 71, 72 sont surmoulées dans le capot 70 et soudées au laser aux deux traces 212, 211 de la pièce d'interconnexion 21. Les liaisons électriques réalisées entre ces deux éléments, par exemple au travers de l'ouverture 74 prévue à cet effet. Les liaisons électriques peuvent être réalisées par soudure, notamment par soudure laser ou soudure brasage, ainsi que par brasage ou par contact mécanique. Dans ce dernier cas, le contact mécanique est obtenu par exemple par des vis de fixation du capot 70 exerçant une pression sur les traces.
- La connectique de signal 76 permet un dialogue avec les autres boîtiers électroniques du véhicule. Cette connectique comporte des traces de signal 75 intégrées dans le capot 70 et connectées d'un côté au module de contrôle 30 et de l'autre extrémité au connecteur de signal client (non représenté). Ledit connecteur client de signal comporte un câble de liaison vers un moyen de contrôle tel que, par exemple, un calculateur contrôlant différentes fonctions du véhicule comme, par exemple, la gestion de la machine électrique tournante selon ses fonctions de générateur ou de moteur.
- Les rainures ou orifices pour détromper 77 permettent de positionner correctement le capot 70 sur les guides 107 du module de contrôle 30. Lesdites rainures ou orifices coopèrent ainsi avec des guides 107 du module de contrôle 30.

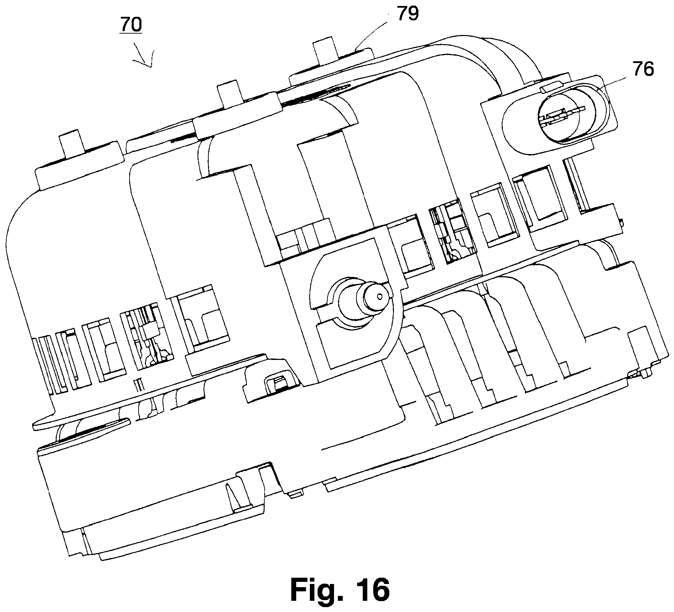

**Selon un deuxième mode de réalisation préférentiel non limitatif,** illustré à la Fig. 16, le capot comporte :
- des ouvertures 79 destiné à recevoir des moyens de fixation tels que des goujons à la place des vis.

Il comporte en outre les éléments suivants décrits dans le premier mode.
- les traces de puissance 71, 72,
- l'élément de connexion 73 au réseau de bord,
- les deux ouvertures 74,
- l'interconnexion de signal 75,
- la connectique de signal 76, et
- les rainures ou orifices pour détromper 77.

On notera que le capot 70 tel que décrit dans les deux modes est destiné à être une pièce spécifique à chaque client en raison de l'emplacement spécifique et du type du (des) connecteur(s) client utilisé(s).

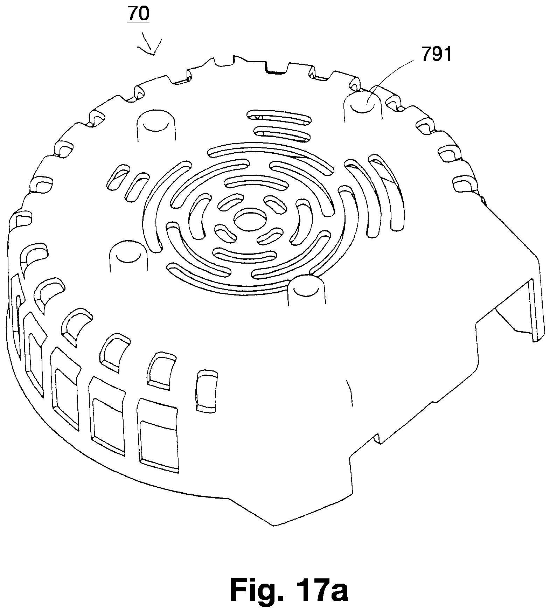

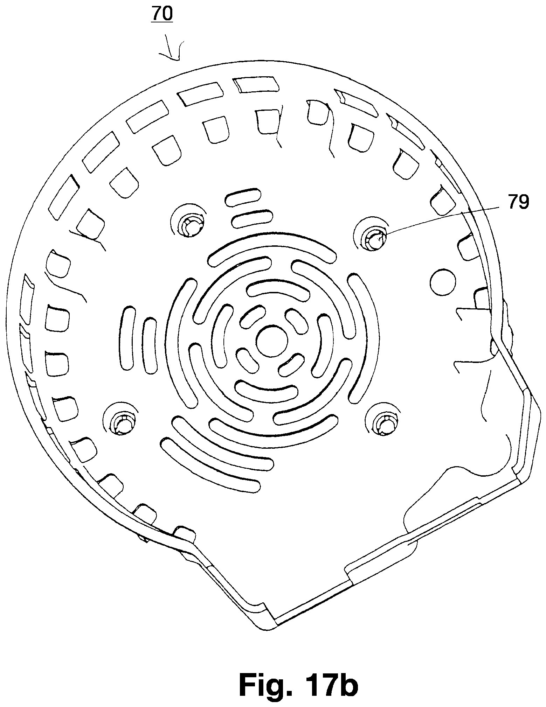

**Selon un troisième mode de réalisation préférentiel non limitatif**, illustré à la Fig. 17a et 17b, le capot est un capot simple qui comporte uniquement des clips de fixation 791 du capot s'enfichant sur des goujons 226g de la plaque de signal 22 fixant l'ensemble. Il ne comporte plus aucune trace, ni connecteur. Il n'y a que de la matière plastique.

Après avoir vu l'ensemble des éléments qui coopèrent avec les modules électroniques, nous décrivons ci-après leur assemblage.

Comme on le verra en détail ci-après, les modules électroniques sont fixés sur le palier arrière de la machine de plusieurs manières :
- Soit sur le palier directement (palier dissipateur à ailettes ou eau intégrant ou non des caloducs),
- soit sur un dissipateur non intégré (à ailettes ou eau intégrant ou non des caloducs).

### 1) 1^{er} mode d'assemblage ou agencement

Selon un premier mode d'assemblage des modules, un module électronique s'interface avec les éléments suivants :
- un palier dissipateur 60,
- une pièce d'interconnexion de signal 22 selon les premier ou deuxième modes de réalisation
- une pièce d'interconnexion de puissance 21 selon les premier ou deuxième modes de réalisation
- un capot 70 selon les premier ou deuxième modes de réalisation.

Ainsi, le 1^{er} mode d'assemblage de l'ensemble des pièces décrites ci-dessus s'effectue de la manière suivante.

**Dans une première étape 1)**, on monte le ou les modules électroniques sur le palier dissipateur 60.

Le positionnement de chaque module sur le palier dissipateur 60 est facilité par les deux pions de positionnement 109a, 109b qui vont se retrouver en regard de chaque orifice 609a, 609b du palier 60 correspondant.

La fixation des modules sur le palier dissipateur 60 se fait d'une part au moyen d'une colle, par exemple à billes de verre, et d'autre part de façon mécanique de deux manières différentes.

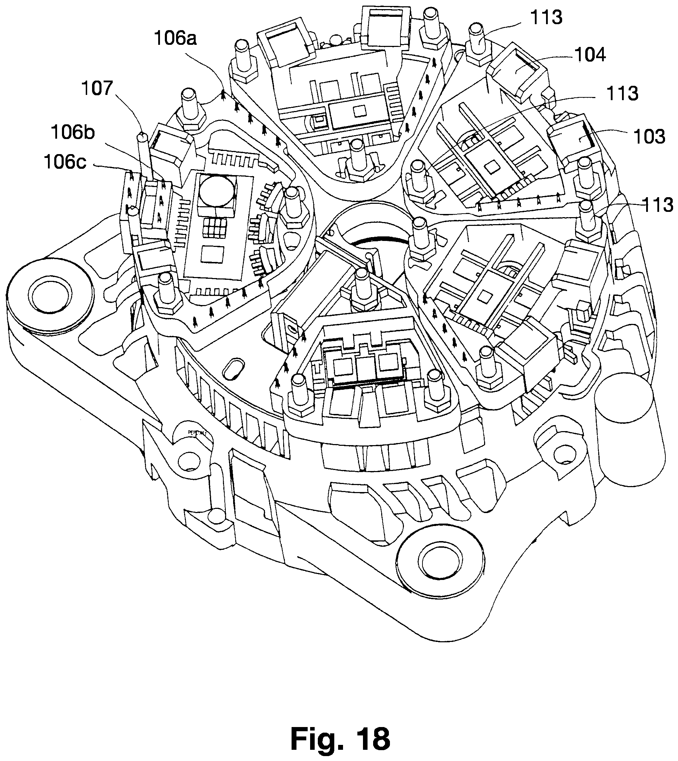

**Selon une première manière non limitative,** illustrée sur la Fig. 18, chacun des modules est fixé par trois goujons 113. Les trois goujons vont s'insérer dans les orifices correspondants 608 dudit palier. La Fig. 18 représente l'assemblage de cinq modules, trois modules de puissance 20, un module de contrôle 30 et un module d'excitation 40.

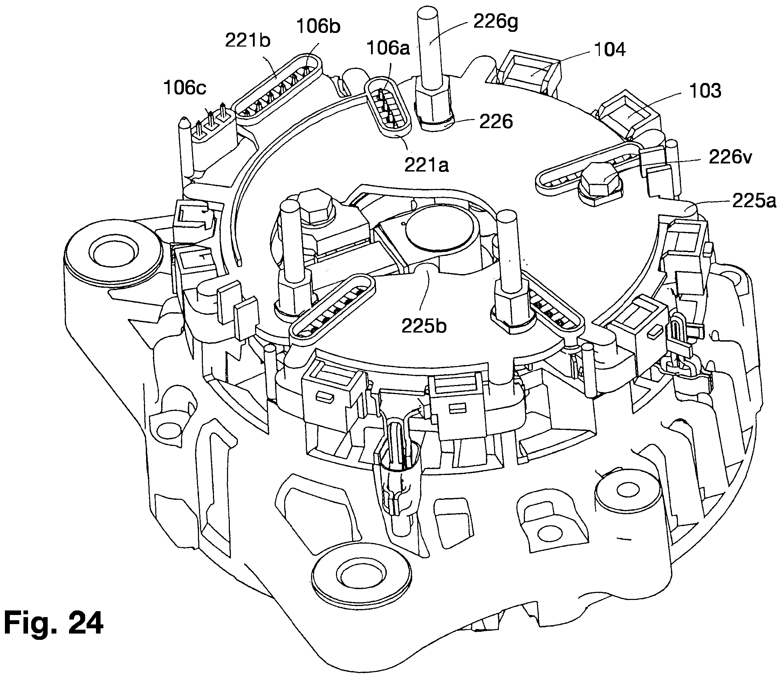

**Selon une deuxième manière préférentielle non limitative**, illustrée à la Fig. 24, la fixation s'effectue au moyen :
- de trois goujons 226g qui sont mis après l'installation de la plaque d'interconnexion de signal 22, et qui s'insèrent dans les orifices 681, 682, 683 correspondants du palier dissipateur 60, et
- d'une vis 226v qui s'insère dans l'orifice associé 684 du palier.

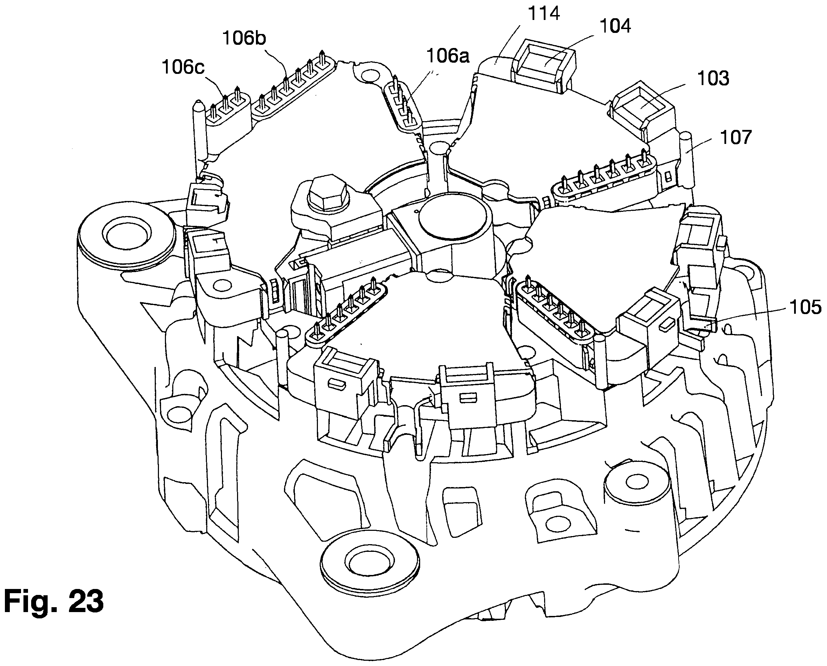

La Fig. 23 représente l'assemblage de quatre modules, trois modules de puissance 10, un module de contrôle/excitation.

Pour les deux manières, l'ensemble des modules sont agencés préférentiellement dans un même plan perpendiculaire à l'axe de rotation du rotor de la machine électrique, tout comme les traces de puissance et les connexions de signal, afin de faciliter leur assemblage.

Toutefois, en variante de ce qui est présenté sur les Fig. précédentes, les modules peuvent être disposés sur des plans différents.

**Dans une deuxième étape 2),** on monte la plaque d'interconnexion de signal 22 sur les modules électroniques. De ce fait, ladite plaque est au plus proche des modules pour réduire la longueur des connexions de signal le plus possible et pour éviter des problèmes d'enfichage. De cette manière, les connexions de signal 106 des modules sont courtes ; on maîtrise ainsi plus leur déformation (elles sont moins déformables), lesdites connexions étant de préférence souples.

La plaque d'interconnexion de signal 22 est fixée à l'ensemble module-palier selon deux manières différentes correspondant aux deux manières de fixer les modules sur la palier comme décrit précédemment.

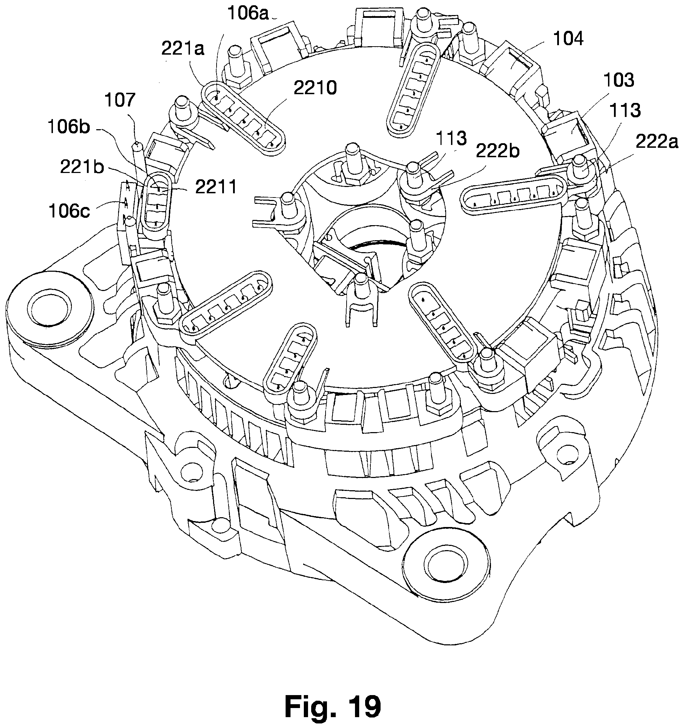

**Selon une première manière non limitative**, illustrée à la Fig. 19, la plaque 22 est positionnée au moyen des pions de positionnement 224 qui sont positionnés en regard des orifices de positionnement 610a et 610b du palier. Ainsi, grâce à ce positionnement :
- les évidements de connexion 221a se placent en regard des éléments de connexion de signal 106a des modules,
- les évidements de connexion 221b se placent en regard des éléments de connexion de signal 106b des modules, et
- les pattes de fixation 222 se placent en regard des goujons 113 des modules 10.

Ensuite, après pression, les connexions de signal 106a s'insèrent dans les orifices d'interconnexion 2210 des traces métalliques de signal TS, les éléments de connexion 106b s'insèrent dans les orifices d'interconnexion 2211 des traces métalliques de signal TS, et les pattes 222 se fixent sur les goujons 113.

**Selon une deuxième manière préférentielle non limitative**, illustrée à la Fig. 24, la plaque 22 est positionnée sur les modules au moyen des pions de positionnement 224 qui sont positionnés en regard des orifices de positionnement 610a et 610b du palier. Ainsi, grâce à ce positionnement :
- les évidements de connexion 221a se placent en regard des éléments de connexion de signal 106a des modules,
- les évidements de connexion 221b se placent en regard des éléments de connexion de signal 106b des modules,
- les béquilles 225a et 225b se placent en regard des zones d'appuis 114 des modules, et
- les inserts 226 se placent en regard des orifices correspondant 681 à 684 du palier.

Ensuite, après pression, les éléments de connexion 106 s'insèrent dans lesdits évidements 221 correspondant, les béquilles 225 prennent appui sur les zones d'appui 114 des modules.

On fixe alors les goujons 226g qui s'insèrent dans les orifices 224 de ladite plaque 22 et 681, 682, 683 du palier dissipateur 60. Les goujons appuient sur ladite plaque et par conséquent sur l'ensemble plaque-modules-palier de manière à permettre une meilleure tenue mécanique. De la même manière, on visse la vis 226v dans les orifices correspondant respectifs 226 et 684 de la plaque 22 et du palier 60.

Ainsi, la plaque d'interconnexion de signal 22 est réalisée de manière à exercer une pression sur les modules de puissance 20 et les autres modules 30, 40 afin de garantir leur maintien tout au long de la vie de la machine électrique tournante.

Dans un mode de réalisation non limitatif, le matériau de ladite plaque est du plastique PPS (phénylène polysulphide) chargé en fibres de verre.

Ainsi, selon ces deux manières, la plaque de signal est déformée pour exercer une pression sur les modules, la déformation étant de préférence d'environ 0.3mm. De cette manière, on évite que les modules se décollent et on évite les sollicitations sur les soudures des languettes.

**Dans une troisième étape 3),** on monte la plaque d'interconnexion de puissance 21 sur l'ensemble palier-modules-plaque de signal. La plaque d'interconnexion de puissance 21 est fixée par-dessus de la plaque d'interconnexion de signal 22.

La plaque de puissance 21 est fixée de deux manières différentes.

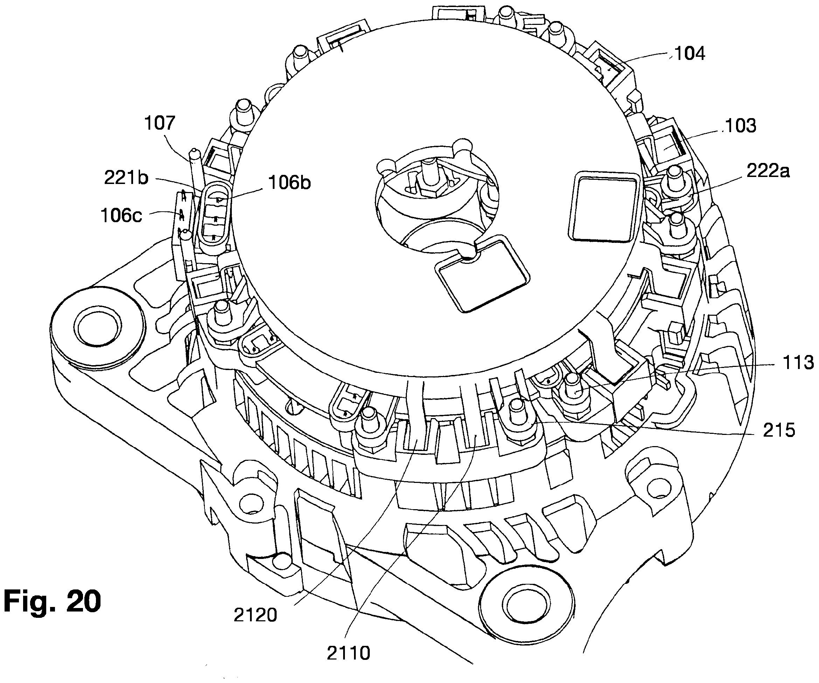

**Selon une première manière non limitative,** illustrée à la Fig. 20, la plaque de puissance 21 est placée sur la plaque de signal 22 de sorte que :
- les pattes de fixation 215 se placent en regard des goujons 113 des modules 22, lesdits goujons permettant de positionner ladite plaque 21,
- les terminaux de puissance 2120, 2110 se placent en regard des traces correspondantes du module 103, 104,

Dans le cas d'un porte balais, il est positionné de sorte qu'il s'insère dans le dégagement 605, et le protecteur cage balais dans le dégagement 603 du palier.

Ensuite, après pression, les pattes de fixations 215 se fixent sur les goujons 113, les terminaux de puissance 2120, 2110 appuient respectivement sur les extrémités des traces 103, 104 des modules.

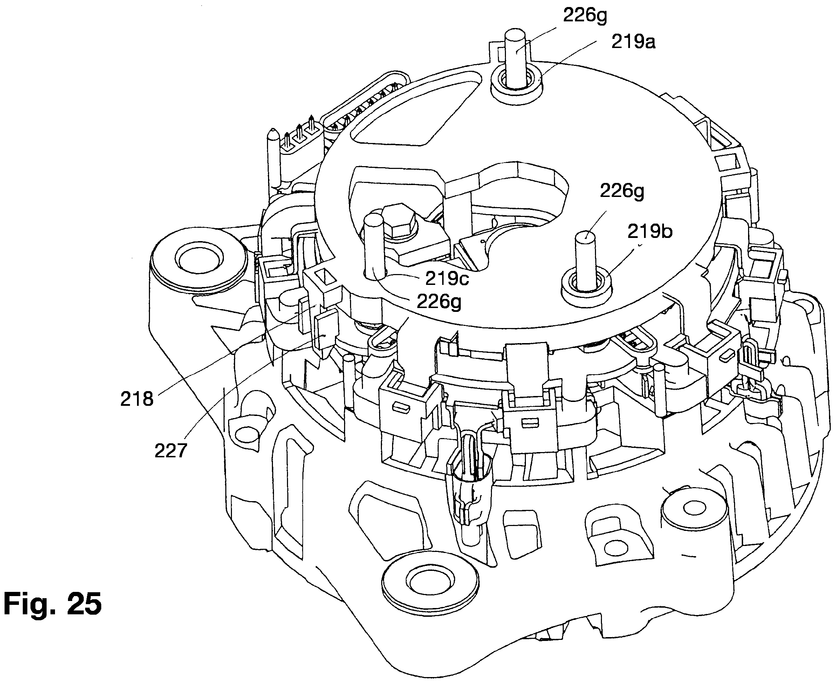

**Selon une deuxième manière préférentielle non limitative,** illustrée à la Fig. 25, la plaque de puissance 21 est placée sur la plaque de signal 22 de sorte que :
- les inserts 219 se placent en regard des goujons 226g, lesdits orifices et goujons servant de détrompeur,
- la patte 218 se place en regard du clip de maintien 227 de la plaque de signal 22.
   Ensuite, après appui, les orifices 219 s'insèrent sur les goujons 226g et la patte 218 vient s'encliqueter dans le clip 227, et
- l'orifice 219c se place en regard d'un troisième goujon 226g.

**Dans une dernière étape),** on monte le capot sur l'ensemble. De cette manière, le capot 70 forme une coiffe du palier arrière de la machine.

La fixation du capot 70 se fait de deux manières différentes.

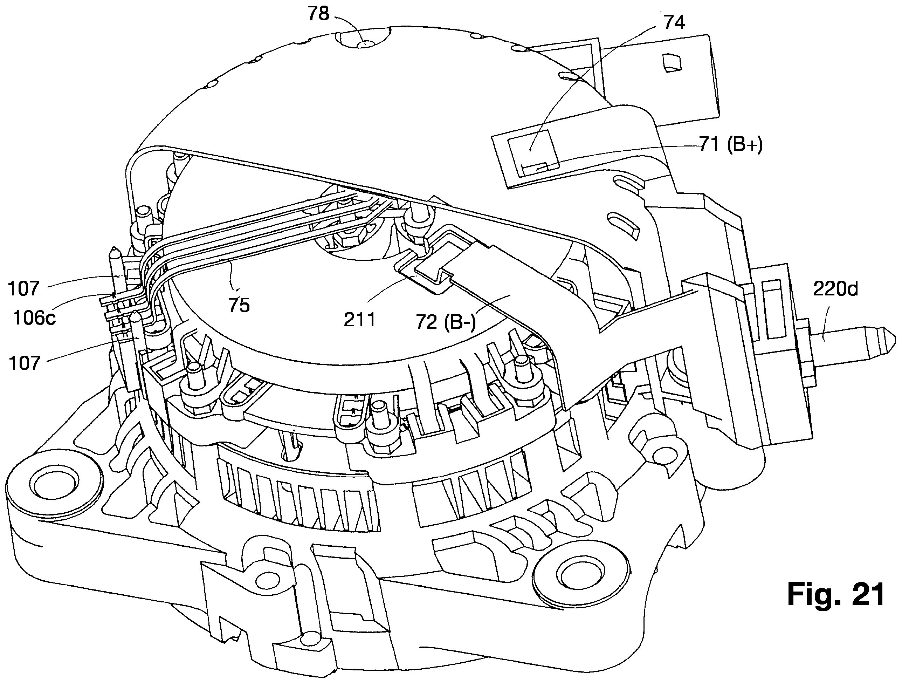

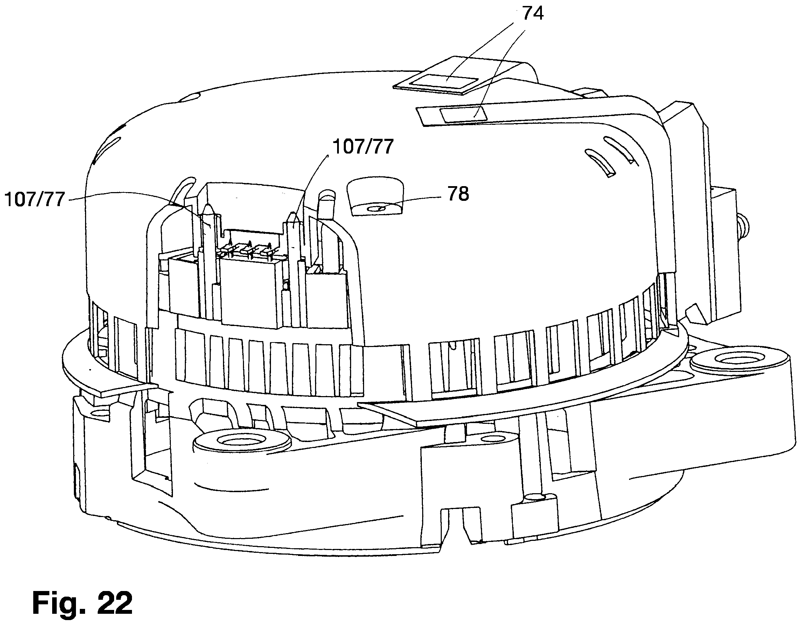

**Selon une première manière non limitative,** illustrée aux Fig. 21 et 22, le capot 70 est placé sur la plaque de puissance 21 de sorte que les rainures 77 du capot se trouvent en regard des guides 107 du module de contrôle 30. Ces guides et ces rainures servent de détrompeur.

Ensuite, après pression, lesdites rainures s'insèrent dans lesdits guides de sorte que :
- le contact est établit entre les traces de signal 75 du capot 70 et les languettes 106c du module de contrôle 30, et
- le contact est établit entre les traces de puissances 71 (B+), 72 (B-) du capot et respectivement les traces de puissance 212, 211 de la plaque de puissance 21.

Enfin, après installation du capot, on réalise la connexion électrique entre les traces 71, 72 du capot et les traces 212, 211 par soudure laser via les ouvertures 74.

On fixe le capot par trois vis ou écrous 78.

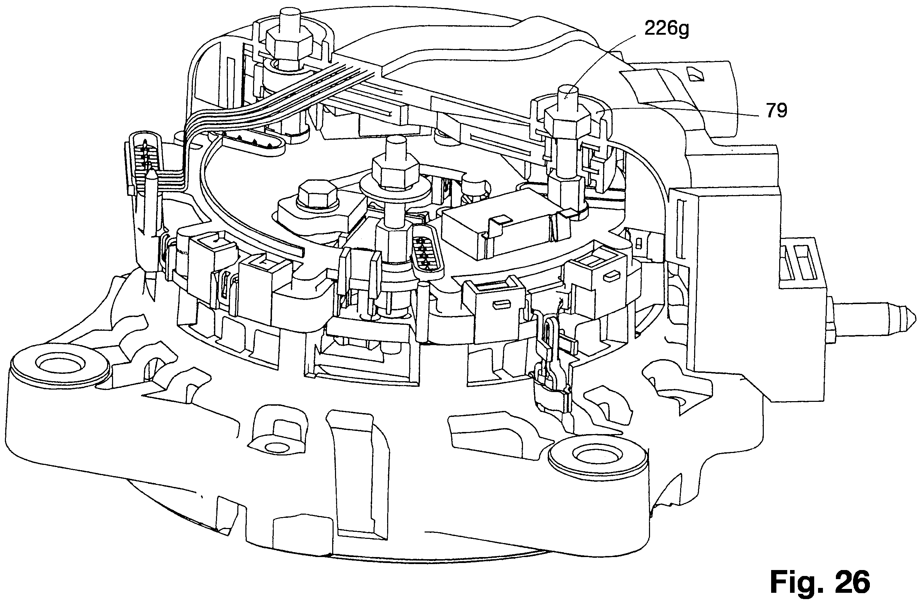

**Selon une deuxième manière préférentielle non limitative**, illustrée à la Fig. 26, le capot 70 est placée sur la plaque de puissance 21 de la même manière que la première manière en vue d'établir les contacts électriques. De plus, les ouvertures 79 se placent au dessus des trois goujons 226g qui fixent l'ensemble électronique.

Ensuite, après pression, le capot 70 se fixe grâce auxdits goujons sur l'ensemble électronique (palier-modules-plaques d'interconnexion).

Dans ce cas, le capot 70 appuie sur tous les éléments de l'agencement et assure ainsi un appui suffisamment fort pour, à la fois, immobiliser la plaque de puissance 21 sur le palier dissipateur et assurer les contacts électriques nécessaires.

Ainsi, comme on peut le voir, selon ce premier mode d'assemblage, les modules électroniques 10, la pièce d'interconnexion de signal 22, la pièce d'interconnexion de puissance 21 et le dissipateur occupent respectivement un premier, deuxième, troisième et quatrième plans tous parallèles entre eux, et les plans se superposent dans l'ordre suivant en partant du plan le plus près du palier arrière de la machine :
- quatrième plan,
- premier plan,
- deuxième plan, et
- troisième plan.

Ainsi, la pièce d'interconnexion de puissance 21 est indépendante des modules électroniques et n'est connectée auxdits modules notamment que par ses terminaux électriques de puissance.

Il en est de même pour la pièce d'interconnexion de signal 22 qui n'est connectée auxdits modules notamment que par ses connexions de signal 106.

### 2) 2^{ème} mode d'assemblage ou agencement

Selon un deuxième mode d'assemblage des modules, ou agencement, un module électronique, s'interface avec les éléments suivants :
- un dissipateur 80,
- une pièce d'interconnexion de signal 22 selon le troisième mode de réalisation
- une pièce d'interconnexion de puissance 21 selon le troisième mode de réalisation
- un capot 70, selon le troisième mode de réalisation

Ainsi, le 2^{ème} mode d'assemblage de l'ensemble des pièces décrites ci-dessus s'effectue de la manière suivante.

On notera que dans l'exemple pris pour ce mode d'assemblage, il existe quatre modules qui sont fixés sur le dissipateur 80. Trois modules de puissance 20 et un module de contrôle/excitation 30.

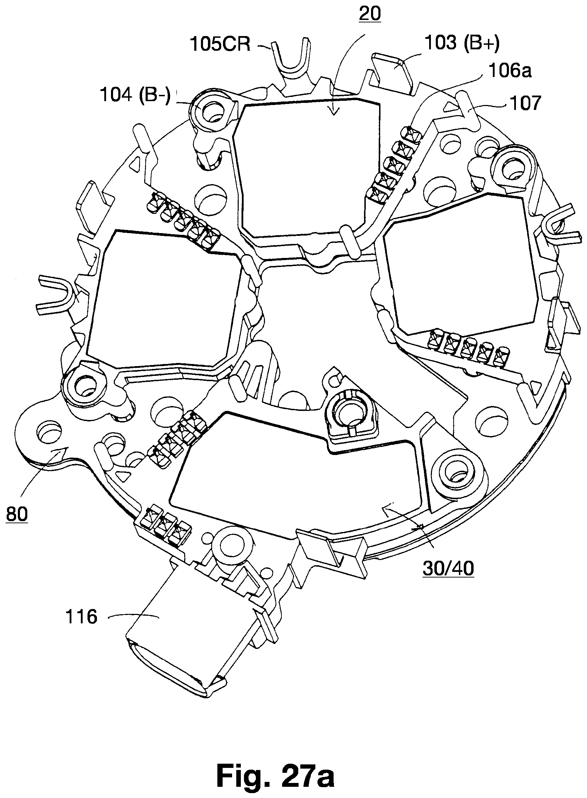

**Dans une première étape 1),** illustrée à la Fig. 27a, on positionne les modules sur la face supérieure du dissipateur 80 de manière à les fixer.

Le positionnement s'effectue au moyen des pions de positionnement 109a et 109b qui sont placés en regard des orifices 810 du dissipateur 80, et lors du positionnement, l'insert 120 de chaque module vient se positionner en regard de chaque orifice associé 804 du dissipateur 80.

Par la suite, la fixation se fait via :
- des vis 1150 qui s'insèrent dans les orifices de fixation 115 des modules et les orifices 804 correspondant du dissipateur 80. Ces vis de fixation permettent également de relier les modules à la masse via l'insert 120, et
- le connecteur 116 du module de contrôle/excitation 30 qui se visse dans l'orifice associé 807 du dissipateur, au moyen d'une vis via.
   Lors de l'assemblage,
- les moyens de protections électriques 126 des modules s'insèrent dans les évidements 809 du dissipateur prévus à cet effet.

Par ailleurs, les modules sont également collés au dissipateur 80 au moyen d'une colle, telle qu'une colle à billes de verre.

On notera que préalablement à la fixation du module de contrôle/excitation 30 sur le dissipateur 80, on a fixé le porte balais 50 sur ledit module via la vis 117a prévue à cet effet. Dans une autre variante, on peut le fixer après l'installation dudit module 30 sur le dissipateur 80.

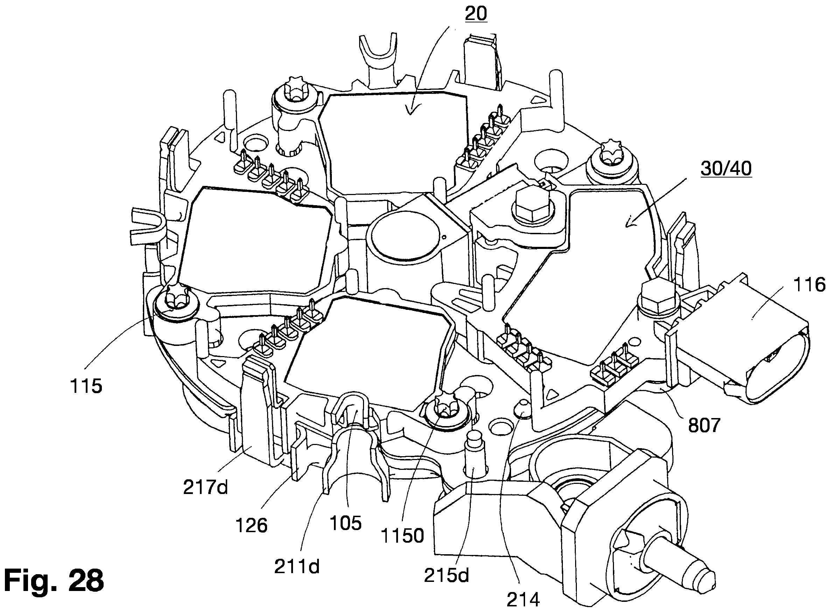

**Dans une deuxième étape 2),** illustrée à la Fig. 28, on positionne la plaque de puissance 21 sur la face inférieure du dissipateur de manière à fixer ladite plaque 21 sur ledit dissipateur 80.

Le positionnement s'effectue au moyen de :
- des moyens de positionnement 214d de ladite plaque 21 qui viennent en regard des orifices de positionnement associés 808 du dissipateur, et
- de la borne de fixation 215d qui vient en regard de l'orifice de connexion électrique 805.

La fixation de ladite plaque 21 sur le dissipateur 80 s'effectue au moyen :
- des deux moyens de positionnement 214 qui se placent dans les orifices correspondants 808 du dissipateur,
- de la borne de fixation 215d qui vient s'enficher dans l'orifice de connexion électrique 805, et
- des quatre béquilles de contrainte 213d qui se placent en vis-à-vis des appuis 814 correspondants du dissipateur.
   Lors de l'assemblage,
- des moyens de protection de phase 211d s'intègrent dans les évidements 812 prévus à cet effet du dissipateur.

Ainsi, comme on peut le voir sur la Fig. 28 :
- les moyens 211d vont protéger les languettes de phase du stator,
- les languettes axiales des terminaux électriques 217d sont alors en regard des traces positives 103 correspondantes (B+) de chaque module électronique 10 ce qui va permettre d'établir une liaison électrique entre lesdites traces 103 et la trace positive 221d (B+) de la plaque de puissance 21, et
- l'insert électrique 216d intégré dans la borne 215d permet la mise à la masse du dissipateur 80.

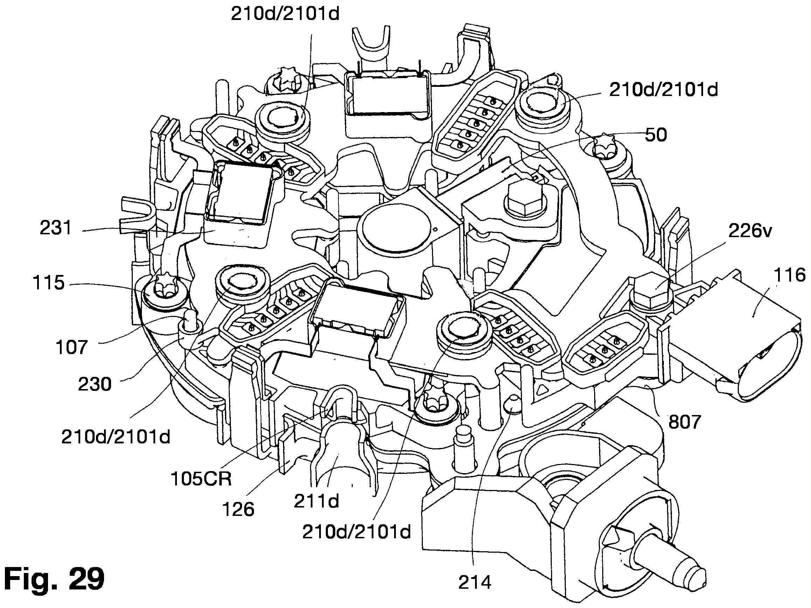

**Dans une troisième étape 3),** illustrée à la Fig. 29, on positionne la plaque d'interconnexion de signal 22 sur lesdits modules électroniques 10 de manière à la fixer.

On notera que la plaque de signal 22 est pré-positionnée (pré-guidée) grâce à deux pions de protection 107 de deux modules électroniques 10, lesdits pions étant les plus éloignés l'un de l'autre pour bien pré-guider.

Le positionnement s'effectue au moyen de :
- des deux protubérances évidées 230 servant de pré-guidage et qui se pré-positionnent sur deux pions de positionnement ou guides 107 appartenant à des modules électroniques.

Puis, par la suite, on peut positionner la plaque de signal 22 au moyen les pions de positionnement 224 dans les orifices correspondant 811 du dissipateur 80.

Lors de l'assemblage, on a :
- les évidements de connexion 221a qui se placent en regard des éléments de connexion de signal 106a des modules,
- les évidements de connexion 221b qui se placent en regard des éléments de connexion de signal 106b des modules,
- les béquilles 225a et 225b qui se placent en regard des zones d'appuis 119, 114 respectivement des modules, et
- les inserts 226 qui se placent en regard des orifices correspondant 806 du dissipateur.

La fixation s'effectue au moyen de :
- rivets creux isolés 2101d associés aux inserts 210d de la plaque de puissance. Ces rivets 2101d à l'intérieur des inserts, permettent d'une part, un assemblage de la plaque de signal, et d'autre part un isolement de la masse du dissipateur par rapport à la masse du palier, et enfin la création d'un sous ensemble électronique (les deux plaques, le dissipateur et les modules électroniques) pré-assemblé de sorte que lors de l'assemblage sur le palier, par le biais de vis ou goujons, après soudures des connexions de signal 106 avec la plaque de signal 22, il n'y a pas de contraintes supplémentaires qui risquent de solliciter mécaniquement lesdites soudures.

Ensuite, après pression, les languettes de signal 106 s'insèrent dans lesdits orifices d'interconnexion 2210, 2211 correspondants, les béquilles 225 prennent appui sur les zones d'appui 119, 114 des modules.

On notera également les logements 231 de la plaque de signal comprennent dans l'exemple illustré à la Fig. 29 une capacité associée à chacun des modules de puissance 20, qui est reliée, d'une part à la trace positive 103 (B+) du module associé, et d'autre part, à la trace négative 104 (B-) dudit module associé.

En outre, préférentiellement, on peut effectuer une soudure étain ou laser, ou encore déposer un résine+polymérisation dans les évidements de connexion 221a et 221b des languettes de signal 106 pour notamment les protéger du brouillard salin.

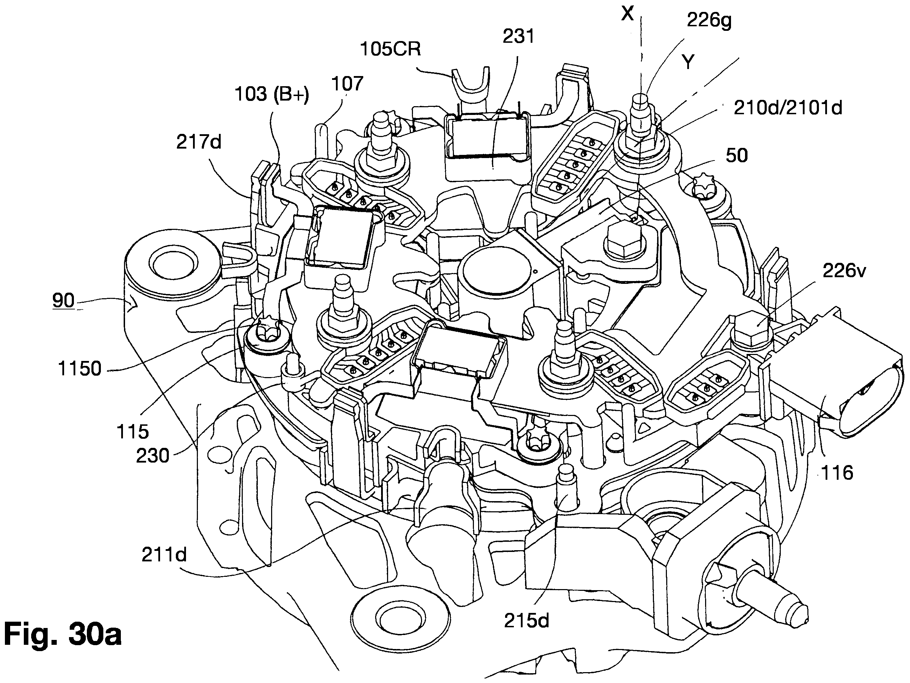

**Dans une quatrième étape 4),** illustrée à la Fig. 30a, on positionne l'ensemble de l'électronique ainsi obtenue sur le palier arrière 90 de la machine.

La fixation s'effectue au moyen :
- de quatre goujons 226g ou vis dans le palier arrière 90 via les inserts 226 de la plaque de signal 22, 210d de la plaque de puissance 21 et 806 du dissipateur 80 correspondants. Les goujons appuient sur ladite plaque et par conséquent sur l'ensemble plaque-dissipateur-palier de manière à créer un assemblage électronique sur le palier. De la même manière, on visse la vis 226v dans les orifices correspondants respectifs 226 et 807 de la plaque 22 et du dissipateur 80.

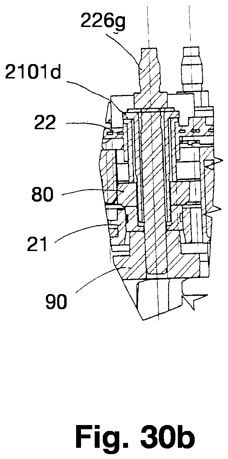

La Fig. 30b est une vue en coupe selon le plan X-Y représenté à la Fig. 30a, montrant tout un assemblage de pièces principales citées ci-dessus. Elle montre notamment :
- le palier 90,
- la plaque d'interconnexion de signal 21,
- le dissipateur 80,
- la plaque d'interconnexion de signal 22,
- un rivet 2101d, et
- un goujon de fixation 226g.

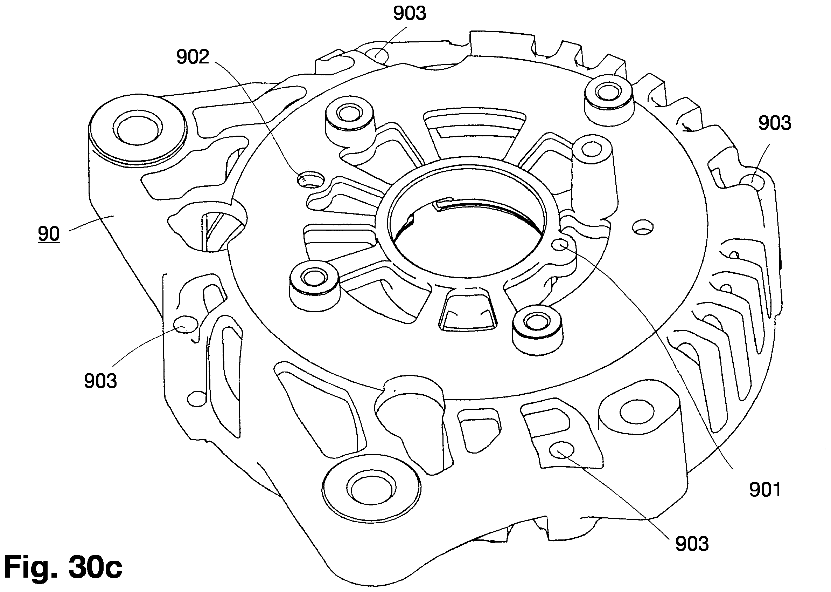

On notera que préalablement à l'assemblage électronique, on a fixé le palier arrière 90 de la machine sur le palier avant (non représenté) de ladite machine via quatre tirants dans des orifices 903, les orifices étant illustrés sur la Fig. 30c du palier 90. Les tirants sont ainsi vissés avant l'assemblage électronique ce qui permet de positionner au préalable les phases du stator et donc de faciliter l'assemblage du sous-ensemble électronique avec lesdites phases.

Le palier arrière comporte notamment :
- un orifice de positionnement 901 configuré pour recevoir le pion de positionnement 1151 du module de contrôle/excitation 30, ce qui permet un positionnement précis des capteurs de position par rapport au palier, et
- un orifice de référencement 902 dans lequel le pion 212d de la plaque de puissance 21 est inséré.

On soude également les crochets de phase 105cr aux phases du stator (fils standard ou en cosse).

**Enfin, dans une cinquième étape 5),** on met en place le capot plastique 70 au moyen de clips de fixation qui viennent s'encliqueter sur les goujons.

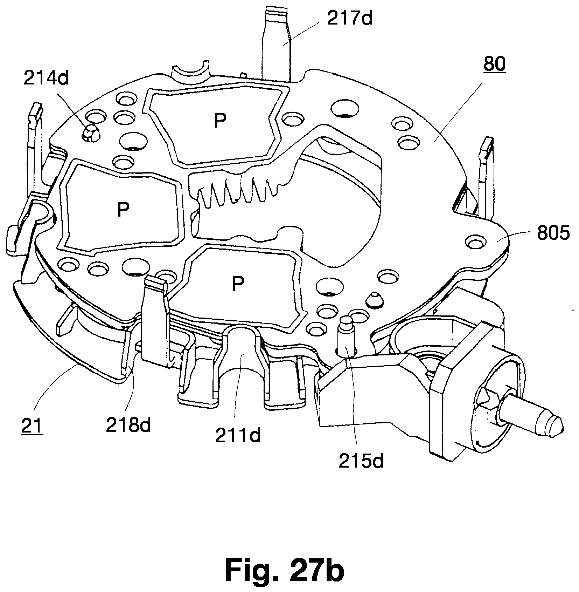

On notera que les étapes définies ci-dessus peuvent être effectuées dans un ordre différent. Par exemple, la deuxième étape peut bien entendu être effectuée avant la première étape (la Fig. 27b illustre ce cas) ou après la troisième étape.

Ainsi, le deuxième mode d'assemblage présente les avantages suivants:
- Premièrement, l'assemblage de toute la partie électronique (modules, plaques de puissance et de signal) se fait en dehors du palier arrière de sorte que l'on peut tester l'électronique avant l'assemblage sur la machine ; on intègre ainsi que de l'électronique qui fonctionne dans ladite machine ce qui permet de gagner du temps en terme de process, et d'avoir deux process indépendants et donc de ne pas modifier le procédé « process » d'assemblage machine standard qui existent déjà ;

- Deuxièmement, l'assemblage de la partie électronique peut se faire après l'assemblage du palier arrière de la machine sur le palier avant, plus particulièrement après la mise en place des tirants de fixation des paliers qui seront alors recouverts par l'électronique ;
- Troisièmement, les performances au niveau du refroidissement thermique sont améliorées du fait du flux d'air axial additionné au flux d'air radial. On a une diminution des pertes de charge avec une entrée d'air axiale ;
- Quatrièmement, le capot n'est plus qu'un simple capot plastique. Il n'y a pas de traces surmoulées dans le capot, les traces de puissance et les traces de signal étant intégrées respectivement dans la plaque de puissance et dans le module de contrôle/excitation, ce qui permet de limiter le nombre de soudures d'interconnexion à faire ;
- Cinquièmement, le plan de masse est réalisé par le dissipateur. Il y a donc une diminution de la résistance et de l'inductance du circuit interne de puissance entre le connecteur de puissance biphasé client et le module de puissance du fait de la proximité de la trace de polarité positive (B+) de la plaque de puissance 21 avec la masse dissipateur.
- Sixièmement, le plan de masse est réalisé par le dissipateur, de sorte que l'on a un gain en encombrement axial. On utilise ainsi une pièce existante pour véhiculer du courant.

Ainsi, selon ce deuxième mode d'assemblage, les modules électroniques 10, la pièce d'interconnexion de signal 22, la pièce d'interconnexion de puissance 21 et le dissipateur occupent respectivement un premier, deuxième, troisième et quatrième plans tous parallèles entre eux, et les plans se superposent dans l'ordre suivant, en partant du plan le plus près du palier arrière :
- troisième plan,
- quatrième plan,
- premier plan, et
- deuxième plan.

Ainsi, la pièce d'interconnexion de puissance 21 est indépendante des modules électroniques et n'est connectée auxdits modules notamment que par ses terminaux électriques de puissance.

Il en est de même pour la pièce d'interconnexion de signal 22 qui n'est connectée auxdits modules notamment que par ses connexions de signal 106.

Ainsi, l'ensemble des quatre pièces forme un sous-ensemble électronique indépendant d'un palier de la machine.

On notera que les deux modes d'assemblage présentent l'avantage d'utiliser la surface maximale disponible sur l'arrière de la machine pour les modules grâce à l'empilement des différents éléments pour les interconnexions de puissance et signaux contrairement à une solution dans laquelle les traces d'interconnexion de puissance et de signal occuperaient de la surface sur l'arrière de la machine au détriment des modules.

On notera que la plaque d'interconnexion de signal 22 selon les différents modes de réalisation décrits précédemment peut être utilisée lorsqu'il n'y a pas de plaque de puissance 21. Par exemple avec des modules réalisant eux-mêmes leur interconnexion de puissance.

Quant à la plaque d'interconnexion de puissance 21 selon les différents modes de réalisation décrits précédemment, elle peut également être utilisée sans la plaque de signal 22. Par exemple, avec une carte électronique PCB effectuant l'interconnexion de signal.

L'assemblage selon tous les modes de réalisation présentés ci-dessus présente les avantages supplémentaires suivants :
- il évite d'empiler toutes les traces l'une sur l'autre, un empilement n'étant pas propice à un bon maintien en position des traces,
- il comporte des moyens de fixation au dissipateur ou sur la palier dissipateur qui ne sont pas concentrés sur la périphérie dudit dissipateur ou palier, de sorte qu'il existe une répartition d'efforts de manière à bien supporter les vibrations mécaniques,
- il permet aux différents éléments (plaques d'interconnexion et modules) d'être dans des plans différents et perpendiculaires à l'axe de rotation de la machine, de sorte qu'il créé plus de place pour les traces de puissance ce qui entraîne une diminution de la résistivité desdites traces. Ainsi, cet assemblage permet de véhiculer une plus grande puissance,
- il permet d'utiliser de façon optimum la place disponible pour les modules électroniques sur le palier arrière de la machine, les différents éléments (plaques d'interconnexion et modules) étant sur des plans différents et perpendiculaires à l'axe de rotation de la machine.

## Revendications

1. Machine électrique tournante comprenant au moins un module électronique (10) tel qu'un module de puissance (20) ou un module de contrôle (30) ou un module d'excitation (40), un dissipateur (80) comprenant une plaque de base (801) et une pièce d'interconnexion de puissance (21), ladite pièce (21) comprenant au moins une trace de puissance (211, 212) dotée de terminaux électriques de puissance (2120, 2110, 217d) chacun destiné à coopérer avec une trace de puissance (103, 104) dudit au moins un module électronique (10) de manière à distribuer une puissance électrique audit module électronique (10), la pièce d'interconnexion de puissance (21) comprend une plaque de base (213) en matière électriquement isolante qui surmoule au moins partiellement ladite trace de puissance (211, 212), ledit module électronique (10) s'intègre sur ladite machine de manière indépendante de ladite pièce d'interconnexion de puissance (21), ladite pièce d'interconnexion de puissance (21) étant empilée dans un plan différent de celui utilisé par le module électronique (10), lesdits plans étant perpendiculaires à l'axe de rotation (AX) de la machine,
**caractérisé en ce que** :
- ledit module électronique (10) comporte un ensemble de composants électroniques (102) qui sont disposés dans un boîtier (101) et ladite au moins une trace de puissance (103, 104) forme un élément de connexion accessible de l'extérieur dudit module pour son fonctionnement
- **en ce que** les terminaux électriques de puissance (2120, 2110, 217d) de la trace de puissance (211, 212) s'étendent vers la périphérie externe de ladite pièce (21),
- et **en ce que** la plaque de base (801) du dissipateur (80) est configurée pour pouvoir être assemblée en sandwich axialement entre la pièce d'interconnexion de puissance (21), qui est située vers l'intérieur de la machine, et le module électronique (10), qui est situé vers l'extérieur de la machine, de sorte que la pièce d'interconnexion de puissance (21) soit configurée pour être placée sur la face inférieure du dissipateur.

2. Machine électrique tournante selon la revendication précédente, **caractérisée en ce que** lesdits terminaux de puissance comportent des extrémités libres recourbées.

3. Machine électrique tournante selon l'une des revendications précédentes, **caractérisée en ce que** la pièce d'interconnexion de puissance (21) comprend au moins une trace d'interconnexion de puissance positive (212, +BATT ; 221d, B+) et au moins une trace d'interconnexion négative (211, - BATT ; 222d, B-).

4. Machine électrique tournante selon l'une des revendications précédentes, **caractérisée en ce que** la plaque de base (213) comprend au moins un évidement (214a, 214b) pour une connexion électrique d'une trace d'interconnexion de puissance (211, 212) avec un capot.

5. Machine électrique tournante selon l'une des revendications précédentes, **caractérisée en ce que** la pièce d'interconnexion de puissance (21) comprend en outre des dispositifs de fixation (215) pour fixation sur un module électronique (10), lesdits dispositifs s'étendant radialement sur la périphérie extérieure de ladite pièce (21).

6. Machine électrique tournante selon l'une quelconque des revendications précédentes, **caractérisée en ce que** la machine comporte une pièce d'interconnexion de signal (22), la pièce d'interconnexion de puissance (21) comprend en outre des dispositifs de pré-assemblage (218) sur la pièce d'interconnexion de signal (22), ladite pièce d'interconnexion de signal permettant de véhiculer des signaux de contrôle entre des modules électroniques.

7. Machine électrique tournante selon l'une quelconque des revendications précédentes, **caractérisée en ce que** la pièce d'interconnexion de puissance (21) comprend en outre des inserts (219a, 219b) pour recevoir des moyens de fixation (226g) pour fixation sur la machine.

8. Machine électrique tournante selon l'une quelconque des revendications précédentes, **caractérisée en ce que** la machine comprend un dissipateur et **en ce que** la pièce d'interconnexion de puissance (21) comprend en outre des dispositifs d'appui (2113) pour appuyer ladite pièce (21) sur un dissipateur lors d'un assemblage.

9. Machine électrique tournante selon l'une des revendications précédentes, **caractérisée en ce que** la machine comprend un stator comprenant des phases et **en ce que** la pièce d'interconnexion de puissance (21) comprend en outre des moyens de protection (211d) de phases de stator.

10. Machine électrique tournante selon l'une des revendications précédentes, **caractérisée en ce que** la machine électrique tournante comporte un palier et **en ce que** la pièce d'interconnexion de puissance (21) comprend en outre des moyens de positionnement (212d) sur le palier, lesdits moyens s'étendant sur une face inférieure de ladite pièce (21), et de préférence d'autres dispositifs de positionnement (214d) de ladite pièce (21) sur un dissipateur de la machine électrique tournante.

11. Machine électrique tournante selon l'une des revendications précédentes, **caractérisée en ce que** la pièce d'interconnexion de puissance (21) comprend en outre au moins une béquille de contrainte (213d) pour une déformation axiale de ladite pièce (21), ladite béquille de contrainte (213d) ayant de préférence une hauteur plus grande que l'insert (210d).

12. Machine électrique tournante selon l'une des revendications précédentes, **caractérisée en ce que** la pièce d'interconnexion de puissance (21) comprend en outre un connecteur de puissance (219d) dans lequel sont insérées des traces de puissance positives et négatives (222d, 221d) de façon apparentes.

13. Machine électrique tournante selon l'une des revendications précédentes, **caractérisée en ce que** la machine comprend un palier et **en ce que** la pièce d'interconnexion de puissance (21) comporte en outre une collerette (213z) destinée à recouvrir des ouvertures de sorties d'air du palier de manière à guider l'air en sortie et atténuer un rebouclage d'air.

## Patentansprüche

1. Rotierende elektrische Maschine, mindestens umfassend ein elektronisches Modul (10) wie etwa ein Leistungsmodul (20) oder ein Steuermodul (30) oder ein Erregungsmodul (40), einen Kühlkörper (80), der eine Grundplatte (801) und ein Leistungsverbindungstück (21) umfasst, wobei das Stück (21) mit mindestens einer Leistungsleitung (211, 212) mit elektrischen Leistungsanschlüssen (2120, 2110, 217d) versehen ist, wobei jeder dazu bestimmt ist, mit einer Leistungsleitung (103, 104) des mindestens einen elektronischen Moduls (10) so zusammenzuarbeiten, dass eine elektrische Leistung an das elektronische Modul (10) verteilt wird, wobei das Leistungsverbindungsstück (21) eine Grundplatte (213) aus einem elektrisch isolierenden Material umfasst, das die Leistungsleitung (211, 212) mindestens teilweise überformt, wobei sich das elektronische Modul (10) unabhängig vom Leistungsverbindungsstück (21) in die Maschine integriert, wobei das Leistungsverbindungsstück (21) auf einer anderen Ebene als der vom elektronischen Modul (10) verwendeten eingeschichtet ist, wobei die Ebenen rechtwinklig zur Rotationsachse (AX) der Maschine verlaufen,
**dadurch gekennzeichnet:**
- **dass** das elektronische Modul (10) einen Satz elektronischer Komponenten (102) umfasst, die in einem Gehäuse (101) angeordnet sind, und die mindestens eine Leistungsleitung (103, 104) ein Verbindungselement bildet, das für sein Funktionieren von der Außenseite des Moduls zugänglich ist,
- **dass** die elektrischen Leistungsanschlüsse (2120, 2110, 217d) der Leistungsleitung (211, 212) sich zum äußeren Umfang des Stücks (21) erstrecken,
- und **dass** die Grundplatte (801) des Kühlkörpers (80) dazu konfiguriert ist, axial sandwichartig zwischen das Leistungsverbindungsstück (21) das sich zum Inneren der Maschine hin befindet, und das elektronische Modul (10), das sich zum Äußeren der Maschine hin befindet, montiert zu werden, weshalb das Leistungsverbindungsstück (21) dazu konfiguriert ist, auf der unteren Seite des Kühlkörpers platziert zu werden.

2. Rotierende elektrische Maschine nach dem vorhergehenden Anspruch, **dadurch gekennzeichnet, dass** die Leistungsanschlüsse umgebogene freie Enden umfassen.

3. Rotierende elektrische Maschine nach einem der vorhergehenden Ansprüche, **dadurch gekennzeichnet, dass** das Leistungsverbindungsstück (21) mindestens eine positive Leistungsverbindungsleitung (212, +BATT; 221d, B+) und mindestens eine negative Verbindungsleitung (211, -BATT; 222d, B-).

4. Rotierende elektrische Maschine nach einem der vorhergehenden Ansprüche, **dadurch gekennzeichnet, dass** die Grundplatte (213) mindestens eine Aussparung (214a, 214b) für eine elektrische Verbindung einer Leistungsverbindungsleitung (211, 212) mit einer Abdeckung umfasst.

5. Rotierende elektrische Maschine nach einem der vorhergehenden Ansprüche, **dadurch gekennzeichnet, dass** das Leistungsverbindungsstück (21) außerdem Befestigungsvorrichtungen (215) zur Befestigung an einem elektronischen Modul (10) umfasst, wobei sich die Vorrichtungen radial am äußeren Umfang des Stücks (21) erstrecken.

6. Rotierende elektrische Maschine nach einem der vorhergehenden Ansprüche, **dadurch gekennzeichnet, dass** die Maschine ein Signalverbindungsstück (22) umfasst, das Leistungsverbindungsstück (21) außerdem Vorrichtungen zur Vormontage (218) an das Signalverbindungsstück (22) umfasst, wobei das Signalverbindungsstück es ermöglicht, Steuersignale zwischen den elektronischen Modulen zu vermitteln.

7. Rotierende elektrische Maschine nach einem der vorhergehenden Ansprüche, **dadurch gekennzeichnet, dass** das Leistungsverbindungsstück (21) außerdem Einsätze (219a, 219b) umfasst, um Befestigungsmittel (226g) zur Befestigung an der Maschine aufzunehmen.

8. Rotierende elektrische Maschine nach einem der vorhergehenden Ansprüche, **dadurch gekennzeichnet, dass** die Maschine einen Kühlkörper umfasst und dass das Leistungsverbindungsstück (21) außerdem Stützvorrichtungen (2113) umfasst, um das Stück (21) bei einer Montage an einem Kühlkörper abzustützen.

9. Rotierende elektrische Maschine nach einem der vorhergehenden Ansprüche, **dadurch gekennzeichnet, dass** die Maschine einen Stator umfasst, der Phasen umfasst, und dass das Leistungsverbindungsstück (21) außerdem Mittel zum Schutz (211d) der Statorphasen umfasst.

10. Rotierende elektrische Maschine nach einem der vorhergehenden Ansprüche, **dadurch gekennzeichnet, dass** die rotierende elektrische Maschine ein Lager umfasst und dass das Leistungsverbindungsstück (21) außerdem Mittel zum Positionieren (212d) auf dem Lager, wobei die Mittel sich auf einer unteren Seite des Stücks (21) erstrecken, und vorzugsweise andere Vorrichtungen zum Positionieren (214d) des Stücks (21) an einem Kühlkörper der rotierenden elektrischen Maschine umfasst.

11. Rotierende elektrische Maschine nach einem der vorhergehenden Ansprüche, **dadurch gekennzeichnet, dass** das Leistungsverbindungsstück (21) außerdem mindestens eine Raststütze (213d) für eine axiale Verformung des Stücks (21) umfasst, wobei die Raststütze (213d) vorzugsweise eine größere Höhe aufweist als der Einsatz (210d).

12. Rotierende elektrische Maschine nach einem der vorhergehenden Ansprüche, **dadurch gekennzeichnet, dass** das Leistungsverbindungsstück (21) außerdem einen Leistungsverbinder (219d) umfasst, in den die positive und negative Leistungsleitung (222d, 221d) in ersichtlicher Weise eingesteckt werden.

13. Rotierende elektrische Maschine nach einem der vorhergehenden Ansprüche, **dadurch gekennzeichnet, dass** die Maschine ein Lager umfasst und dass das Leistungsverbindungsstück (21) außerdem einen Flansch (213z) umfasst, der dazu bestimmt ist, die Luftaustrittsöffnungen des Lagers so zu bedecken, dass die Luft beim Austritt geführt wird und ein Rückströmen der Luft abgeschwächt wird.

## Claims

1. Rotary electric machine comprising at least one electronic module (10) such as a power module (20) or a control module (30) or an excitation module (40), a heatsink (80) comprising a base plate (801) and a power interconnection part (21), said part (21) comprising at least one power track (211, 212) provided with electrical power terminals (2120, 2110, 217d) that are each intended to cooperate with a power track (103, 104) of said at least one electronic module (10) so as to distribute electrical power to said electronic module (10), the power interconnection part (21) comprises a base plate (213) made of electrically insulating material that at least partially overmoulds said power track (211, 212), said electronic module (10) is integrated on said machine independently of said power interconnection part (21), said power interconnection part (21) being stacked in a plane different to that used by the electronic module (10), said planes being perpendicular to the axis of rotation (AX) of the machine,
**characterized in that**:
- said electronic module (10) has a set of electronic components (102) that are disposed in a housing (101) and said at least one power track (103, 104) forms a connection element accessible from outside said module for the operation thereof
- **in that** the electrical power terminals (2120, 2110, 217d) of the power track (211, 212) extend towards the outer periphery of said part (21),
- and **in that** the base plate (801) of the heatsink (80) is configured to be able to be sandwiched axially between the power interconnection part (21), which is situated towards the inside of the machine, and the electronic module (10), which is situated towards the outside of the machine, such that the power interconnection part (21) is configured to be placed on the lower face of the heatsink.

2. Rotary electric machine according to the preceding claim, **characterized in that** said power terminals have curved-over free ends.

3. Rotary electric machine according to either of the preceding claims, **characterized in that** the power interconnection part (21) comprises at least one positive power interconnection track (212, +BATT; 221d, B+) and at least one negative interconnection track (211, -BATT; 222d, B-).

4. Rotary electric machine according to one of the preceding claims, **characterized in that** the base plate (213) comprises at least one hollowness (214a, 214b) for electrical connection of a power interconnection track (211, 212) with a cover.

5. Rotary electric machine according to one of the preceding claims, **characterized in that** the power interconnection part (21) also comprises fastening devices (215) for fastening to an electronic module (10), said devices extending radially over the outer periphery of said part (21).

6. Rotary electric machine according to any one of the preceding claims, **characterized in that** the machine has a signal interconnection part (22), the power interconnection part (21) also comprises devices (218) for pre-assembly on the signal interconnection part (22), said signal interconnection part making it possible to convey control signals between electronic modules.

7. Rotary electric machine according to any one of the preceding claims, **characterized in that** the power interconnection part (21) also comprises inserts (219a, 219b) for receiving fastening means (226g) for fastening to the machine.

8. Rotary electric machine according to any one of the preceding claims, **characterized in that** the machine comprises a heatsink and **in that** the power interconnection part (21) also comprises support devices (2113) for supporting said part (21) on a heatsink during assembly.

9. Rotary electric machine according to one of the preceding claims, **characterized in that** the machine comprises a stator comprising phases and **in that** the power interconnection part (21) also comprises means (211d) for protecting stator phases.

10. Rotary electric machine according to one of the preceding claims, **characterized in that** the rotary electric machine has a bracket and **in that** the power interconnection part (21) also comprises means (212d) for positioning on the bracket, said means extending over a lower face of said part (21), and preferably other devices (214d) for positioning said part (21) on a heatsink of the rotary electric machine.

11. Rotary electric machine according to one of the preceding claims, **characterized in that** the power interconnection part (21) also comprises at least one straining stand (213d) for axial deformation of said part (21), said straining stand (213d) preferably having a height greater than the insert (210d).

12. Rotary electric machine according to one of the preceding claims, **characterized in that** the power interconnection part (21) also comprises a power connector (219d) in which positive and negative power tracks (222d, 221d) are inserted in an apparent manner.

13. Rotary electric machine according to one of the preceding claims, **characterized in that** the machine comprises a bracket and **in that** the power interconnection part (21) also has a collar (213z) intended to cover air outlet openings of the bracket so as to guide the outlet air and attenuate air loopback.
